# EUROPEAN PATENT SPECIFICATION

(11) **EP 3 800 683 B1**
(45) Date of publication and mention of the grant of the patent: **18.12.2024**
(21) Application number: 20197892.1
(22) Date of filing: 23.09.2020
(51) Int. Cl.: H10K 50/12, H10K 85/60, H10K 101/00

(54) **ORGANIC ELECTROLUMINESCENCE DEVICE**
ORGANISCHE ELEKTROLUMINESZENZVORRICHTUNG
DISPOSITIF ÉLECTROLUMINESCENT ORGANIQUE

(30) Priority: 01.10.2019 KR 20190121391
(43) Date of publication of application: 07.04.2021
(73) Proprietor: Samsung Display Co., Ltd., Gyeonggi-do (KR)
(72) Inventor: CHOI, Minsoo, Hwaseong-si Gyeonggi-do (KR); KIM, Minje, Suwon-si Gyeonggi-do (KR); KIM, Eung Do, Gwangjin-gu Seoul (KR); KIM, Hyunyoung, Yongin-si Gyeonggi-do (KR); KIM, Hyojeong, Hwaseong-si Gyeonggi-do (KR); SHIN, Hyosup, Hwaseong-si Gyeonggi-do (KR); YOON, Seokgyu, Hwaseong-si Gyeonggi-do (KR); LEE, Youngki, Asan-si Chungcheongnam-do (KR); LEE, Jungsub, Hwaseong-si Gyeonggi-do (KR); LEE, Jiyoung, Hwaseong-si Gyeonggi-do (KR); JUNG, Hyejin, Hwaseong-si Gyeonggi-do (KR); CHO, Kunwook, Songpa-gu Seoul (KR); CHO, Hyeon Gu, Yongin-si Gyeonggi-do (KR); CHOI, Youngeun, Jeonju-si Jeollabuk-do (KR); LYU, Jaejin, Yongin-si Gyeonggi-do (KR)
(74) Representative: Marks & Clerk LLP

(56) References cited:
- US-A1- 2017 346 029
- LI WAN ET AL: "Efficient solution-processed blue and white OLEDs based on a high-triplet bipolar host and a blue TADF emitter", ORGANIC ELECTRONICS, vol. 58, 1 July 2018 (2018-07-01), AMSTERDAM, NL, pages 276 - 282, XP093007280, ISSN: 1566-1199, DOI: 10.1016/j.orgel.2018.04.027
- PARK JINHO ET AL: "High Efficiency of over 25% and Long Device Lifetime of over 500 h at 1000 nit in Blue Fluorescent Organic Light-Emitting Diodes", ADVANCED MATERIALS, vol. 34, no. 21, 24 April 2022 (2022-04-24), DE, pages 2108581, XP093007299, ISSN: 0935-9648, Retrieved from the Internet <URL:https://onlinelibrary.wiley.com/doi/full-xml/10.1002/adma.202108581> DOI: 10.1002/adma.202108581
- W J FINKENZELLER ET AL: "Emission of Ir(ppy)3. Temperature dependence, decay dynamics, and magnetic field properties", CHEMICAL PHYSICS LETTERS, vol. 377, 25 July 2003 (2003-07-25), pages 299 - 305, XP055022501, DOI: 10.1016/S0009-2614(03)01142-4
- HUANG XIAOYU ET AL: "Investigation of Exciton Recombination Zone in Quantum Dot Light-Emitting Diodes Using a Fluorescent Probe", ACS APPLIED MATERIALS & INTERFACES, vol. 9, no. 33, 14 August 2017 (2017-08-14), US, pages 27809 - 27816, XP055772769, ISSN: 1944-8244, Retrieved from the Internet <URL:https://pubs.acs.org/doi/pdf/10.1021/acsami.7b08574> DOI: 10.1021/acsami.7b08574
- JOO CHUL WOONG ET AL: "Development of solution-processable blue/hybrid-white OLEDs based on thermally activated delayed fluorescence", JOURNAL OF INDUSTRIAL AND ENGINEERING CHEMISTRY, vol. 65, 31 March 2018 (2018-03-31), KOREA, pages 35 - 39, XP055772792, ISSN: 1226-086X, DOI: 10.1016/j.jiec.2018.03.030
- LEE KYUNG HYUNG ET AL: "Phosphor sensitized thermally activated delayed fluorescence organic light-emitting diodes with ideal deep blue device performances", JOURNAL OF MATERIALS CHEMISTRY C, vol. 7, no. 28, 2 July 2019 (2019-07-02), GB, pages 8562 - 8568, XP055772375, ISSN: 2050-7526, Retrieved from the Internet <URL:https://pubs.rsc.org/en/content/articlepdf/2019/tc/c9tc02746g> DOI: 10.1039/C9TC02746G

## Description

### BACKGROUND

### 1. Field

One or more aspects of embodiments of the present disclosure relate to an organic electroluminescence device, and more particularly, to an organic electroluminescence device including a plurality of light-emitting materials in an emission layer.

### 2. Description of the Related Art

Organic electroluminescence displays are being actively developed as image displays. An organic electroluminescence display differs from a liquid crystal display in that it is a so-called self-luminescent display, in which holes and electrons respectively injected from a first electrode and a second electrode recombine in an emission layer, and a light-emitting material including an organic compound in the emission layer emits light to attain display.

In the application of an organic electroluminescence device to a display, decreases in driving voltage, and increases in emission efficiency and/or lifespan of the organic electroluminescence device are desired, and development of materials for an organic electroluminescence device capable of stably attaining the above requirements is also desired.

Recently, in order to achieve an organic electroluminescence device with high efficiency, materials capable of phosphorescence emission (which uses energy in a triplet state) or delayed fluorescence emission (which uses the generating phenomenon of singlet excitons by the collision of triplet excitons (triplet-triplet annihilation, TTA)) are being developed, and materials capable of thermally activated delayed fluorescence (TADF) using delayed fluorescence are being developed.

US 2017/346029 A1 discloses an organic light-emitting device that includes: a first electrode; a second electrode facing the first electrode; and an emission layer disposed between the first electrode and the second electrode and including a host and a dopant, wherein the host is an exciplex host, which is a combination of a hole transporting host and an electron transporting host which form an exciplex, or a delayed fluorescent organic compound, and the dopant includes both a phosphorescent dopant and a fluorescent dopant.

Joo et al. in "Development of solution-processable blue/hybrid-white OLEDs based on thermally activated delayed fluorescence" (Journal of Industrial and Engineering Chemistry, 2018, vol. 65, pp. 35-39) disclose hybrid-WOLEDs that are fabricated by employing single emitting layers (S-EMLs), which consist of 5-(4-(4,6-diphenyl-1,3,5-triazin-2-yl)phenyl)-10,10-diphenyl-5,10-dihydrodibenzo[b,e][1,4]azasiline (DTPDDA) as a blue thermally activated delayed fluorescent (TADF) emitter and bis(2-methyldibenzo[f,h]quinoxaline) (acetylacetonate)iridium(III) (Ir(MDQ)₂acac) as a phosphorescent red emitter.

Lee et al. in "Phosphor sensitized thermally activated delayed fluorescence organic light-emitting diodes with ideal deep blue device performances" (Journal of Materials Chemistry C, 2019, vol. 7, no. 28, pp. 8562-8568) disclose phosphorescence sensitized thermally activated delayed fluorescent (PSTADF) organic light-emitting diodes (OLEDs).

### SUMMARY

One or more aspects of embodiments of the present disclosure are directed toward an organic electroluminescence device showing excellent lifespan (lifetime) characteristics and emission efficiency.

The present invention provides an organic electroluminescence device according to claim 1. Said organic electroluminescence device includes a first electrode, a second electrode opposite the first electrode, and an emission layer disposed between the first electrode and the second electrode. The emission layer includes a host having a first luminescent onset wavelength, a first dopant having a second luminescent onset wavelength, and a second dopant different from the first dopant and having a third luminescent onset wavelength. The third luminescent onset wavelength is greater than the first luminescent onset wavelength and the second luminescent onset wavelength.

A normalized light intensity at a cross point of a normalized light absorption spectrum and a normalized light emission spectrum of the second dopant may be about 0.5 or more.

A distance between a peak of the normalized light absorption spectrum and a peak of the normalized light emission spectrum of the second dopant may be about 50 nm or less.

In an embodiment the second dopant may have a smaller (e.g., may be smaller in) lowest triplet excitation energy level than each of the host and the first dopant.

The host includes a first host and a second host, the second host being different from the first host.

The first host is represented by Formula H-1:

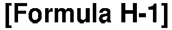

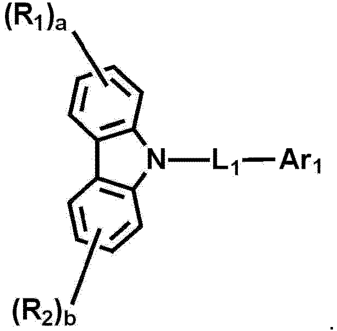

In Formula H-1, L₁ may is a direct linkage, a substituted or unsubstituted arylene group of 6 to 30 carbon atoms for forming a ring, or a substituted or unsubstituted heteroarylene group of 2 to 30 carbon atoms for forming a ring; Ari is a substituted or unsubstituted aryl group of 6 to 30 carbon atoms for forming a ring, or a substituted or unsubstituted heteroaryl group of 2 to 30 carbon atoms for forming a ring; "a" and "b" are each independently an integer of 0 to 4; and R₁ and R₂ are each independently a substituted or unsubstituted aryl group of 6 to 30 carbon atoms for forming a ring, or a substituted or unsubstituted heteroaryl group of 2 to 30 carbon atoms for forming a ring.

The second host is represented by Formula H-2:

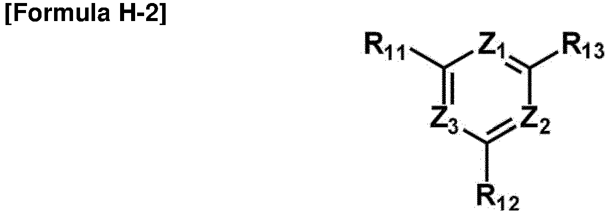

In Formula H-2, Z₁ to Z₃ are each independently CR_{y} or N; and R_{y} and R₁₁ to R₁₃ are each independently a hydrogen atom, a deuterium atom, a cyano group, a substituted or unsubstituted silyl group, a substituted or unsubstituted aryl group of 6 to 30 carbon atoms for forming a ring, or a substituted or unsubstituted heteroaryl group of 2 to 30 carbon atoms for forming a ring.

In an embodiment, the first dopant may include an organometallic complex including iridium (Ir), ruthenium (Ru), rhodium (Rh), platinum (Pt), palladium (Pd), copper (Cu), or osmium (Os) as a central metal element.

In an embodiment, the first dopant may be represented by Formula D-1:

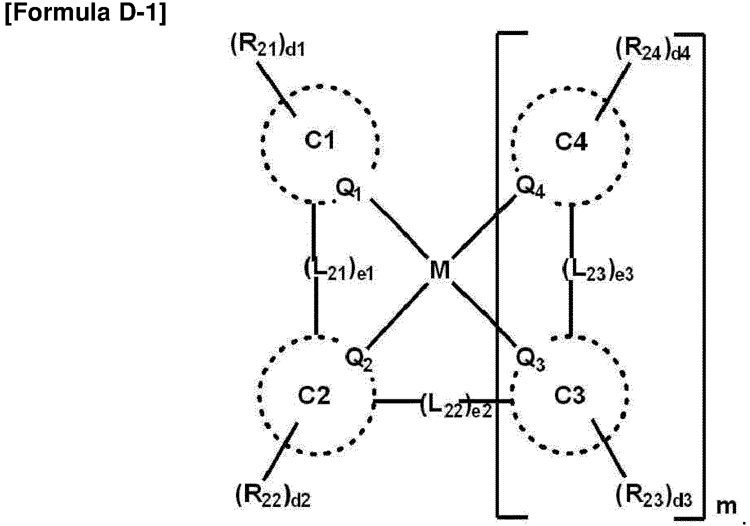

In Formula D-1, M is Pt, Pd, Cu, Os, Ir, Ru, or Rh; Q₁ to Q₄ are each independently C or N; C1 to C4 are each independently a substituted or unsubstituted hydrocarbon ring of 5 to 30 carbon atoms for forming a ring, or a substituted or unsubstituted heterocycle of 2 to 30 carbon atoms for forming a ring; L₂₁ to L₂₃ are each independently a direct linkage, *-o-*, *-s-*, 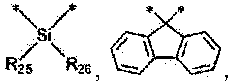 a substituted or unsubstituted divalent alkyl group of 1 to 20 carbon atoms, a substituted or unsubstituted arylene group of 6 to 30 carbon atoms for forming a ring, or a substituted or unsubstituted heteroarylene group of 2 to 30 carbon atoms for forming a ring; e1 to e3 are each independently 0 or 1; R₂₁ to R₂₆ are each independently a hydrogen atom, a deuterium atom, a halogen atom, a cyano group, a substituted or unsubstituted amine group, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring, or are combined with an adjacent group to form a ring; d1 to d4 are each independently an integer of 0 to 4; and when M is Pt, Pd, Cu, or Os, "m" is 1, and when M is Ir, Ru, or Rh, "m" is 2, and e2 is 0.

In an embodiment, the second dopant may be represented by Formula D-2a:

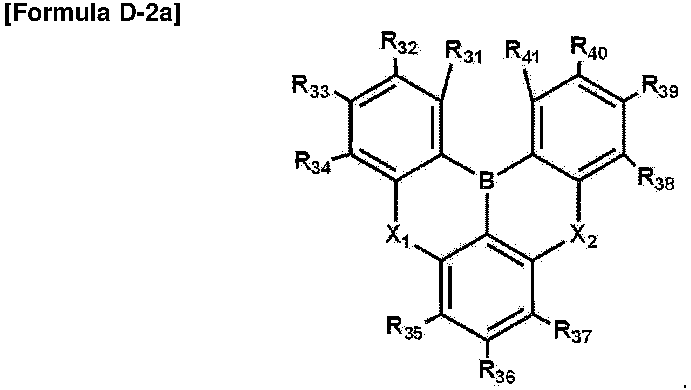

In Formulae D-2a, X₁ and X₂ are each independently NRₘ or O; Rₘ is a hydrogen atom, a deuterium atom, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring; and R₃₁ to R₄₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring, or are combined with an adjacent group to form a ring.

In an embodiment, the second dopant may be represented by Formula D-2b:

**[Formula D-2b]** **D₁-L₂-A₁.**

In Formula D-2b, L₂ is a direct linkage, a substituted or unsubstituted arylene group of 6 to 30 carbon atoms for forming a ring, or a substituted or unsubstituted heteroarylene group of 2 to 30 carbon atoms for forming a ring; and D₁ is represented by Formula D-2-1 or Formula D-2-2:

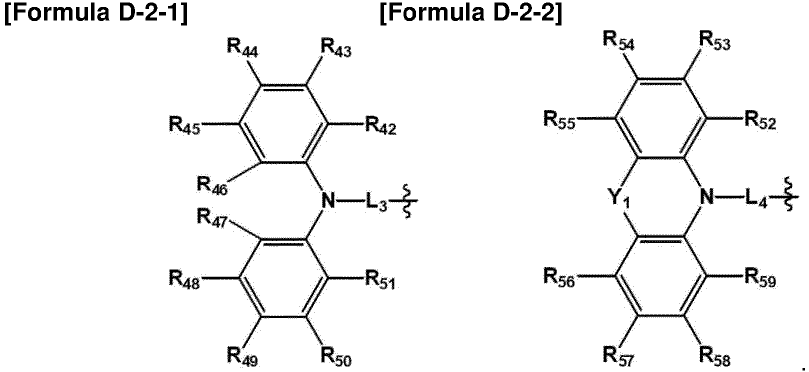

In Formulae D-2-1 and D-2-2, L₃ and L₄ are each independently a direct linkage, or a substituted or unsubstituted arylene group of 6 to 30 carbon atoms for forming a ring; R₄₂ to R₅₉ are each independently a hydrogen atom, a deuterium atom, a halogen atom, a substituted or unsubstituted amine group, a substituted or unsubstituted silyl group, a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring, or are each combined with an adjacent group to form a ring; Y₁ is a direct linkage, CRₐR_{b}, SiR_{c}R_{d}, GeRₑR_{f}, NR_{g}, O or S; Rₐ to R_{g} are each independently a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring; Rₐ and R_{b}, R_{c} and R_{d}, and/or Rₑ and R_{f} are optionally combined with each other to form a ring; and A₁ is represented by one of Formulae D-2-3 to D-2-10:

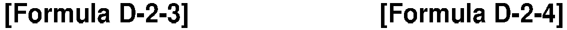

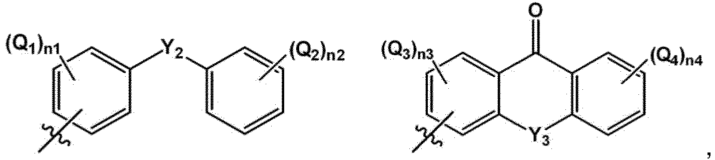

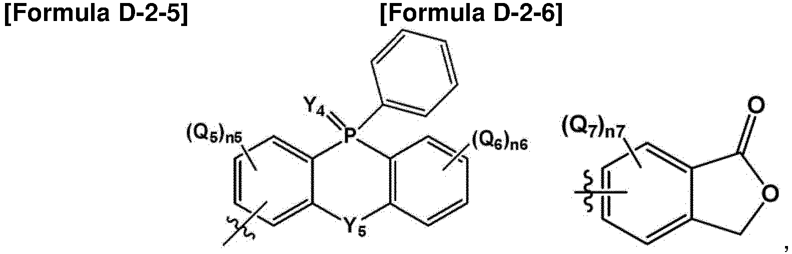

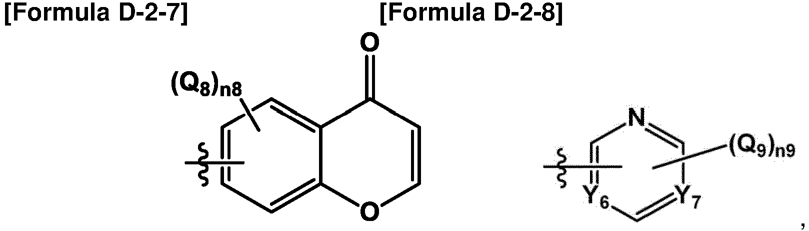

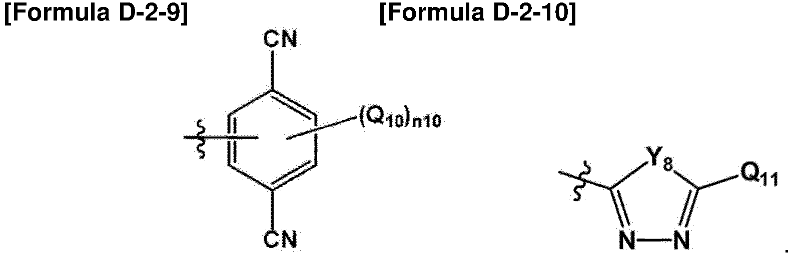

Y₂ is C=O or S(=O)₂; Y₃ is C=O, or O; Y₄ and Y₅ are each independently O or S; Y₆ and Y₇ are each independently N or CQ₁₂, Y₈ is O or NQ₁₃; Q₁ to Q₁₃ are each independently a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring; n1, n4, and n6 are each independently 0 to 4; n3, n5, n7, n8, and n10 are each independently an integer of 0 to 3; n2 is an integer of 0 to 5; and n9 is an integer of 0 to 2.

In an embodiment, the first host and the second host may be in a weight ratio of about 7:3 to about 3:7.

In an embodiment, an amount of the first dopant may be about 10 wt% to about 15 wt%, and an amount of the second dopant may be about 1 wt% to about 5 wt% based on a total weight of the first host, the second host, the first dopant, and the second dopant.

At least some of the above and other features of the invention are set out in the claims.

### BRIEF DESCRIPTION OF THE DRAWINGS

The accompanying drawings are included to provide a further understanding of the present disclosure and are incorporated in and constitute a part of this specification. The drawings illustrate example embodiments of the present disclosure and, together with the description, serve to explain principles of the present disclosure. In the drawings:
FIG. 1 is a cross-sectional view schematically illustrating an organic electroluminescence device according to an embodiment of the present disclosure;
FIG. 2 is a cross-sectional view schematically illustrating an organic electroluminescence device according to an embodiment of the present disclosure;
FIG. 3 is a cross-sectional view schematically illustrating an organic electroluminescence device according to an embodiment of the present disclosure;
FIG. 4 is a cross-sectional view schematically illustrating an organic electroluminescence device according to an embodiment of the present disclosure;
FIG. 5 is a cross-sectional view schematically illustrating an organic electroluminescence device according to an embodiment of the present disclosure;
FIG. 6A to FIG. 6F are plots of the normalized emission spectra (intensity vs. wavelength) of a host, a first dopant and a second dopant according to example embodiments of the present disclosure; and
FIG. 7A and FIG. 7B are plots of the light emission spectrum and light absorption spectrum (intensity vs. wavelength) of the second dopant according to an embodiment of the present disclosure.

### DETAILED DESCRIPTION

The present disclosure may have various modifications and may be embodied in different forms, and example embodiments will be explained in more detail with reference to the accompany drawings. The present disclosure may, however, be embodied in different forms and should not be construed as limited to the embodiments set forth herein.

It will be understood that when an element (or region, layer, part, etc.) is referred to as being "on", "connected to" or "coupled to" another element, it can be directly on, connected or coupled to the other element, or a third intervening element may be present.

Like reference numerals refer to like elements throughout, and duplicative descriptions thereof may not be provided. In addition, in the drawings, the thickness, the ratio, and the dimensions of constituent elements may be exaggerated for effective explanation of technical contents.

The term "and/or" includes one or more combinations which may be defined by relevant elements. As used herein, the terms "substantially", "about", and similar terms are used as terms of approximation and not as terms of degree, and are intended to account for the inherent deviations in measured or calculated values that would be recognized by those of ordinary skill in the art.

It will be understood that, although the terms first, second, etc. may be used herein to describe various elements, these elements should not be limited by these terms. These terms are only used to distinguish one element from another element. Thus, a first element could be termed a second element without departing from the teachings of the present disclosure. Similarly, a second element could be termed a first element. As used herein, the singular forms are intended to include the plural forms as well, unless the context clearly indicates otherwise.

In addition, the terms "below", "beneath", "on" and "above" are used for explaining the relation of elements shown in the drawings. The terms are a relative concept and are explained based on the direction shown in the drawing.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "includes," "including," "comprises," and/or "comprising," when used in this specification, specify the presence of stated features, numerals, steps, operations, elements, parts, or the combination thereof, but do not preclude the presence or addition of one or more other features, numerals, steps, operations, elements, parts, or the combination thereof.

Hereinafter, the organic electroluminescence device according to an embodiment of the present disclosure will be explained with reference to the attached drawings.

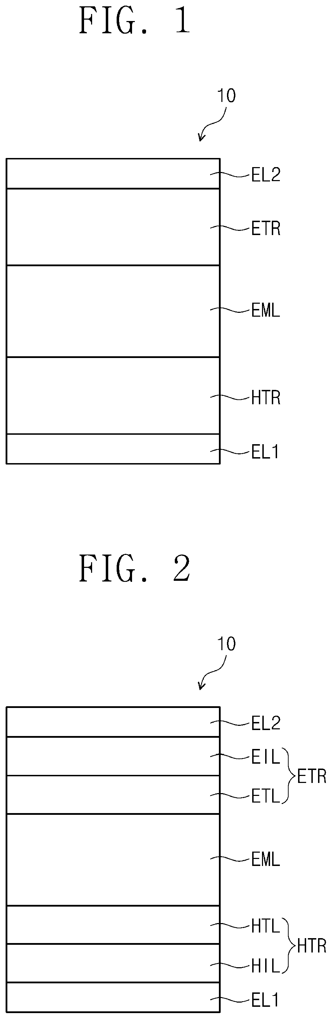

FIG. 1 to FIG. 5 are schematic cross-sectional views of organic electroluminescence devices according to example embodiments of the present disclosure. Referring to FIG. 1 to FIG. 5, in an organic electroluminescence device 10 of an embodiment, a first electrode EL1 and a second electrode EL2 are oppositely disposed, and an emission layer EML is disposed between the first electrode EL1 and the second electrode EL2.

In addition, the organic electroluminescence device 10 of an embodiment may further include a plurality of functional layers between the first electrode EL1 and the second electrode EL2, in addition to the emission layer EML. The plurality of the functional layers may include a hole transport region HTR and an electron transport region ETR. For example, the organic electroluminescence device 10 according to an embodiment may include a first electrode EL1, a hole transport region HTR, an emission layer EML, an electron transport region ETR, and a second electrode EL2, stacked in this stated order. In some embodiments, the organic electroluminescence device 10 of an embodiment may include a capping layer CPL disposed on the second electrode EL2.

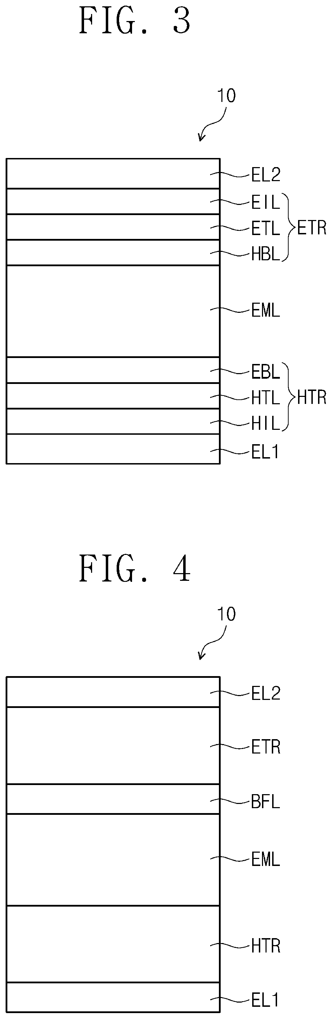

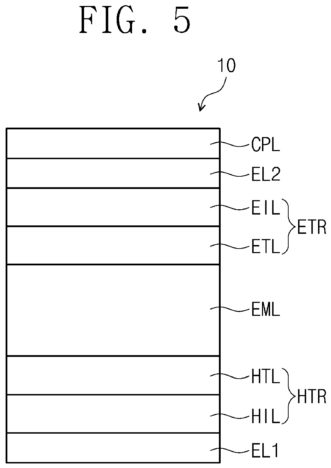

FIG. 2 shows a cross-sectional view of an organic electroluminescence device 10 of an embodiment in which the hole transport region HTR includes a hole injection layer HIL and a hole transport layer HTL, and the electron transport region ETR includes an electron injection layer EIL and an electron transport layer ETL. FIG. 3 shows a cross-sectional view of an organic electroluminescence device 10 of an embodiment in which the hole transport region HTR includes the hole injection layer HIL, the hole transport layer HTL, and an electron blocking layer EBL, and the electron transport region ETR includes the electron injection layer EIL, the electron transport layer ETL, and a hole blocking layer HBL. FIG. 4 shows a cross-sectional view of an organic electroluminescence device 10 of an embodiment including a buffer layer BFL between the emission layer EML and the electron transport region ETR. FIG. 5 shows a cross-sectional view of an organic electroluminescence device 10 of an embodiment including a capping layer CPL disposed on a second electrode EL2.

The first electrode EL1 has conductivity (e.g., is conductive). The first electrode EL1 may be formed using a metal alloy or a conductive compound. The first electrode EL1 may be an anode. In some embodiments, the first electrode EL1 may be a pixel electrode. The first electrode EL1 may be a transmissive electrode, a transflective electrode, or a reflective electrode. If the first electrode EL1 is a transmissive electrode, the first electrode EL1 may include a transparent metal oxide (such as indium tin oxide (ITO), indium zinc oxide (IZO), zinc oxide (ZnO), and/or indium tin zinc oxide (ITZO)). If the first electrode EL1 is the transflective electrode or the reflective electrode, the first electrode EL1 may include silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), LiF/Ca, LiF/AI, molybdenum (Mo), titanium (Ti), a compound thereof, or a mixture thereof (for example, a mixture of Ag and Mg). In some embodiments, the first electrode EL1 may have a structure including a plurality of layers including a reflective layer or a transflective layer formed using the above materials, and a transmissive conductive layer formed using ITO, IZO, ZnO, or ITZO. For example, the first electrode EL1 may include a three-layer structure of ITO/Ag/ITO. However, an embodiment of the present disclosure is not limited thereto. The thickness of the first electrode EL1 may be about 1,000 Å to about 10,000 Å, for example, about 1,000 Å to about 3,000 Å.

The hole transport region HTR is provided on the first electrode EL1. The hole transport region HTR may include at least one of a hole injection layer HIL, a hole transport layer HTL, a hole buffer layer, or an electron blocking layer EBL. The thickness of the hole transport region HTR may be about 50 Å to about 1,500 Å.

The hole transport region HTR may have a single layer formed using a single material, a single layer formed using a plurality of different materials, or a multilayer structure including a plurality of layers formed using a plurality of different materials.

For example, the hole transport region HTR may have a single layer structure including a hole injection layer HIL or a hole transport layer HTL, or may have a single layer structure including a hole injection material and a hole transport material (e.g., simultaneously or as a mixture). In some embodiments, the hole transport region HTR may have a structure of a plurality of layers formed using a plurality of different materials, such as a structure including a hole injection layer HIL/hole transport layer HTL, a hole injection layer HIL/hole transport layer HTL/hole buffer layer, a hole injection layer HIL/hole buffer layer, a hole transport layer HTL/hole buffer layer, or a hole injection layer HIL/hole transport layer HTL/electron blocking layer EBL, without limitation, each being stacked on the first electrode EL1.

The hole transport region HTR may be formed using various suitable methods (such as a vacuum deposition method, a spin coating method, a cast method, a Langmuir-Blodgett (LB) method, an inkjet printing method, a laser printing method, and/or a laser induced thermal imaging (LITI) method).

The hole injection layer HIL may include, for example, a phthalocyanine compound such as copper phthalocyanine, N,N'-diphenyl-N,N'-bis-[4-(phenyl-m-tolyl-amino)-phenyl]-phenyl-4,4'-diamine (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris{N,-2-naphthyl)-N- phenylamino}-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(1-naphthalene-1-yl)-N,N'-diphenyl-benzidine (NPB), triphenylamine-containing polyether ketone (TPAPEK), 4-isopropyl-4'-methyldiphenyliodonium [tetrakis(pentafluorophenyl)borate], and/or dipyrazino[2,3-f:2',3'-h]quinoxaline-2,3,6,7,10,11-hexacarbonitrile (HAT-CN).

The hole transport layer HTL may include, for example, carbazole derivatives such as N-phenyl carbazole and polyvinyl carbazole, fluorene-based derivatives, N,N'-bis(3-methylphenyl)-N,N'-diphenyl-[1,1-biphenyl]-4,4'-diamine (TPD), triphenylamine-based derivatives such as 4,4',4"-tris(N-carbazolyl)triphenylamine (TCTA), N,N'-di(1-naphthalene-1-yl)-N,N'-diphenyl-benzidine (NPB), 4,4'-cyclohexylidene bis[N,N-bis(4-methylphenyl)benzeneamine (TAPC), 4,4'-bis[N,N'-(3-tolyl)amino]-3,3'-dimethylbiphenyl (HMTPD), 1,3-bis(N-carbazolyl)benzene (mCP), etc.

The thickness of the hole transport region HTR may be about 50 Å to about 10,000 Å, for example, about 100 Å to about 5,000 Å. The thickness of the hole injection region HIL may be, for example, about 30 Å to about 1,000 Å, and the thickness of the hole transport layer HTL may be about 30 Å to about 1,000 Å. For example, the thickness of the electron blocking layer EBL may be about 10 Å to about 1,000 Å. If the thicknesses of the hole transport region HTR, the hole injection layer HIL, the hole transport layer HTL and the electron blocking layer EBL satisfy the above-described ranges, satisfactory hole transport properties may be achieved without a substantial increase in driving voltage.

The hole transport region HTR may further include a charge generating material in addition to the above-described materials to increase conductivity. The charge generating material may be dispersed substantially uniformly or non-uniformly in the hole transport region HTR. The charge generating material may be, for example, a p-dopant. The p-dopant may be a quinone derivative, a metal oxide, or a cyano group-containing compound, without limitation. For example, non-limiting examples of the p-dopant include quinone derivatives (such as tetracyanoquinodimethane (TCNO) and/or 2,3,5,6-tetrafluoro-7,7',8,8'-tetracyanoquinodimethane (F4-TCNQ)), metal oxides (such as tungsten oxide and/or molybdenum oxide), and inorganic metal compounds (such as Cul and/or Rbl), without limitation.

As described above, the hole transport region HTR may further include at least one of a hole buffer layer or an electron blocking layer EBL in addition to the hole injection layer HIL and the hole transport layer HTL. The hole buffer layer may compensate for an optical resonance distance according to the wavelength of light emitted from the emission layer EML, and may thereby increase light emission efficiency. The hole transport region HTR and the hole buffer layer may include the same materials. The electron blocking layer EBL may prevent or reduce electron injection from the electron transport region ETR to the hole transport region HTR.

The emission layer EML is provided on the hole transport region HTR. The emission layer EML may have a thickness of, for example, about 100 Å to about 1,000 Å or about 100 Å to about 300 Å. The emission layer EML may have a single layer formed using a single material, a single layer formed using a plurality of different materials, or a multilayer structure having a plurality of layers formed using a plurality of different materials.

In the organic electroluminescence device 10 of an embodiment, the emission layer EML may include a plurality of different kinds (e.g., classes) of light-emitting materials. The organic electroluminescence device 10 of an embodiment may include a first host and a second host, which are different from each other, and a first dopant and a second dopant, which are different from each other.

In the description, the term "substituted or unsubstituted" refers to a state of being unsubstituted, or substituted with at least one substituent selected from the group consisting of a deuterium atom, a halogen atom, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, an alkoxy group, a hydrocarbon ring group, an aryl group, and a heterocyclic group. Each of the exemplified substituents may be further substituted or unsubstituted. For example, in some embodiments a biphenyl group may be interpreted as a named aryl group, or in some embodiments may be interpreted as a phenyl group substituted with a phenyl group.

In the description, the term "combined with an adjacent group to form a ring" may refer to forming a substituted or unsubstituted hydrocarbon ring or heterocycle by combining with an adjacent group. The term "hydrocarbon ring" includes an aliphatic hydrocarbon ring and an aromatic hydrocarbon ring. The term "heterocycle" includes an aliphatic heterocycle and an aromatic heterocycle. The ring formed by combining with an adjacent group may be a monocyclic ring or a polycyclic ring. In addition, the ring formed via combining with an adjacent group may be further combined with another ring to form a spiro structure.

In the description, the term "adjacent group" may refer to a substituent on an adjacently bonded atom, a substituent on the same atom, or a substituent sterically positioned at the nearest position to (e.g., within bonding distance of) a corresponding substituent. For example, in 1,2-dimethylbenzene, the two methyl groups may be interpreted as "adjacent groups" to each other, and in 1,1-diethylcyclopentene, the two ethyl groups may be interpreted as "adjacent groups" to each other.

In the description, non-limiting examples of the halogen atom include a fluorine atom, a chlorine atom, a bromine atom or an iodine atom.

In the description, the term "alkyl group" may refer to a linear, branched or cyclic alkyl. The number of carbons in the alkyl group may be 1 to 50, 1 to 30, 1 to 20, 1 to 10, or 1 to 6. Non-limiting examples of the alkyl group may include methyl, ethyl, n-propyl, isopropyl, n-butyl, s-butyl, t-butyl, i-butyl, 2-ethylbutyl, 3,3-dimethylbutyl, n-pentyl, i-pentyl, neopentyl, t-pentyl, cyclopentyl, 1-methylpentyl, 3-methylpentyl, 2-ethylpentyl, 4-methyl-2-pentyl, n-hexyl, 1-methylhexyl, 2-ethylhexyl, 2-butylhexyl, cyclohexyl, 4-methylcyclohexyl, 4-t-butylcyclohexyl, n-heptyl, 1-methylheptyl, 2,2-dimethylheptyl, 2-ethylheptyl, 2-butylheptyl, n-octyl, t-octyl, 2-ethyloctyl, 2-butyloctyl, 2-hexyloctyl, 3,7-dimethyloctyl, cyclooctyl, n-nonyl, n-decyl, adamantyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldocecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-heneicosyl, n-docosyl, n-tricosyl, n-tetracosyl, n-pentacosyl, n-hexacosyl, n-heptacosyl, n-octacosyl, n-nonacosyl, n-triacontyl, etc.

In the description, the term "alkenyl group" refers to a hydrocarbon group including one or more carbon-carbon double bonds in the middle and/or at the terminus of an alkyl group including 2 or more carbon atoms. The alkenyl group may be a linear chain or a branched chain. The number of carbons in the alkenyl group is not specifically limited, but may be 2 to 30, 2 to 20, or 2 to 10. Non-limiting examples of the alkenyl group include a vinyl group, a 1-butenyl group, a 1-pentenyl group, a 1,3-butadienyl aryl group, a styrenyl group, a styryl vinyl group, etc.

In the description, the term "alkynyl group" refers to a hydrocarbon group including one or more carbon-carbon triple bonds in the middle or at the terminus of an alkyl group including 2 or more carbon atoms. The alkynyl group may be a linear chain or a branched chain. The number of carbons in the alkynyl group is not specifically limited, but may be 2 to 30, 2 to 20, or 2 to 10. Non-limiting examples of the alkynyl group include an ethynyl group, a propynyl group, etc.

In the description, the term "hydrocarbon ring group" may refer to an optional functional group or substituent derived from an aliphatic hydrocarbon ring, or an optional functional group or substituent derived from an aromatic hydrocarbon ring. The number of carbons in the hydrocarbon ring may be 5 to 60, 5 to 30, or 5 to 20.

In the description, the term "aryl group" refers to an optional functional group or substituent derived from an aromatic hydrocarbon ring. The aryl group may be a monocyclic aryl group or a polycyclic aryl group. The number of carbons in the ring of the aryl group may be 6 to 36, 6 to 30, 6 to 20, or 6 to 15. Non-limiting examples of the aryl group may include phenyl, naphthyl, fluorenyl, anthracenyl, phenanthryl, biphenyl, terphenyl, quaterphenyl, quinquephenyl, sexiphenyl, triphenylenyl, pyrenyl, benzofluoranthenyl, chrysenyl, etc.

In the description, the term "heterocyclic group" refers to an optional functional group or substituent derived from a ring including one or more heteroatoms selected from boron (B), oxygen (O), nitrogen (N), phosphorus (P), silicon (Si) and sulfur (S). The heterocyclic group may be an aliphatic heterocyclic group or an aromatic heterocyclic group. The aromatic heterocyclic group may be a heteroaryl group. The aliphatic heterocycle and the aromatic heterocycle may each be a monocycle or polycycle.

In the description, the heterocyclic group may include one or more selected from B, O, N, P, Si and S as heteroatoms. If the heterocyclic group includes two or more heteroatoms, the two or more heteroatoms may be the same or different. The heterocyclic group may be a monocyclic heterocyclic group or a polycyclic heterocyclic group, and in some embodiments may include a heteroaryl group. The number of carbons in the ring of the heterocyclic group may be 2 to 30, 2 to 20, or 2 to 10.

In the description, the aliphatic heterocyclic group may include one or more selected from B, O, N, P, Si and S as heteroatoms. The number of carbons in the ring of the aliphatic heterocyclic group may be 2 to 30, 2 to 20, or 2 to 10. Non-limiting examples of the aliphatic heterocyclic group include an oxirane group, a thiirane group, a pyrrolidine group, a piperidine group, a tetrahydrofuran group, a tetrahydrothiophene group, a thiane group, a tetrahydropyrane group, a 1 ,4-dioxane group, etc.

In the description, the heteroaryl group may include one or more selected from B, O, N, P, Si and S as heteroatoms. If the heteroaryl group includes two or more heteroatoms, the two or more heteroatoms may be the same or different. The heteroaryl group may be a monocyclic heterocyclic group or a polycyclic heterocyclic group. The number of carbons in the ring of the heteroaryl group may be 2 to 30, 2 to 20, or 2 to 10. Non-limiting examples of the heteroaryl group include thiophene, furan, pyrrole, imidazole, triazole, pyridine, bipyridine, pyrimidine, triazine, triazole, acridyl, pyridazine, pyrazinyl, quinoline, quinazoline, quinoxaline, phenoxazine, phthalazine, pyrido pyrimidine, pyrido pyrazine, pyrazino pyrazine, isoquinoline, indole, carbazole, N-arylcarbazole, N-heteroarylcarbazole, N-alkylcarbazole, benzoxazole, benzimidazole, benzothiazole, benzocarbazole, benzothiophene, dibenzothiophene, thienothiophene, benzofuran, phenanthroline, thiazole, isooxazole, oxazole, oxadiazole, thiadiazole, phenothiazine, dibenzosilole, dibenzofuran, etc.

In the description, the arylene group may be similar to the aryl group except that the arylene group is a divalent group. The heteroarylene group may be similar to the heteroaryl group except that the heteroarylene group is a divalent group.

In the description, the term "silyl group" refers to an alkyl silyl group or an aryl silyl group. Non-limiting examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc.

In the description, the term "boryl group" or "boron group" refers to an alkyl boryl group or an aryl boryl group. Non-limiting examples of the boryl group include a trimethylboryl group, a triethylboryl group, a t-butyldimethylboryl group, a triphenylboryl group, a diphenylboryl group, a phenylboryl group, etc.

In the description, the carbon number of the amine group (or amino group) is not specifically limited, but may be 1 to 30. The amine group may refer to an alkyl amine group, an aryl amine group, or a heteroaryl amine group. Non-limiting examples of the amine group include a methylamine group, a dimethylamine group, a phenylamine group, a diphenylamine group, a naphthylamine group, a 9-methyl-anthracenylamine group, a triphenylamine group, etc.

In the description, the term "oxy group" may refer to an alkoxy group or an aryl oxy group. The alkoxy group may include a linear, branched or cyclic alkyl chain. The number of carbons in the alkoxy group is not specifically limited, but may be, for example, 1 to 20 or 1 to 10. Non-limiting examples of the oxy group include methoxy, ethoxy, n-propoxy, isopropoxy, butoxy, pentyloxy, hexyloxy, octyloxy, nonyloxy, decyloxy, benzyloxy, etc.

In the description, the alkyl group in the alkyl thio group, the alkyl sulfoxy group, the alkyl aryl group, the alkyl amino group, the alkyl boryl group and the alkyl silyl group is the same as described above, including the examples.

In the description, the aryl group in the aryl oxy group, aryl thio group, aryl sulfoxy group, aryl amino group, aryl boron group, aryl silyl group, aryl selenium group, and aryl alkyl group is the same as described above, including the examples.

In the present description, the phosphine oxide group may be substituted with, for example, at least one of alkyl or aryl.

In the present description, the phosphine sulfide group may be substituted with, for example, at least one of alkyl or aryl.

In the description, the term "direct linkage" may refer to a single bond.

In the description, " 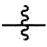 " or "-*" refer to a connected position (e.g., to another formula).

The emission layer EML of the organic electroluminescence device 10 of an embodiment includes a host having a first luminescent onset wavelength, a first dopant having a second luminescent onset wavelength, and a second dopant having a third luminescent onset wavelength. The host includes a first host and a second host that is different from the first host. The host may include a first host having a hole transport moiety and a second host having an electron transport moiety. For example, in the emission layer EML of the organic electroluminescence device 10 of an embodiment, the host may be an exciplex formed by the first host and the second host.

The emission layer EML includes the first host, which is represented by Formula H-1:

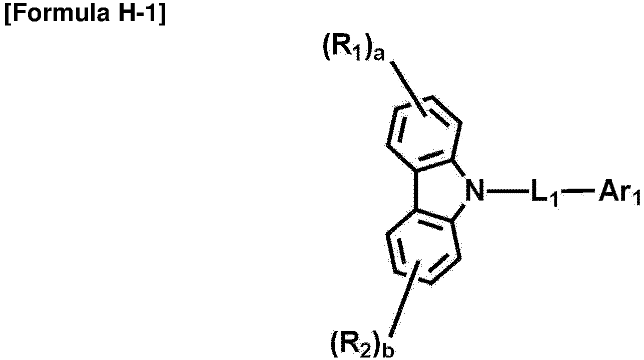

In Formula H-1, L₁ is a direct linkage, a substituted or unsubstituted arylene group of 6 to 30 carbon atoms for forming a ring, or a substituted or unsubstituted heteroarylene group of 2 to 30 carbon atoms for forming a ring. For example, L₁ may be a direct linkage, a substituted or unsubstituted arylene group of 6 to 15 carbon atoms for forming a ring, or a substituted or unsubstituted heteroarylene group of 2 to 12 carbon atoms for forming a ring. Ari is a substituted or unsubstituted aryl group of 6 to 30 carbon atoms for forming a ring, or a substituted or unsubstituted heteroaryl group of 2 to 30 carbon atoms for forming a ring. For example, Ari may be a substituted or unsubstituted aryl group of 6 to 15 carbon atoms for forming a ring, or a substituted or unsubstituted heteroaryl group of 2 to 12 carbon atoms for forming a ring.

In Formula H-1, "a" and "b" are each independently an integer of 0 to 4, and R₁ and R₂ are each independently a substituted or unsubstituted aryl group of 6 to 30 carbon atoms for forming a ring, or a substituted or unsubstituted heteroaryl group of 2 to 30 carbon atoms for forming a ring. For example, R₁ and R₂ may each independently be a substituted or unsubstituted aryl group of 6 to 15 carbon atoms for forming a ring, or a substituted or unsubstituted heteroaryl group of 2 to 12 carbon atoms for forming a ring. When "a" and "b" are each independently an integer of 2 or more, a plurality of R₁ groups and a plurality of R₂ groups may be the same or at least one thereof may be different. In some embodiments, in Formula H-1, "a" and "b" may be 0. In this case, the carbazole group is unsubstituted.

In Formula H-1, L₁ may be a direct linkage, a phenylene group, a divalent biphenyl group, a divalent carbazole group, etc., but an embodiment of the present disclosure is not limited thereto. An may be a substituted or unsubstituted carbazole group, a substituted or unsubstituted dibenzofuran group, a substituted or unsubstituted dibenzothiophene group, a substituted or unsubstituted biphenyl group, etc., but an embodiment of the present disclosure is not limited thereto.

The emission layer includes a compound represented by Formula H-2 as the second host:

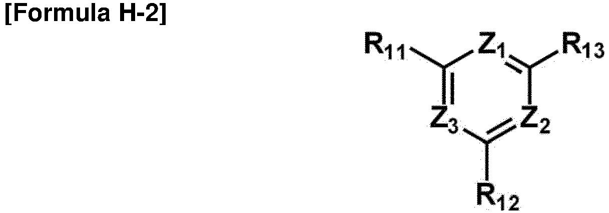

In Formula H-2, Z₁ to Z₃ are each independently CR_{y} or N, and R_{y} and R₁₁ to R₁₃ are each independently a hydrogen atom, a deuterium atom, a cyano group, a substituted or unsubstituted silyl group, a substituted or unsubstituted aryl group of 6 to 30 carbon atoms for forming a ring, or a substituted or unsubstituted heteroaryl group of 2 to 30 carbon atoms for forming a ring. For example, R_{y} and R₁₁ to R₁₃ may each independently be a hydrogen atom, a deuterium atom, a cyano group, a substituted or unsubstituted silyl group, a substituted or unsubstituted aryl group of 6 to 15 carbon atoms for forming a ring, or a substituted or unsubstituted heteroaryl group of 2 to 12 carbon atoms for forming a ring.

For example, Formula H-2 may be represented by one of Formula H-2a or Formula H-2b:

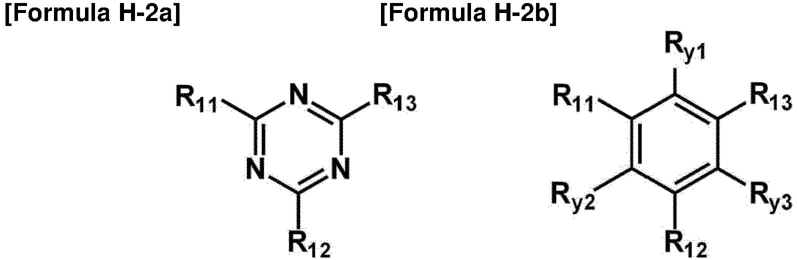

In Formula H-2a and Formula H-2b, R₁₁ to R₁₃ are each independently a hydrogen atom, a deuterium atom, a cyano group, a substituted or unsubstituted silyl group, a substituted or unsubstituted aryl group of 6 to 30 carbon atoms for forming a ring, or a substituted or unsubstituted heteroaryl group of 2 to 30 carbon atoms for forming a ring.

In addition, in Formula H-2b, R_{y1} to R_{y3} are each independently a hydrogen atom, a deuterium atom, a cyano group, a substituted or unsubstituted silyl group, a substituted or unsubstituted aryl group of 6 to 30 carbon atoms for forming a ring, or a substituted or unsubstituted heteroaryl group of 2 to 30 carbon atoms for forming a ring. In addition, in Formula H-2b, at least one selected from R₁₁ to R₁₃ and R_{y1} to R_{y3} is a cyano group, an aryl group of 6 to 30 carbon atoms for forming a ring including at least one cyano group as a substituent, or a heteroaryl group of 2 to 30 carbon atoms for forming a ring including at least one cyano group as a substituent. For example, in Formula H-2b, at least one selected from R₁₁ to R₁₃ and R_{y1} to R_{y3} may be a cyano group, an aryl group of 6 to 15 carbon atoms for forming a ring including at least one cyano group as a substituent, or a heteroaryl group of 2 to 12 carbon atoms for forming a ring including at least one cyano group as a substituent.

For example, the second host represented by Formula H-2a includes a triazine moiety, and the second host represented by Formula H-2b includes at least one cyano group.

In Formula H-2a, R₁₁ to R₁₃ may each independently be a substituted or unsubstituted phenyl group, a substituted or unsubstituted carbazole group, etc., but an embodiment of the present disclosure is not limited thereto.

In Formula H-2b, any one selected from R₁₁ to R₁₃ and R_{y1} to R_{y3} may be substituted with a cyano group, or at least one selected from R₁₁ to R₁₃ and R_{y1} to R_{y3} may be a heteroaryl group of 2 to 30 carbon atoms for forming a ring substituted with a cyano group. The heteroaryl group of 2 to 30 carbon atoms for forming a ring substituted with at least one cyano group may further include a substituent in addition to the cyano group, and the substituent may be a substituted or unsubstituted silyl group, a substituted or unsubstituted alkyl group of 1 to 10 carbon atoms, a substituted or unsubstituted aryl group of 6 to 30 carbon atoms for forming a ring, or a substituted or unsubstituted heteroaryl group of 2 to 30 carbon atoms for forming a ring.

The organic electroluminescence device 10 includes the first host represented by Formula H-1 and the second host represented by Formula H-2 simultaneously (e.g., at the same time) in the emission layer EML, and also includes a first dopant and a second dopant (described in more detail below), in the emission layer EML, and may show excellent emission efficiency and long-lifespan characteristics. In the emission layer EML of the organic electroluminescence device 10 of an embodiment, the host may be an exciplex formed by the first host represented by Formula H-1 and the second host represented by Formula H-2.

Among the two host materials included simultaneously in the emission layer EML, the first host may be a hole transport host, and the second host may be an electron transport host. The organic electroluminescence device 10 of an embodiment may include both (e.g., simultaneously) the first host having excellent hole transport properties and the second host having excellent electron transport properties in the emission layer EML, such that energy transfer to the dopant compounds may be efficient.

The emission layer EML may include an organometallic complex including iridium (Ir), ruthenium (Ru), rhodium (Rh), platinum (Pt), palladium (Pd), copper (Cu), or osmium (Os) as a central metal element, bonded to one or more ligands, as the first dopant. In the organic electroluminescence device 10 of an embodiment, the emission layer may include a compound represented by Formula D-1 as the first dopant:

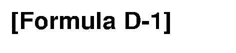

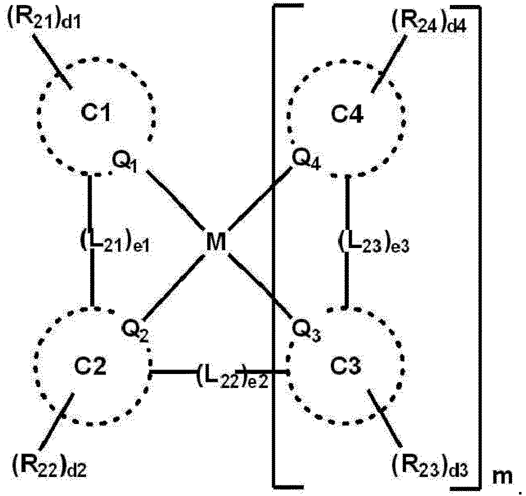

In Formula D-1, M is a metal element, such as a transition metal element. M may be Pt, Pd, Cu, Os, Ir, Ru, or Rh.

In Formula D-1, Q₁ to Q₄ are each independently C or N.

In Formula D-1, C1 to C4 are each independently a substituted or unsubstituted hydrocarbon ring of 5 to 30 carbon atoms for forming a ring, or a substituted or unsubstituted heterocycle of 2 to 30 carbon atoms for forming a ring. For example, C1 to C4 may each independently be a substituted or unsubstituted hydrocarbon ring of 5 to 15 carbon atoms for forming a ring, or a substituted or unsubstituted heterocycle of 2 to 12 carbon atoms for forming a ring.

In Formula D-1, L₂₁ to L₂₃ are each independently a direct linkage, *-o-*, *-s-*, 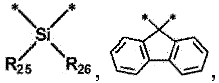 a substituted or unsubstituted divalent alkyl group of 1 to 20 carbon atoms, a substituted or unsubstituted arylene group of 6 to 30 carbon atoms for forming a ring, or a substituted or unsubstituted heteroarylene group of 2 to 30 carbon atoms for forming a ring. In L₂₁ to L₂₃, -* means a connected part with C1 to C4. For example, L₂₁ to L₂₃ may each independently be a direct linkage, *-o-*, 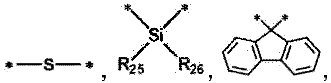 a substituted or unsubstituted divalent alkyl group of 1 to 6 carbon atoms, a substituted or unsubstituted arylene group of 6 to 15 carbon atoms for forming a ring, or a substituted or unsubstituted heteroarylene group of 2 to 12 carbon atoms for forming a ring.

In Formula D-1, e1 to e3 are each independently 0 or 1. When e1 is 0, C1 and C2 may not be (are not) interconnected. When e2 is 0, C2 and C3 may not be (are not) interconnected. When e3 is 0, C3 and C4 may not be (are not) interconnected.

R₂₁ to R₂₆ are each independently a hydrogen atom, a deuterium atom, a halogen atom, a cyano group, a substituted or unsubstituted amine group, a substituted or unsubstituted alkyl group of 1 to 20 carbon atoms, a substituted or unsubstituted aryl group of 6 to 30 carbon atoms for forming a ring, or a substituted or unsubstituted heteroaryl group of 1 to 30 carbon atoms for forming a ring, or are combined with an adjacent group to form a ring. For example, R₂₁ to R₂₆ may each independently a hydrogen atom, a deuterium atom, a halogen atom, a cyano group, a substituted or unsubstituted amine group, a substituted or unsubstituted alkyl group of 1 to 6 carbon atoms, a substituted or unsubstituted aryl group of 6 to 15 carbon atoms for forming a ring, or a substituted or unsubstituted heteroaryl group of 1 to 12 carbon atoms for forming a ring, or are combined with an adjacent group to form a ring. For example, when R₂₁ to R₂₆ are alkyl groups, R₂₁ to R₂₆ may be a methyl group, an isopropyl group, or a tert-butyl group. When R₂₁ to R₂₆ are amine groups, R₂₁ to R₂₆ may be a dimethylamine group. When R₂₁ to R₂₆ are halogen atoms, R₂₁ to R₂₆ may be a fluorine atom (F).

d1 to d4 are each independently an integer of 0 to 4. When d1 to d4 are each integers of 2 or more, a plurality of R₂₁ to R₂₄ groups may all be the same, or at least one may be different.

"m" may be 1 or 2. When M is Pt, Pd, Cu, or Os, "m" is 1. When M is Ir, Ru, or Rh, "m" is 2, and e2 is 0.

For example, Formula D-1 may be represented by Formula D-1a-1:

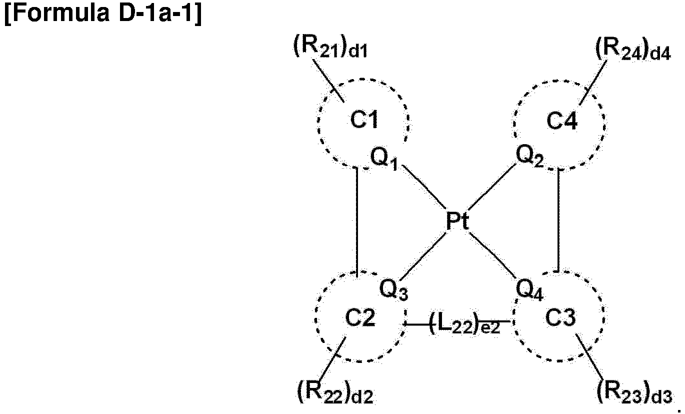

In Formula D-1a-1, C1 to C4, Q₁ to Q₄, R₂₁ to R₂₄, d1 to d4, L₂₂, and e2 may be the same as described herein in connection with Formula D-1.

In Formula D-1a-1, C1 to C4 may each independently be a substituted or unsubstituted hydrocarbon ring or a substituted or unsubstituted heterocycle, represented by any one of C-1 to C-3:

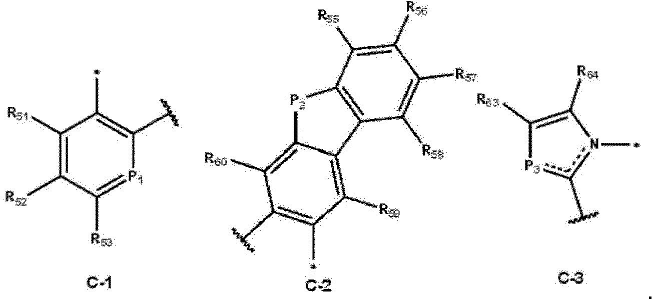

In C-1 to C-3, P₁ is C-* or CR₅₄, P₂ is N-* or NR₆₁, and P₃ is N-* or NR₆₂. R₅₁ to R₆₄ are each independently a substituted or unsubstituted alkyl group of 1 to 20 carbon atoms, a substituted or unsubstituted aryl group of 6 to 30 carbon atoms for forming a ring, or a substituted or unsubstituted heteroaryl group of 6 to 30 carbon atoms for forming a ring, or may be combined with an adjacent group to form a ring. For example, R₅₁ to R₆₄ may each independently be a substituted or unsubstituted alkyl group of 1 to 6 carbon atoms, a substituted or unsubstituted aryl group of 6 to 15 carbon atoms for forming a ring, or a substituted or unsubstituted heteroaryl group of 6 to 12 carbon atoms for forming a ring, or may be combined with an adjacent group to form a ring.

In addition, in C-1 to C-3, 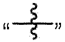 refers to a connection point with M1 (the central metal atom), and "-*" refers to a connection point with an adjacent ring group (C1 to C4) or a linker (L₂₁ to L₂₄).

For example, Formula D-1 may be represented by Formula D-1b-1:

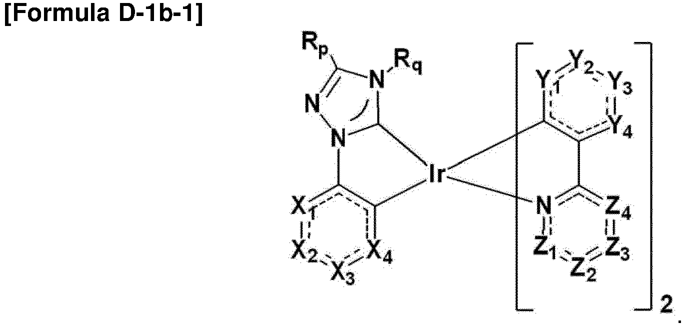

In Formula D-1b-1, X₁ to X₄, Y₁ to Y₄, and Z₁ to Z₄ are each independently CRₙ or N. In addition, Rₚ, R_{q}, and Rₙ are each independently a hydrogen atom, a deuterium atom, a halogen atom, a cyano group, a substituted or unsubstituted alkyl group of 1 to 20 carbon atoms, a substituted or unsubstituted hydrocarbon ring of 5 to 30 carbon atoms for forming a ring, a substituted or unsubstituted heterocycle of 2 to 30 carbon atoms for forming a ring, or a substituted or unsubstituted amine group, or are combined with an adjacent group to form a ring. For example, Rₚ, R_{q}, and Rₙ may each independently be a hydrogen atom, a deuterium atom, a halogen atom, a cyano group, a substituted or unsubstituted alkyl group of 1 to 6 carbon atoms, a substituted or unsubstituted hydrocarbon ring of 5 to 15 carbon atoms for forming a ring, a substituted or unsubstituted heterocycle of 2 to 12 carbon atoms for forming a ring, or a substituted or unsubstituted amine group, or may be combined with an adjacent group to form a ring. In Formula D-1b-1, the hexagonal rings including X₁ to X₄, Y₁ to Y₄, or Z₁ to Z₄ as ring-forming atoms may each independently be a substituted or unsubstituted benzene ring, a substituted or unsubstituted pyridine ring, a substituted or unsubstituted pyrimidine ring, or a substituted or unsubstituted triazine ring.

The first dopant represented by Formula D-1a-1 or Formula D-1b-1 may be a phosphorescent dopant.

The organic electroluminescence device 10 of an embodiment includes a second dopant in addition to the first dopant represented by Formula D-1 in the emission layer EML. The second dopant may be a fluorescent dopant. The second dopant may be a material to emit blue light.

In the organic electroluminescence device 10 of an embodiment, the emission layer may include a compound represented by one of Formula D-2a or D-2b as the second dopant:

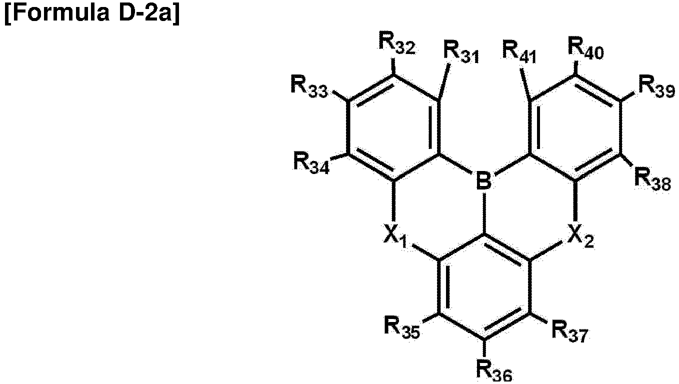

In Formulae D-2a, X₁ and X₂ are each independently NRₘ or O, and Rₘ is a hydrogen atom, a deuterium atom, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring. For example, Rₘ may be a hydrogen atom, a deuterium atom, a substituted or unsubstituted alkyl group of 1 to 6 carbon atoms, a substituted or unsubstituted aryl group of 6 to 15 carbon atoms for forming a ring, or a substituted or unsubstituted heteroaryl group of 2 to 12 carbon atoms for forming a ring. In Formula D-2, R₃₁ to R₄₁ are each independently a hydrogen atom, a deuterium atom, a halogen atom, a cyano group, a substituted or unsubstituted amine group, a substituted or unsubstituted boryl group, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring, or are combined with an adjacent group to form a ring. For example, R₃₁ to R₄₁ may each independently be a hydrogen atom, a deuterium atom, a halogen atom, a cyano group, a substituted or unsubstituted amine group, a substituted or unsubstituted boryl group, a substituted or unsubstituted aryl oxy group, a substituted or unsubstituted alkoxy group, a substituted or unsubstituted alkyl group of 1 to 10 carbon atoms, a substituted or unsubstituted aryl group of 6 to 15 carbon atoms for forming a ring, or a substituted or unsubstituted heteroaryl group of 2 to 12 carbon atoms for forming a ring, or may be combined with an adjacent group to form a ring.

For example, in Formula D-2a, R₃₁ to R₄₁ may each independently be a hydrogen atom, a substituted or unsubstituted phenyl group, a substituted or unsubstituted carbazole group, a substituted or unsubstituted aryl oxy group, a substituted or unsubstituted alkoxy group, a substituted or unsubstituted alkyl boryl group, or a substituted or unsubstituted aryl boryl group.

In Formula D-2a, R₃₉ and R₄₀ may be combined with each other to form a heterocycle. A condensed heterocycle formed by combining R₃₉ and R₄₀ with each other may include B, O, or N as a heteroatom. The condensed heterocycle may be unsubstituted, or substituted with a substituted or unsubstituted aryl group or a substituted or unsubstituted heteroaryl group.

The second dopant represented by Formula D-2a may be represented by any one of Formula D-2a-1 to Formula D-2a-4:

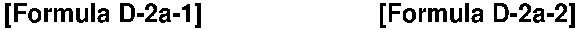

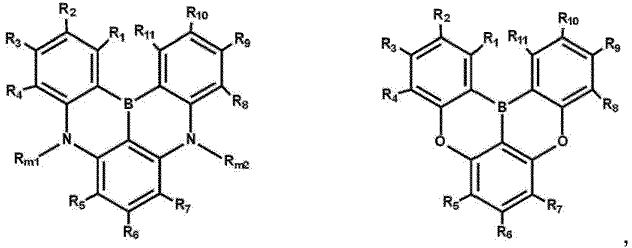

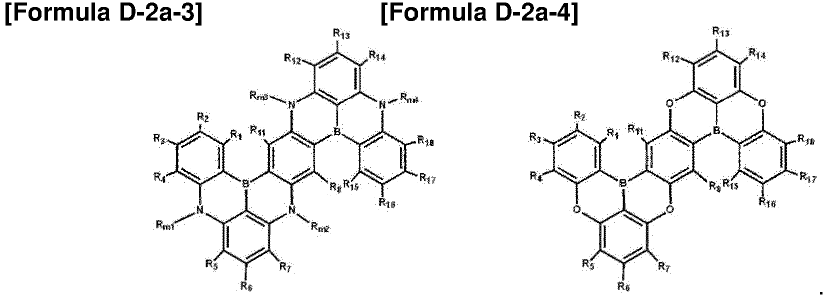

In Formula D-2a-1 to Formula D-2a-4, Rₘ₁ to Rₘ₄ are each independently a hydrogen atom, a deuterium atom, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring. For example, Rₘ₁ to Rₘ₄ may each independently be a hydrogen atom, a deuterium atom, a substituted or unsubstituted alkyl group of 1 to 6 carbon atoms, a substituted or unsubstituted aryl group of 6 to 15 carbon atoms for forming a ring, or a substituted or unsubstituted heteroaryl group of 2 to 12 carbon atoms for forming a ring. R₁ to R₁₈ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted alkyl group of 1 to 20 carbon atoms, a substituted or unsubstituted aryl group of 6 to 30 carbon atoms for forming a ring, or a substituted or unsubstituted heteroaryl group of 2 to 30 carbon atoms for forming a ring, or combined with an adjacent group to form a ring. For example, R₁ to R₁₈ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted alkyl group of 1 to 10 carbon atoms, a substituted or unsubstituted aryl group of 6 to 15 carbon atoms for forming a ring, or a substituted or unsubstituted heteroaryl group of 2 to 12 carbon atoms for forming a ring, or combined with an adjacent group to form a ring.

For example, Rₘ₁ to Rₘ₄ may each independently be a hydrogen atom or a substituted or unsubstituted phenyl group. In addition, R₁ to R₁₈ may each independently be a hydrogen atom, a substituted or unsubstituted alkyl group of 1 to 10 carbon atoms, a substituted or unsubstituted phenyl group, a substituted or unsubstituted carbazole group, or a substituted or unsubstituted arylamine group of 6 to 20 carbon atoms for forming a ring. However, an embodiment of the present disclosure is not limited thereto.

**[Formula D-2b]** **D₁-L₂-A₁.**

In Formula D-2b, L₂ is a direct linkage, a substituted or unsubstituted arylene group of 6 to 30 carbon atoms for forming a ring, or a substituted or unsubstituted heteroarylene group of 2 to 30 carbon atoms for forming a ring. For example, L₂ may be a direct linkage, a substituted or unsubstituted arylene group of 6 to 15 carbon atoms for forming a ring, or a substituted or unsubstituted heteroarylene group of 2 to 12 carbon atoms for forming a ring. For example, L₂ may be a direct linkage, or a substituted or unsubstituted phenylene group.

In Formula D-2b, D₁ is represented by one of Formula D-2-1 or Formula D-2-2:

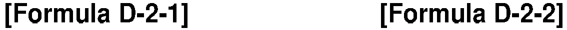

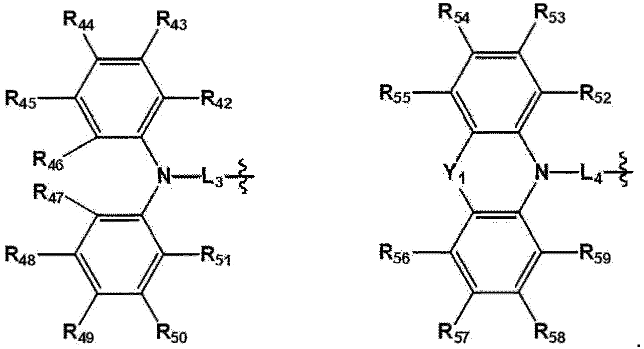

In Formulae D-2-1 and D-2-2, L₃ and L₄ are each independently a direct linkage, or a substituted or unsubstituted arylene group of 6 to 30 carbon atoms for forming a ring. For example, L₃ and L₄ may each independently be a direct linkage, or a substituted or unsubstituted arylene group of 6 to 15 carbon atoms for forming a ring. For example, L₃ and L₄ may each independently be a direct linkage, or a substituted or unsubstituted phenylene group.

R₄₂ to R₅₉ are each independently a hydrogen atom, a deuterium atom, a halogen atom, a substituted or unsubstituted amine group, a substituted or unsubstituted silyl group, a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring. For example, R₄₂ to R₅₉ may each independently be a hydrogen atom, a deuterium atom, a halogen atom, a substituted or unsubstituted amine group, a substituted or unsubstituted silyl group, a substituted or unsubstituted alkyl group of 1 to 6 carbon atoms, a substituted or unsubstituted aryl group of 6 to 15 carbon atoms for forming a ring, or a substituted or unsubstituted heteroaryl group of 2 to 12 carbon atoms for forming a ring. In some embodiments, R₄₂ to R₅₉ may be combined with an adjacent group to form a ring.

Y₁ is a direct linkage, CRₐR_{b}, SiR_{c}R_{d}, GeRₑR_{f}, NR_{g}, O, or S. In an embodiment, Y₁ may be a direct linkage, CRₐR_{b}, NR_{g}, or O.

Rₐ to R_{g} are each independently a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring. For example, Rₐ to R_{g} may each independently be a substituted or unsubstituted alkyl group of 1 to 6 carbon atoms, a substituted or unsubstituted aryl group of 6 to 15 carbon atoms for forming a ring, or a substituted or unsubstituted heteroaryl group of 2 to 12 carbon atoms for forming a ring. Each pair of Rₐ and R_{b}, R_{c} and R_{d}, and Rₑ and R_{f} may be combined with each other to form a ring.

In Formula D-2b, A₁ is represented by one of Formulae D-2-3 to D-2-10:

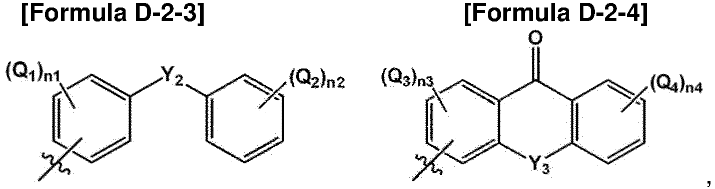

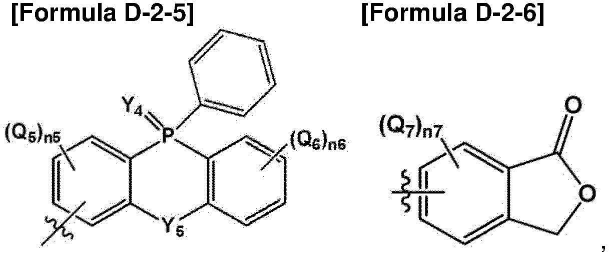

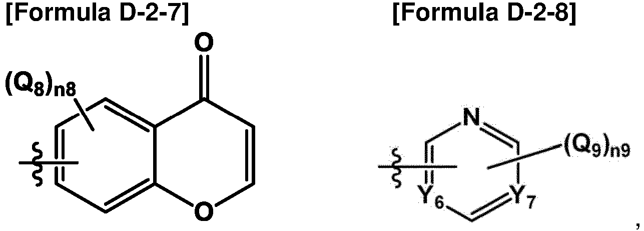

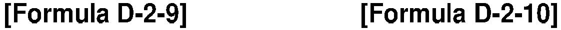

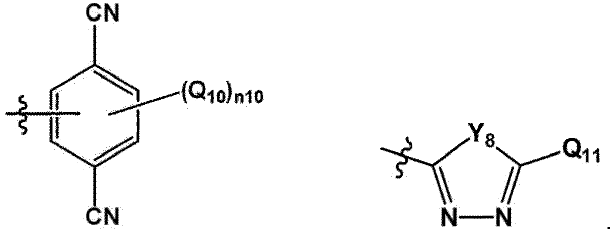

In Formula D-2-3, Y₂ is C=O, or S(C=O)₂. In Formula D-2-4, Y₃ is C=O, or O. In Formula D-2-5, Y₄ and Y₅ are each independently O, or S. In Formula D-2-8, Y₆ and Y₇ are each independently N, or CQ₁₂. In Formula D-2-10, Y₈ is O or NQ₁₃.

In Formulae D-2-3 to D-2-10, Q₁ to Q₁₃ are each independently a substituted or unsubstituted alkyl group of 1 to 15 carbon atoms, a substituted or unsubstituted aryl group of 6 to 30 carbon atoms for forming a ring, or a substituted or unsubstituted heteroaryl group of 2 to 30 carbon atoms for forming a ring. For example, Q₁ to Q₁₃ may each independently be a substituted or unsubstituted alkyl group of 1 to 6 carbon atoms, a substituted or unsubstituted aryl group of 6 to 15 carbon atoms for forming a ring, or a substituted or unsubstituted heteroaryl group of 2 to 12 carbon atoms for forming a ring.

In Formulae D-2-3 to D-2-10, n1, n4, and n6 are each independently 0 to 4; n3, n5, n7, n8, and n10 are each independently an integer of 0 to 3; n2 is an integer of 0 to 5; and n9 is an integer of 0 to 2. When n1 to n10 are each independently an integer of 2 or more, a plurality of Q₁ to Q₁₀ may be the same, or at least one may be different.

The organic electroluminescence device 10 of an embodiment may include the first dopant represented by Formula D-1 and the second dopant represented by Formula D-2a or Formula D-2b in the emission layer EML. The organic electroluminescence device 10 includes the first dopant and the second dopant simultaneously (e.g., together), and may show excellent emission efficiency and/or improved device lifespan characteristics.

The lowest triplet excitation energy level (T1 level) of the first dopant may be substantially equal to or greater than the lowest triplet excitation energy level (T1 level) of the second dopant. The lowest triplet excitation energy level of the host may be substantially equal to or greater than the lowest triplet excitation energy level of the second dopant. In an embodiment, the first dopant may play the role of an assistant dopant which transfers the energy of the host to the second dopant. The second dopant may be a light-emitting dopant that is excited by the transferred energy from the host via the first dopant, and subsequently emits light. In an embodiment, the lowest triplet excitation energy level of the host may be substantially equal to or greater than the lowest triplet excitation energy levels of the first dopant and the second dopant, respectively, and the lowest triplet excitation energy of the second dopant may be smaller than the lowest triplet excitation energy level of the host and the lowest triplet excitation energy level of the first dopant, respectively. In this description, the lowest triplet energy level (T1 energy level) is calculated by measuring the low-temperature emission spectrum of a single film, obtaining the onset wavelength, and converting it to the energy level.

In an embodiment, the second dopant may be a thermally activated delayed fluorescence (TADF) dopant. For example, in an embodiment, the second dopant may have a reverse intersystem crossing constant (k_{RISC}) of about 10³ s⁻¹ or more and/or f (oscillation strength) of about 0.1 or more, and thus, thermally activated delayed fluorescence may be easily produced.

In an embodiment, the second dopant is a light-emitting dopant to emit blue light, and the emission layer EML may emit fluorescence. For example, the emission layer EML may emit blue light as delayed fluorescence.

In an embodiment, the first dopant, which is the assistant dopant, may accelerate the delayed fluorescence of the second dopant. Accordingly, the emission efficiency of the emission layer of an embodiment may be improved. In addition, when the delayed fluorescence is accelerated, excitons formed in the emission layer EML may not be accumulated in the emission layer EML, but may rapidly emit light, thereby reducing device deterioration. Accordingly, the lifespan of the organic electroluminescence device 10 of an embodiment may increase.

In the organic electroluminescence device 10, the emission layer EML includes the first host, the second host, the first dopant, and the second dopant, and the amount of the first dopant may be about 10 wt% to about 15 wt%, and the amount of the second dopant may be about 1 wt% to about 5 wt% based on the total weight of the first host, the second host, the first dopant, and the second dopant.

If the amounts of the first dopant and the second dopant satisfy the above-described ratios, the first dopant may efficiently transfer energy to the second dopant, and thus, the emission efficiency and device lifespan may increase.

In the emission layer EML, the amount of the first host and the second host may be the remainder of the total weight, e.g., excluding the first dopant and the second dopant. For example, in the emission layer EML, the amount of the first host and the second host may be about 80 wt% to about 89 wt% based on the total weight of the first host, the second host, the first dopant, and the second dopant. Out of the total weight of the first host and the second host, the weight ratio of the first host and the second host may be about 7:3 to about 3:7.

When the amounts of the first host and the second host satisfy the above-described ratio, charge balance properties in the emission layer EML may be improved, and emission efficiency and/or device life may increase. When the amounts of the first host and the second host deviate from the above-described ratio range, charge balance in the emission layer EML may be broken, emission efficiency may be degraded, and a device may be easily deteriorated.

If the first host, the second host, the first dopant, and the second dopant included in the emission layer EML satisfy the above-described amounts and ratios, excellent emission efficiency and/or long life may be achieved.

The organic electroluminescence device 10 includes the first host, the second host, the first dopant, and the second dopant, and the emission layer EML includes the combination of two host materials and two dopant materials. In the organic electroluminescence device 10 of an embodiment, the emission layer EML may include two different hosts, a first dopant including an organometallic complex, and a second dopant emitting delayed fluorescence, and may thereby show excellent emission efficiency and/or lifespan characteristics.

In an embodiment, the first host represented by Formula H-1 may be represented by any one of the compounds represented in Compound Group 1. The emission layer EML may include at least one of the compounds represented in Compound Group 1 as the first host material.

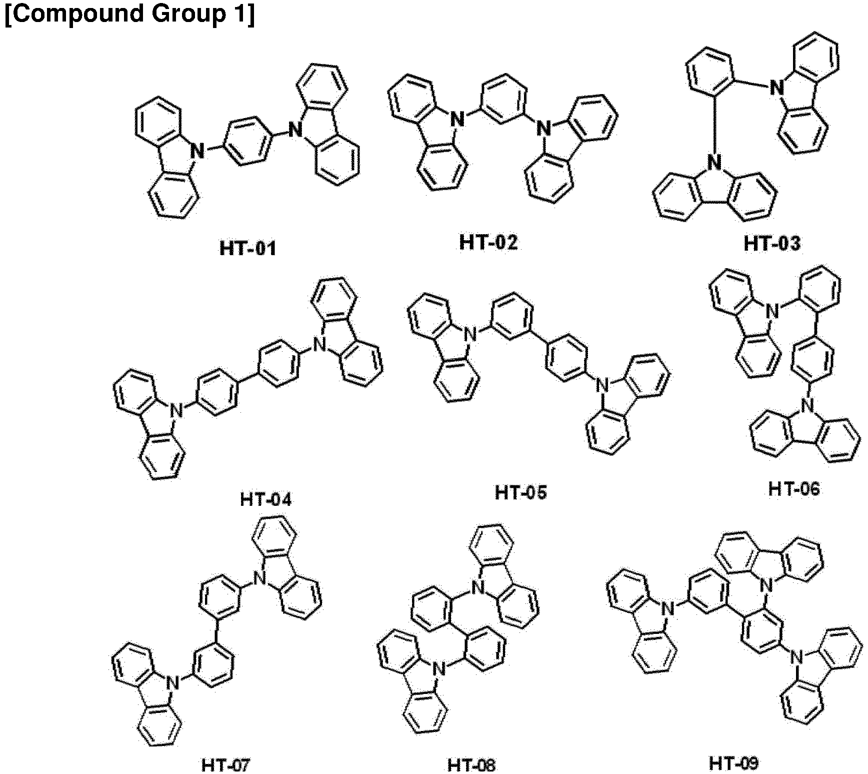

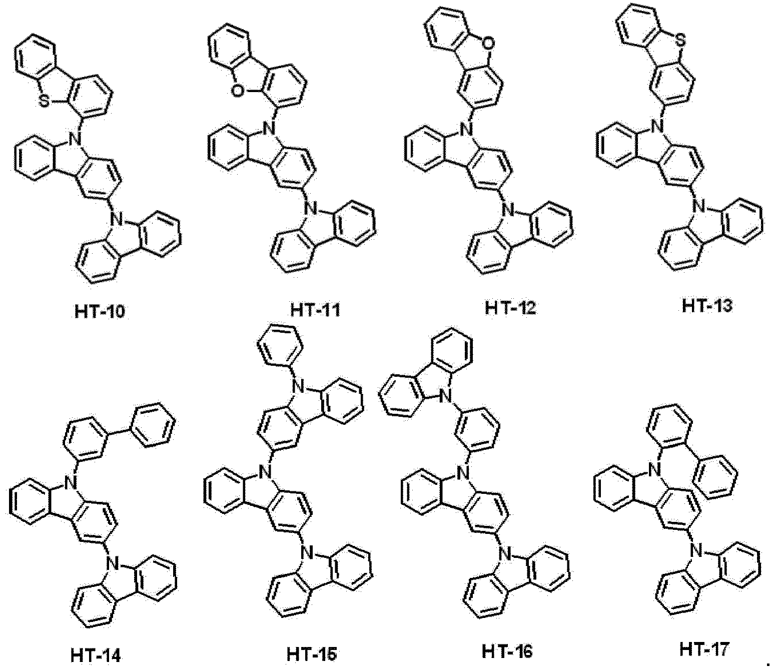

In an embodiment, the second host represented by Formula H-2 may be represented by any one of the compounds represented in Compound Group 2-1 and Compound Group 2-2. The emission layer EML may include at least one of the compounds represented in Compound Group 2-1 and Compound Group 2-2 as the second host material. Compound Group 2-1 may correspond to the second host material represented by Formula H-2a, and Compound Group 2-2 may correspond to the second host material represented by Formula H-2b.

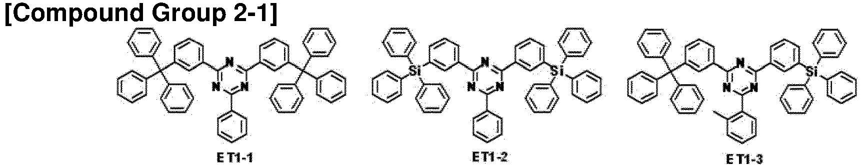

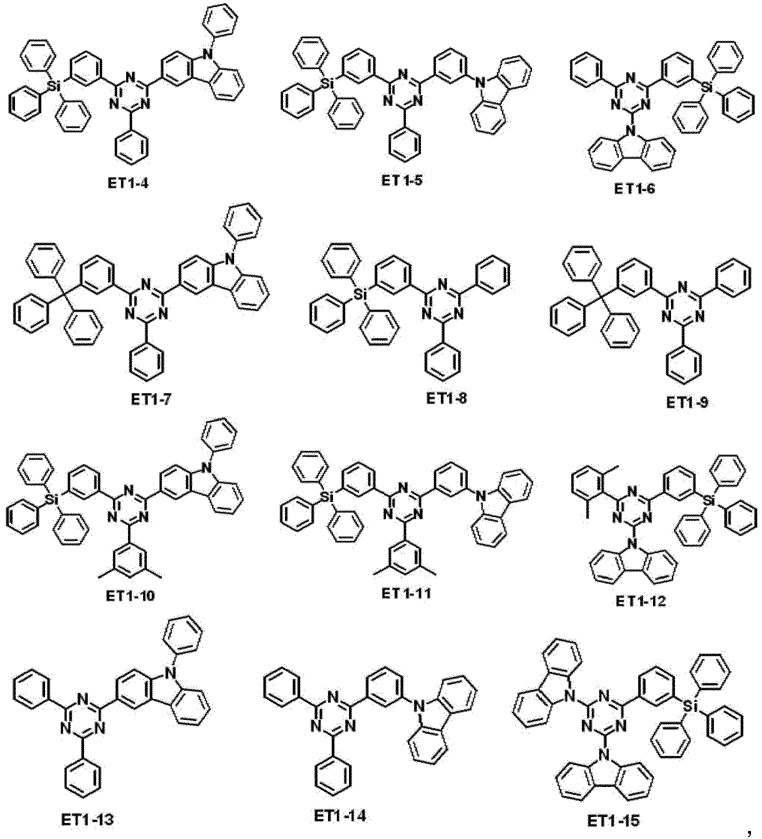

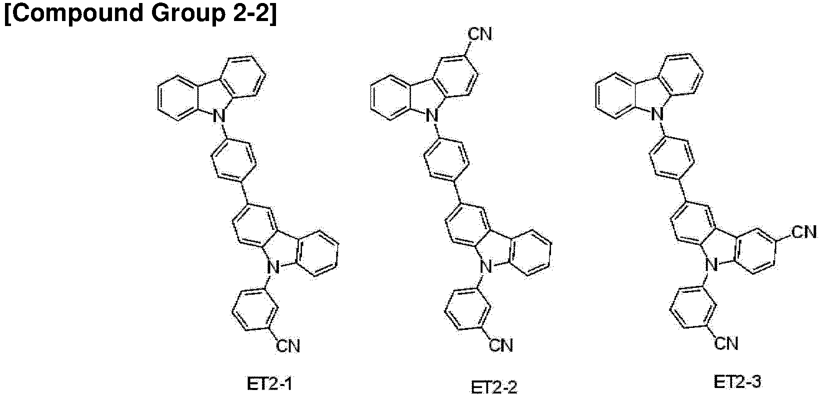

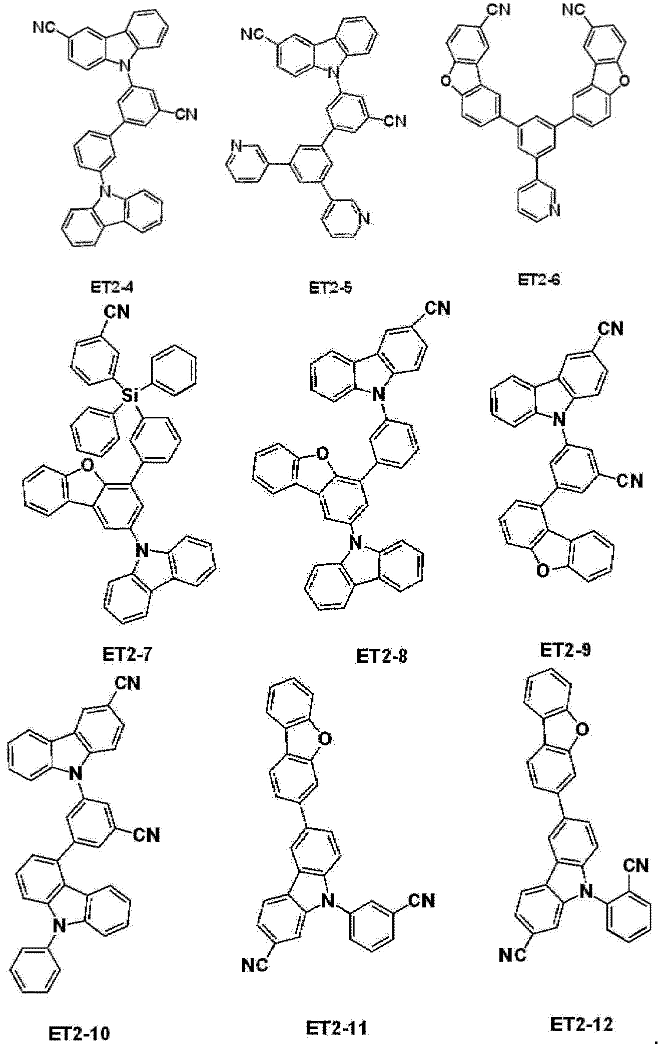

In an embodiment, the emission layer EML may include at least one of the compounds represented in Compound Group 3-1 and Compound Group 3-2 as the first dopant material. Compound Group 3-1 may correspond to the first dopant material represented by Formula D-1a-1, and Compound Group 3-2 may correspond to the first dopant material represented by Formula D-1b-1.

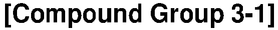

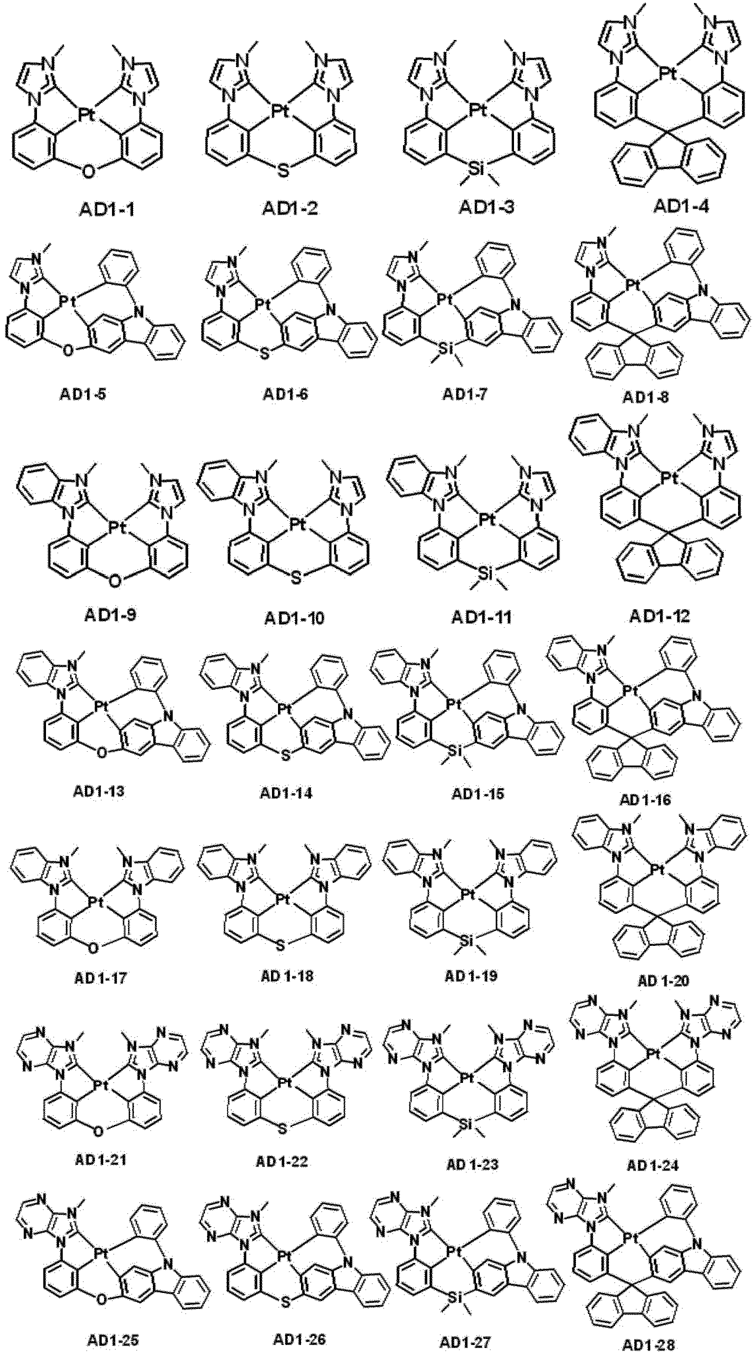

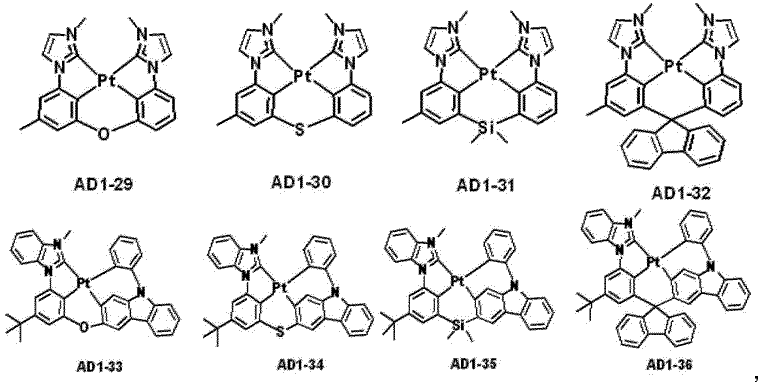

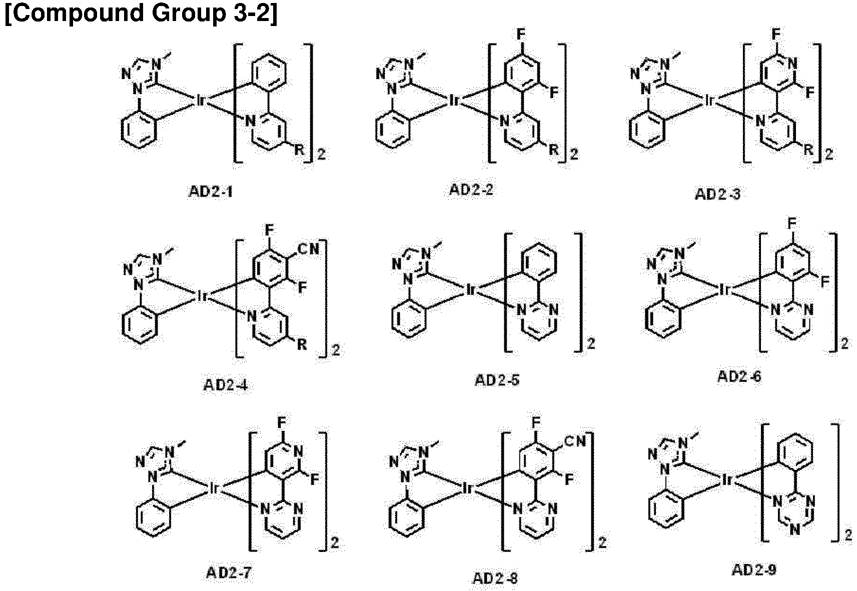

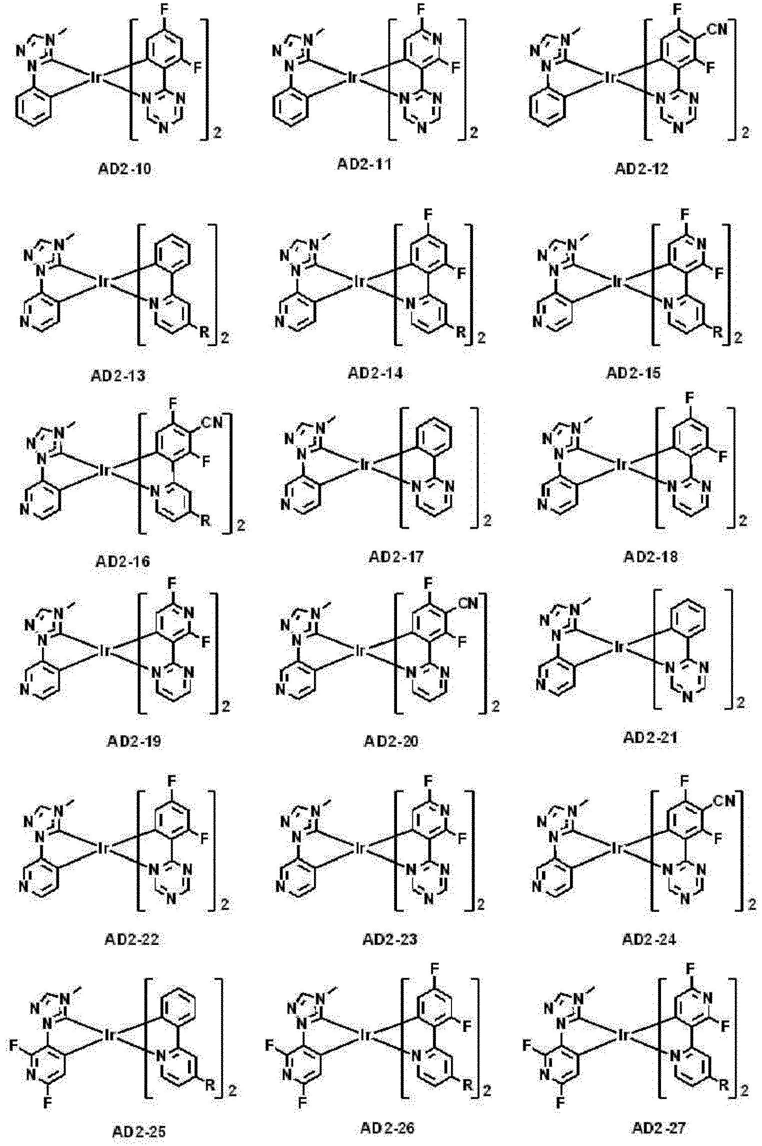

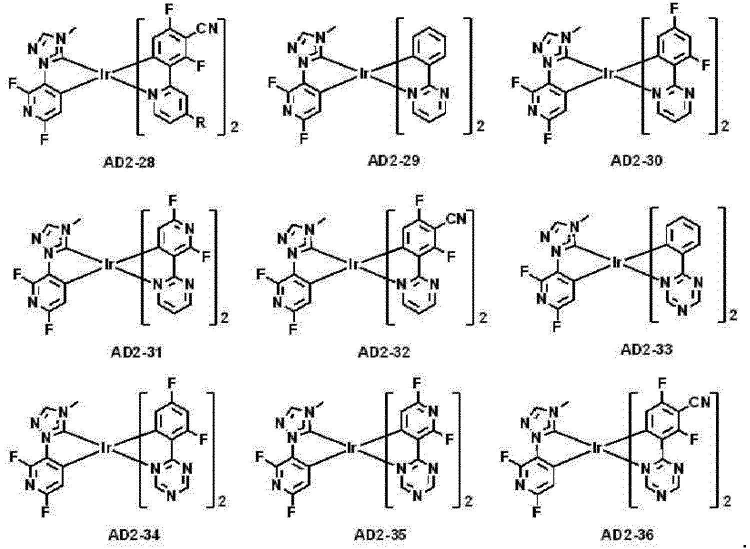

In Compound Group 3-2, in AD2-1 to AD2-4, AD2-13 to AD2-16, and AD2-25 to AD2-28, each R is independently a hydrogen atom, a methyl group, an isopropyl group, a tert-butyl group, or a dimethylamine group.

In an embodiment, the second dopant represented by Formula D-2 may be represented by any one of the compounds represented in Compound Group 4-1 or Compound Group 4-2. The emission layer EML may include at least one of the compounds represented in Compound Group 4-1 or Compound Group 4-2 as the second dopant material. Compound Group 4-1 may correspond to the second dopant material represented by Formula D-2a, and Compound Group 4-2 may correspond to the second dopant material represented by Formula D-2b.

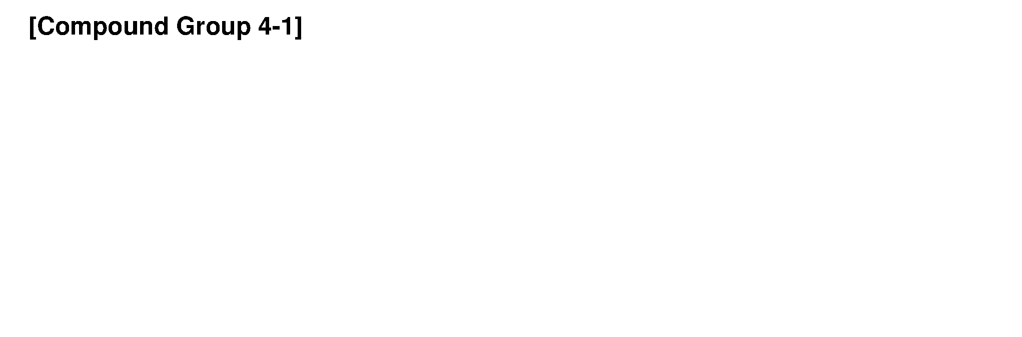

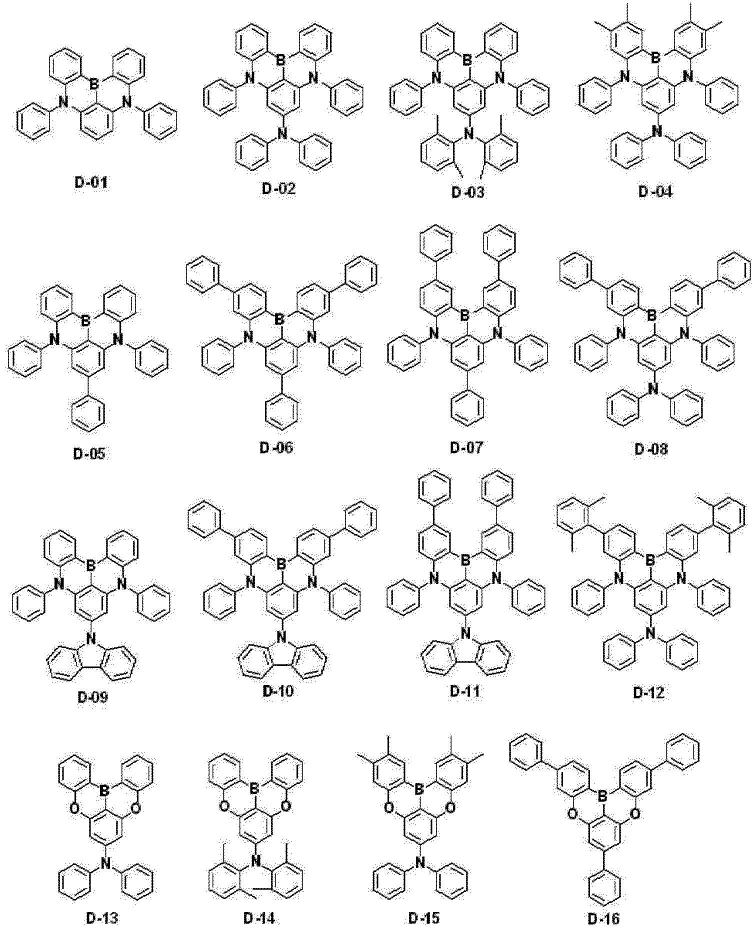

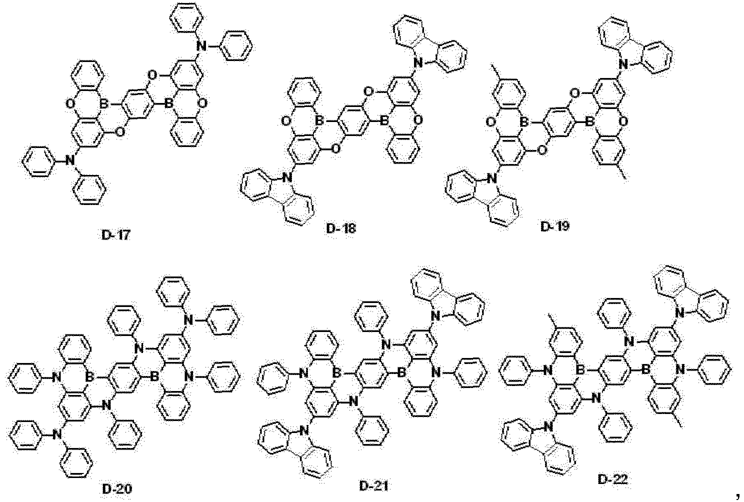

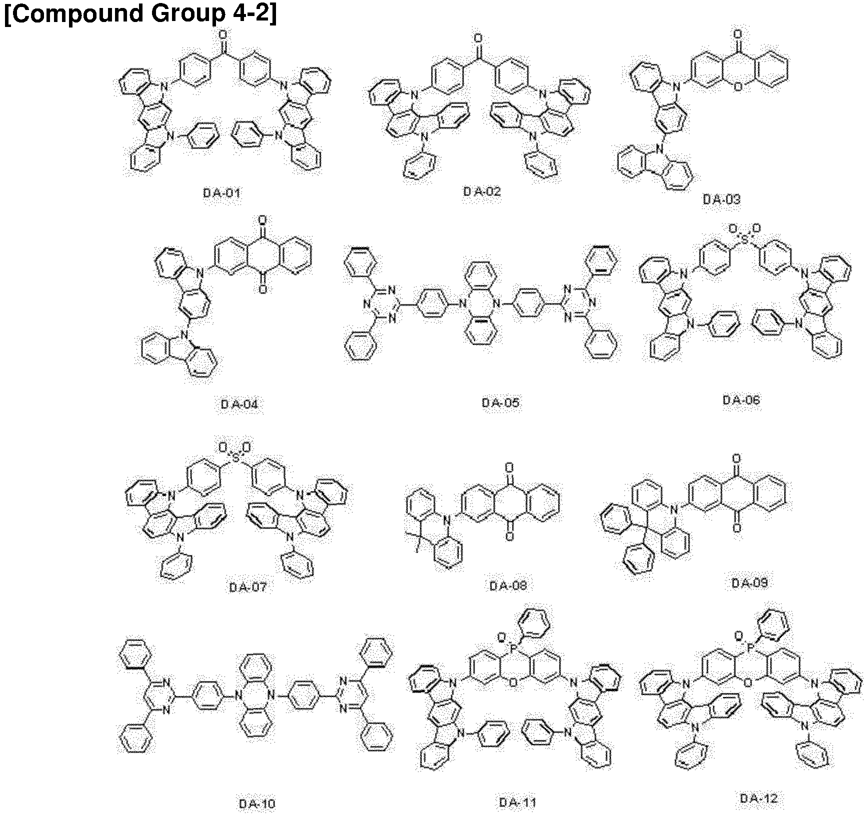

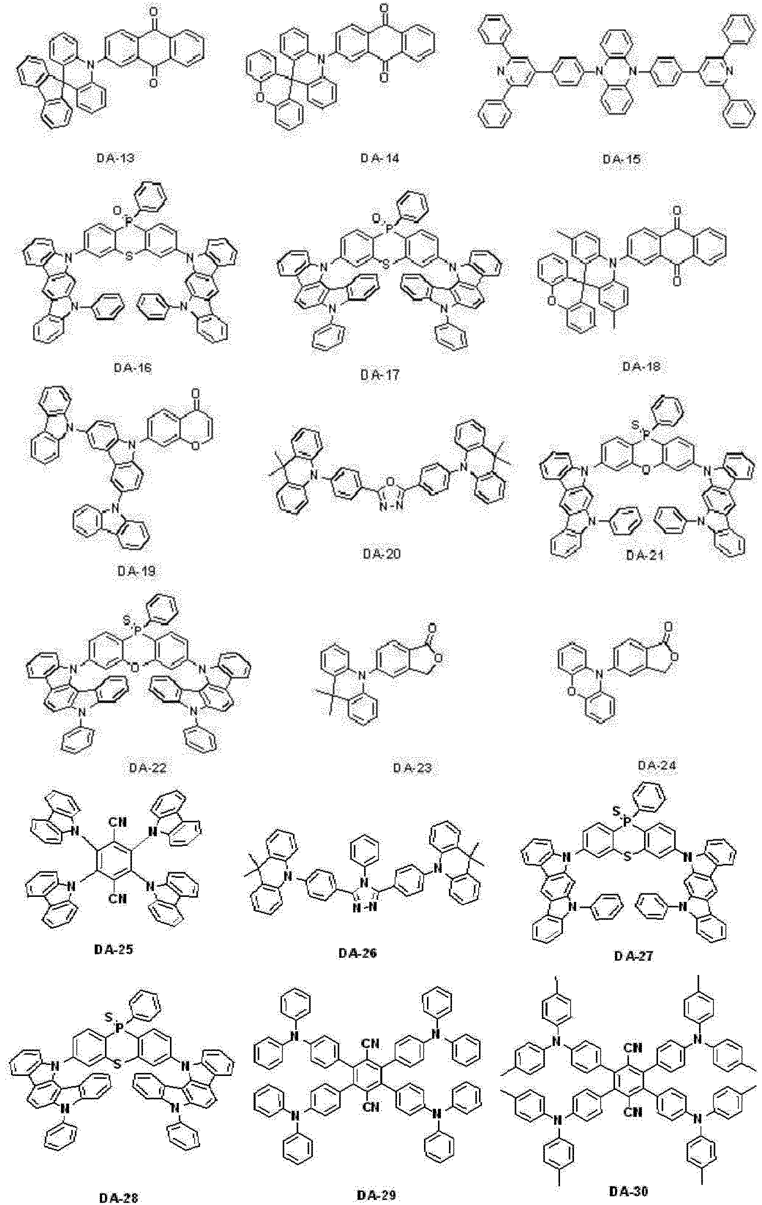

In the organic electroluminescence device 10, the host has a first luminescent onset wavelength, the first dopant has a second luminescent onset wavelength, and the second dopant has a third luminescent onset wavelength.

The third luminescent onset wavelength of the second dopant is greater than each of the first luminescent onset wavelength and the second luminescent onset wavelength. For example, the third luminescent onset wavelength of the second dopant may be greater than the second luminescent onset wavelength of the first dopant, and the second luminescent onset wavelength of the first dopant may be greater than the first luminescent onset wavelength of the host.

In the description, the term "luminescent onset wavelength" is defined as the wavelength at an x-intercept value of a tangent line that is drawn at a position (e.g., on the left side of the peak) where the light intensity y-value is about 0.5 in the normalized light emission spectrum. In this description, the normalized light absorption/emission spectrum is obtained by dissolving the luminous substance in an organic solvent and dividing it by the maximum value of the first peak after measuring the absorption/emission spectrum.

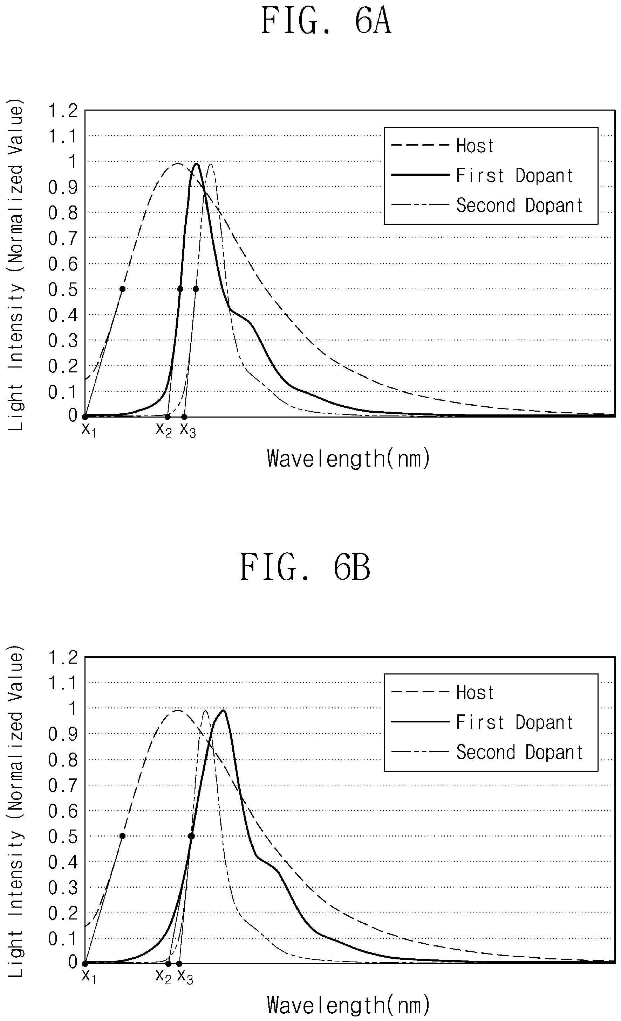

FIG. 6A to FIG. 6F are plots of the normalized light emission spectra (intensity vs. wavelength) of a host, a first dopant and a second dopant according to embodiments of the present disclosure.

In FIG. 6A to FIG. 6F, the x-intercept value of the tangent line that is drawn at a position where light intensity is about 0.5 in the normalized light emission spectrum of the host is defined as the first luminescent onset wavelength (x₁). In FIG. 6A to FIG. 6F, the x-intercept value of the tangent line that is drawn at a position where light intensity is about 0.5 in the normalized light emission spectrum of the first dopant is defined as the second luminescent onset wavelength (x₂). In FIG. 6A to FIG. 6F, the x-intercept value of the tangent line that is drawn at a position where light intensity is about 0.5 in the normalized light emission spectrum of the second dopant is defined as the third luminescent onset wavelength (x₃).

Referring to FIG. 6A to FIG. 6F, the third luminescent onset wavelength (x₃) of the second dopant has a greater value than each of the first luminescent onset wavelength (x₁) of the host and the second luminescent onset wavelength (x₂) of the first dopant. In an embodiment of the present disclosure, the first luminescent onset wavelength (x₁) may be smaller than the second luminescent onset wavelength (x₂) and the third luminescent onset wavelength (x₃), and the second luminescent onset wavelength (x₂) may have a greater value than the first luminescent onset wavelength (x₁) and a smaller value than the third luminescent onset wavelength (x₃). For example, in the emission layer according to an embodiment of the present disclosure, the values may increase in order of the first luminescent onset wavelength (x₁), the second luminescent onset wavelength (x₂), and the third luminescent onset wavelength (x₃).

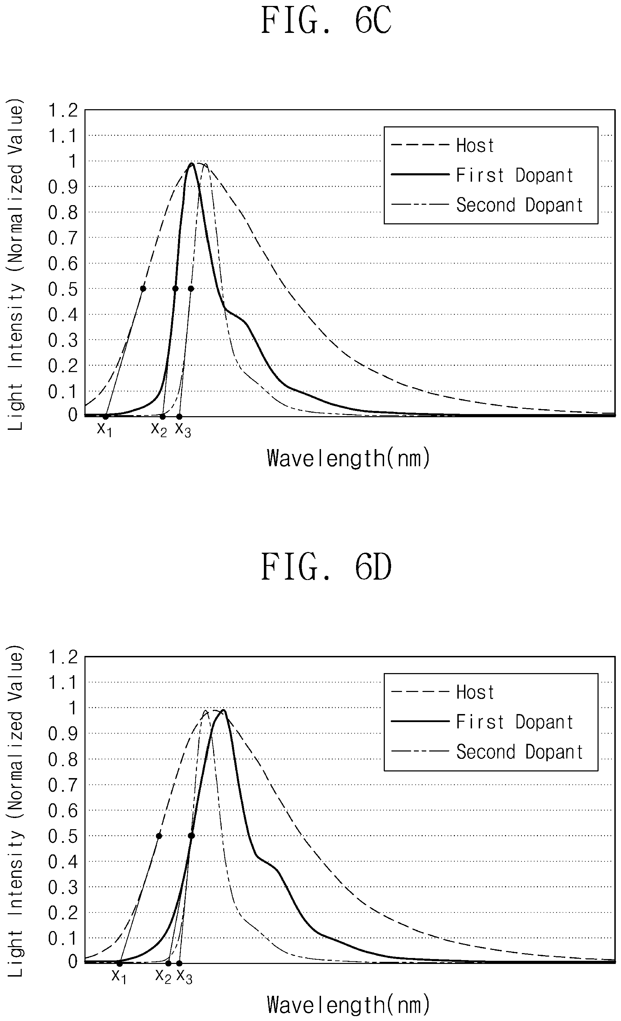

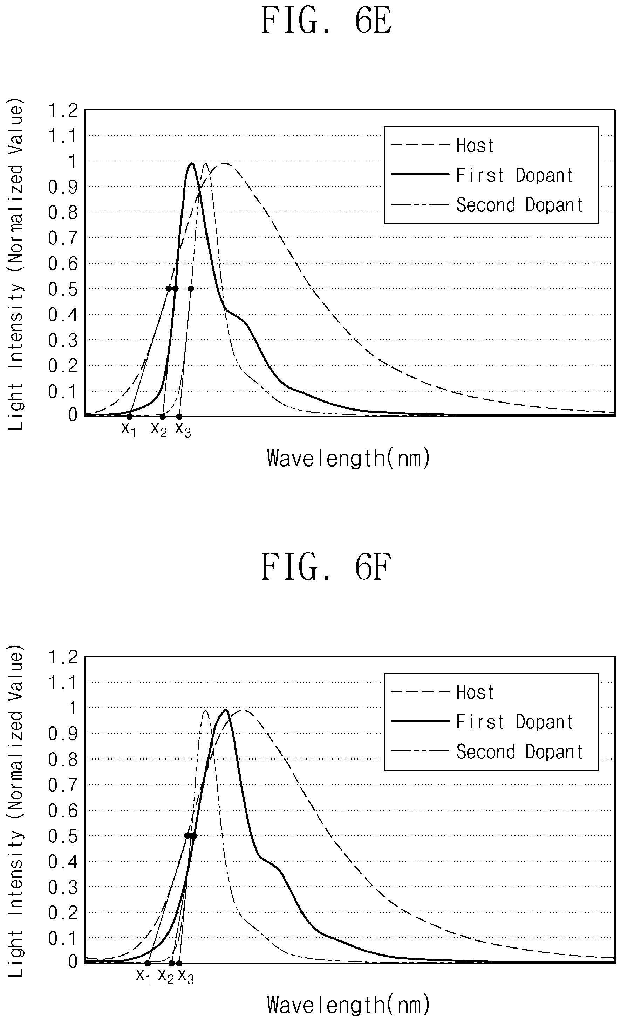

As shown in FIG. 6A, when the light emission peak wavelength of the host is the smallest, the light emission peak wavelength of the first dopant is greater than the light emission peak wavelength of the host, and the light emission peak wavelength of the second dopant is the greatest, the values may increase in order of the first luminescent onset wavelength (x₁), the second luminescent onset wavelength (x₂), and the third luminescent onset wavelength (x₃). Differently, as shown in FIG. 6B, when the light emission peak wavelength of the host is the smallest, and the light emission peak wavelength of the first dopant is the greatest, the values may also increase in order of the first luminescent onset wavelength (x₁), the second luminescent onset wavelength (x₂), and the third luminescent onset wavelength (x₃). As shown in FIG. 6C, when the light emission peak wavelength of the host is greater than the light emission peak wavelength of the first dopant, and the light emission peak wavelength of the second dopant has the greatest value, the values may also increase in order of the first luminescent onset wavelength (x₁), the second luminescent onset wavelength (x₂), and the third luminescent onset wavelength (x₃). As shown in FIG. 6D, when the light emission peak wavelength of the second dopant is the smallest, and the light emission peak wavelength of the first dopant is the greatest, the values may also increase in order of the first luminescent onset wavelength (x₁), the second luminescent onset wavelength (x₂), and the third luminescent onset wavelength (x₃). As shown in FIG. 6E, when the light emission peak wavelength of the host is the greatest, and the light emission peak wavelength of the first dopant is the smallest, the values may also increase in order of the first luminescent onset wavelength (x₁), the second luminescent onset wavelength (x₂), and the third luminescent onset wavelength (x₃). As shown in FIG. 6F, when the light emission peak wavelength of the second dopant is the smallest, the light emission peak wavelength of the host is the greatest, and the wavelengths are similar at positions where light intensities of the normalized light emission spectrum of the host, the normalized light emission spectrum of the first dopant, and the normalized light emission spectrum of the second dopant are all about 0.5 (e.g., when the x-value corresponding to a y-value of 0.5 is similar in each of the normalized light emission spectra of the host, first dopant, and second dopant), the values may also increase in order of the first luminescent onset wavelength (x₁), the second luminescent onset wavelength (x₂), and the third luminescent onset wavelength (X3).

In an embodiment of the present disclosure, the first luminescent onset wavelength may be about 380 nm to about 430 nm, the second luminescent onset wavelength may be about 400 nm to about 450 nm, and the third luminescent onset wavelength may be about 410 nm to about 460 nm.

In an embodiment of the present disclosure, the luminescent onset wavelength and luminescent onset energy are in inverse proportion to each other and may satisfy Equation 1: Luminescent onset energy of hast > luminescent onset energy of first dopant > luminescent onset energy of second dopant

Meanwhile, in the present description, onset energy is a concept that is inversely proportional to the onset wavelength, and is derived by dividing the absolute value of photon energy by the onset wavelength.

In the organic electroluminescence device 10, the emission layer EML includes a host having the first luminescent onset wavelength, a first dopant having the second luminescent onset wavelength, and a second dopant having the third luminescent onset wavelength, and the third luminescent onset wavelength has a greater value than each of the first luminescent onset wavelength and the second luminescent onset wavelength. For example, the third luminescent onset wavelength is greater than the second luminescent onset wavelength, and the second luminescent onset wavelength may have a greater value than the first luminescent onset wavelength.

In the organic electroluminescence device of an embodiment, the luminescent onset wavelength of the second dopant (which is a light-emitting body) is the greatest, the luminescent onset wavelength of the first dopant (which plays the role of an assistant dopant) is smaller than the luminescent onset wavelength of the second dopant, and the luminescent onset wavelength of the host has the smallest value. Accordingly, the energy transfer from the host to the first dopant, and from the first dopant to the second dopant may be easily achieved, and thus, the organic electroluminescence device may show excellent emission efficiency and/or lifespan characteristics.

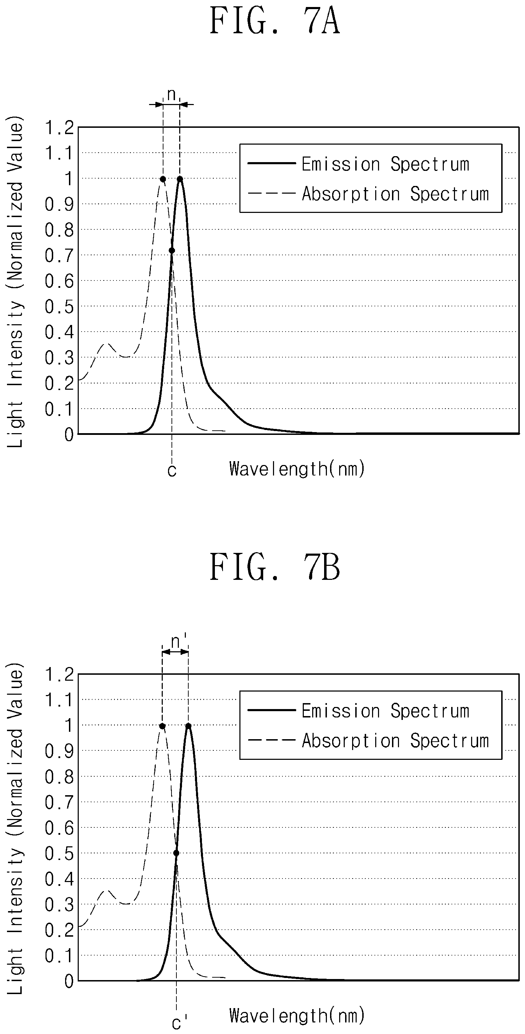

FIG. 7A and FIG. 7B are plots of the light emission spectrum and light absorption spectrum (intensity vs. wavelength) of the second dopant according to an embodiment of the present disclosure.

Referring to FIG. 7A and FIG. 7B, in the organic electroluminescence device 10, the normalized light intensity at the cross point of the normalized light absorption spectrum and the normalized light emission spectrum of the second dopant is about 0.5 or more. In addition, in the organic electroluminescence device 10, the distance (n or n') between the normalized light absorption spectrum peak and the normalized light emission spectrum peak of the second dopant is about 50 nm or less. For example, the peak-to-peak distance n or n' between the light absorption peak and the light emission peak in the normalized spectrum may be about 50 nm or less. When the above-described conditions of the light absorption spectrum and light emission spectrum of the second dopant are satisfied, energy transfer from the host and the first dopant to the second dopant may be easily achieved. Accordingly, the organic electroluminescence device may show excellent emission efficiency and lifespan characteristics.

In some embodiments, the organic electroluminescence device 10 of an embodiment may include a plurality of emission layers. The plurality of emission layers may be provided by stacking in order. For example, an organic electroluminescence device 10 including a plurality of emission layers may be to emit white light. The organic electroluminescence device including a plurality of emission layers may be an organic electroluminescence device of a tandem structure. When an organic electroluminescence device 10 includes a plurality of emission layers, at least one emission layer EML may include all the first host, second host, first dopant, and second dopant, as described above.

In the organic electroluminescence devices 10 of an embodiment, shown in FIG. 1 to FIG. 5, an electron transport region ETR is provided on an emission layer EML. The electron transport region ETR may include at least one of a hole blocking layer HBL, an electron transport layer ETL, or an electron injection layer ElL. However, an embodiment of the present disclosure is not limited thereto.

The electron transport region ETR may have a single layer formed using a single material, a single layer formed using a plurality of different materials, or a multilayer structure having a plurality of layers formed using a plurality of different materials.

For example, the electron transport region ETR may have a single layer structure including an electron injection layer EIL or an electron transport layer ETL, or a single layer structure formed using an electron injection material and an electron transport material (e.g., together). Further, the electron transport region ETR may have a plurality of layers formed of a plurality of different materials, for example, a structure stacked from the emission layer EML of electron transport layer ETL/electron injection layer EIL, or hole blocking layer HBL/electron transport layer ETL/electron injection layer EIL, without limitation. The thickness of the electron transport region ETR may be, for example, about 100 Å to about 1,500 Å or about 1,000 Å to about 1,500 Å.

The electron transport region ETR may be formed using various suitable methods (such as a vacuum deposition method, a spin coating method, a cast method, a Langmuir-Blodgett (LB) method, an inkjet printing method, a laser printing method, and/or a laser induced thermal imaging (LITI) method).

If the electron transport region ETR includes an electron transport layer ETL, the electron transport region ETR may include an anthracene-based compound. The electron transport region may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1 ,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAIq), beryllium bis(benzoquinolin-10-olate (Bebq2), 9,10-di(naphthalene-2-yl)anthracene (ADN), 1,3-bis[3,5-di(pyridine-3-yl)phenyl]benzene (BmPyPhB), or a mixture thereof, without limitation. The thickness of the electron transport layer ETL may be about 100 Å to about 1,000 Å and may be, for example, about 150 Å to about 500 Å. If the thickness of the electron transport layer ETL satisfies the above-described range, satisfactory electron transport properties may be obtained without substantial increase of a driving voltage.

If the electron transport region ETR includes the electron injection layer EIL, the electron transport region ETR may include a metal halide (such as LiF, NaCl, CsF, RbCI, Rbl, and/or Cul), a lanthanide metal (such as ytterbium (Yb)), a metal oxide (such as Li₂O and/or BaO), or lithium quinolate (LiQ). However, an embodiment of the present disclosure is not limited thereto. For example, the electron injection layer EIL may be formed using a mixture of an electron transport material and an insulating organometallic salt. The organometallic salt may be a material having an energy band gap of about 4 eV or more. The organometallic salt may include, for example, metal acetates, metal benzoates, metal acetoacetates, metal acetylacetonates, and/or metal stearates. The thickness of the electron injection layer EIL may be about 1 Å to about 100 Å, or about 3 Å to about 90 Å. If the thickness of the electron injection layer EIL satisfies the above described range, satisfactory electron injection properties may be obtained without inducing substantial increase of a driving voltage.

The electron transport region ETR may include a hole blocking layer HBL as described above. The hole blocking layer HBL may include, for example, at least one of 2,9-dimethyl-4,7-diphenyl-1,10-phenanthroline (BCP) or 4,7-diphenyl-1,10-phenanthroline (Bphen). However, an embodiment of the present disclosure is not limited thereto.

The second electrode EL2 is provided on the electron transport region ETR. The second electrode EL2 may be a common electrode or a cathode. The second electrode EL2 may be a transmissive electrode, a transflective electrode or a reflective electrode. If the second electrode EL2 is the transmissive electrode, the second electrode EL2 may include a transparent metal oxide, for example, ITO, IZO, ZnO, ITZO, etc. The thickness of the second electrode EL2 may be about 1,000 Å to about 10,000 Å, for example, about 1,000 Å to about 3,000 Å.

If the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/AI, Mo, Ti, a compound thereof, or a mixture thereof (for example, a mixture of Ag and Mg). The second electrode EL2 may have a multilayered structure including a reflective layer or a transflective layer formed using the above-described materials and a transparent conductive layer formed using ITO, IZO, ZnO, ITZO, etc.

The second electrode EL2 may be connected with an auxiliary electrode. If the second electrode EL2 is connected with the auxiliary electrode, the resistance of the second electrode EL2 may decrease.

Referring to FIG. 4, the organic electroluminescence device 10 of an embodiment may further include a buffer layer BFL between the emission layer EML and the electron transport region ETR. The buffer layer BFL may control the concentration of excitons produced in the emission layer EML. For example, the buffer layer BFL may include a portion of the materials of the emission layer EML. The buffer layer BFL may include the host material among the materials of the emission layer EML. The lowest triplet excitation energy level of the material of the buffer layer BFL may be controlled or selected to be equal to or greater than the lowest triplet excitation energy level of the second dopant, and equal to or less than the lowest triplet excitation energy level of the second dopant according to the combination of the host and dopant materials included in the emission layer EML.

On the second electrode EL2 of the organic electroluminescence device 10 of an embodiment, a capping layer CPL may be further disposed. The capping layer CPL may include, for example, α-NPD, NPB, TPD, m-MTDATA, Alq₃, CuPc, N4,N4,N4',N4'-tetra(biphenyl-4-yl) biphenyl-4,4'-diamine (TPD15), 4,4',4"-tris(carbazol-9-yl) triphenylamine (TCTA), etc.

The compound of an embodiment not forming part of the claimed invention, may be included in a functional layer other than the emission layer EML as a material for an organic electroluminescence device 10. The organic electroluminescence device 10 according to an embodiment not forming part of the claimed invention, may include the compound in at least one functional layer disposed between the first electrode EL1 and the second electrode EL2, or in a capping layer CPL disposed on the second electrode EL2.

The organic electroluminescence device 10 according to the claimed invention includes (e.g., optimizes) the combination of the host material and the dopant material of the emission layer EML as described in claim 1, and may show excellent emission efficiency and/or long-lifespan characteristics. In addition, the organic electroluminescence device 10 of an embodiment may show high efficiency and long-lifespan characteristics in a blue wavelength region.

Hereinafter, the compound according to an embodiment and the organic electroluminescence device of an embodiment of the present disclosure will be explained in more detail referring to embodiments and comparative embodiments. The following embodiments are only illustrations to assist the understanding of the present disclosure, and the scope of the present disclosure is not limited thereto.

### [Examples]

### (Manufacture of organic electroluminescence device)

The organic electroluminescence devices of the Examples and Comparative Examples were manufactured as follows. An ITO glass substrate was cut into a size of 50 mm x 50 mm x 0.5 mm, washed by ultrasonic waves using isopropyl alcohol and distilled water for 10 minutes each, exposed to ultraviolet rays and ozone for about 10 minutes for washing, and installed in a vacuum deposition apparatus. Then, a hole injection layer HIL was formed at a thickness of about 100 Å using 2-MTDATA, and a hole transport layer HTL was formed at a thickness of about 700 Å using NPB. Then, the first host, the second host, the first dopant, and the second dopant according to embodiments were co-deposited to form an emission layer EML into a thickness of about 300 Å, and an electron transport layer ETL was formed using a compound ETL1 (shown below) at a thickness of about 300 Å. Then, a second electrode was formed using Al at a thickness of about 1,200 Å. All layers were formed by a vacuum deposition method. When emissive layer is deposited, the concentration of the first dopant is 15% and the concentration of the second dopant is 1%.

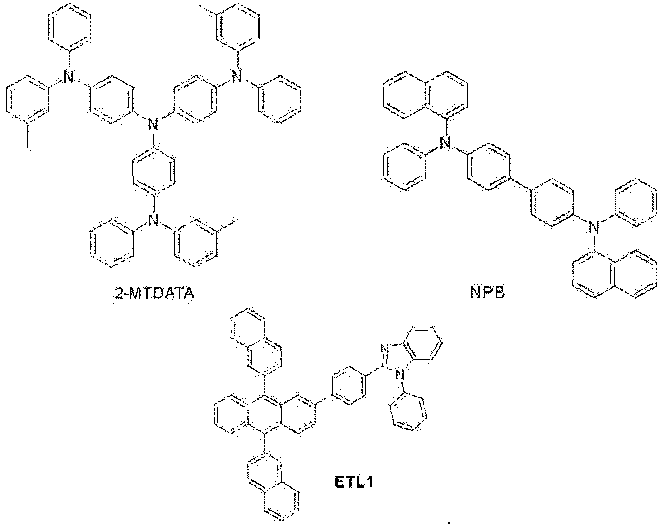

The combinations of the materials for an emission layer used in the Examples and the Comparative Examples are shown in Table 1.

**[Table 1]**

| Device manufacturing example | First host | Second host | Ratio of the first host and the second host | First dopant | Second dopant |
|---|---|---|---|---|---|
| Example 1 | HT-01 | ET1-2 | 5:5 | AD1-2 | D-02 |
| Example 2 | HT-01 | ET1-6 | 7:3 | AD1-15 | DA-03 |
| Example 3 | HT-03 | ET1-8 | 4:6 | AD2-21 | DA-05 |
| Example 4 | HT-04 | ET1-11 | 7:3 | AD1-20 | DA-07 |
| Example 5 | HT-08 | ET1-14 | 4:6 | AD2-27 | DA-17 |
| Example 6 | HT-10 | ET1-15 | 7:3 | AD1-31 | D-05 |
| Example 7 | HT-11 | ET2-1 | 4:6 | AD2-17 | D-11 |
| Example 8 | HT-13 | ET2-3 | 5:5 | AD2-23 | D-19 |
| Example 9 | HT-15 | ET2-7 | 4:6 | AD2-32 | DA-27 |
| Example 10 | HT-17 | ET2-11 | 7:3 | AD1-33 | D-20 |
| Comparative Example 1 | HT-02 | - | - | AD1-2 | DA-04 |
| Comparative Example 2 | HT-05 | ET1-4 | 4:6 | - | DA-11 |
| Comparative Example 3 | HT-08 | ET1-10 | 4:6 | AD2-22 | D-19 |
| Comparative Example 4 | HT-10 | - | - | AD1-23 | - |
| Comparative Example 5 | - | ET2-4 | - | AD2-21 | DA-21 |
| Comparative Example 6 | HT-11 | ET2-5 | 5:5 | - | DA-23 |
| Comparative Example 7 | - | ET2-6 | - | AD2-30 | DA-29 |
| Comparative Example 8 | HT-13 | ET2-7 | 4:6 | AD2-33 | - |
| Comparative Example 9 | HT-13 | - | - | - | D-14 |
| Comparative Example 10 | HT-01 | ET1-6 | 5:5 | AD1-32 | D-14 |
| Comparative Example 11 | HT-13 | ET2-3 | 5:5 | AD2-33 | DA-07 |
| Comparative Example 12 | HT-05 | ET1-4 | 5:5 | AD2-21 | D-15 |
| Comparative Example 13 | HT-06 | ET1-3 | 5:5 | AD2-27 | DA-29 |
| Comparative Example 14 | HT-08 | ET1-10 | 5:5 | AD1-33 | DA-04 |
| Comparative Example 15 | HT-06 | ET1-3 | 5:5 | AD1-31 | DA-11 |
| Comparative Example 16 | HT-07 | ET2-2 | 5:5 | AD1-23 | DA-23 |

In each device of the Examples and the Comparative Examples, the lowest triplet excitation energy (T1) of a host, the lowest triplet excitation energy (T1) of a first dopant, the lowest triplet excitation energy (T1) of a second dopant, the luminescent onset wavelength of a host, the luminescent onset wavelengths of a first dopant, the luminescent onset wavelengths of a second dopant, normalized light intensity of the cross point (wavelength cross point) of the normalized light absorption spectrum and normalized light emission spectrum of a second dopant, and distance between light absorption/emission peaks, are shown in Table 2. When there are two or more hosts, the two types of hosts form exciplex, and in Table 2, T1 and onset wavelengths of the exciplex are measured and described.

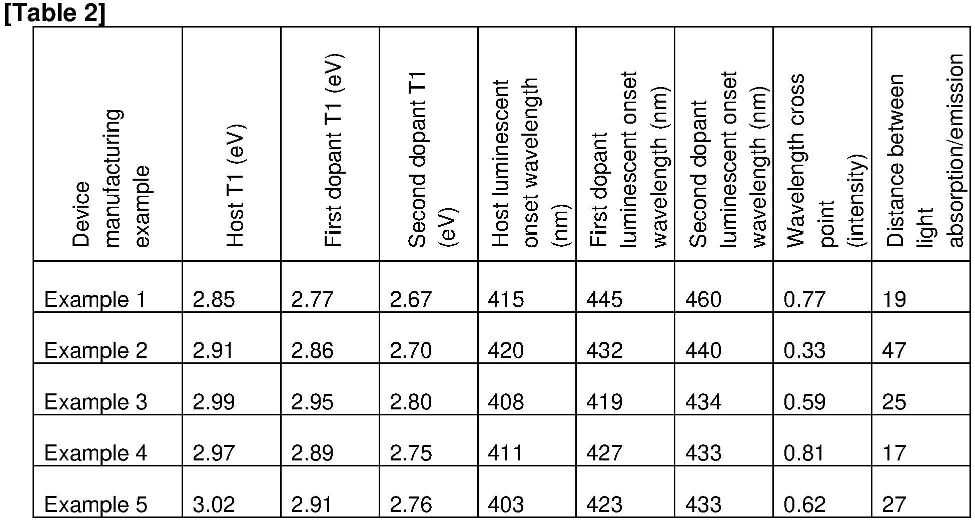

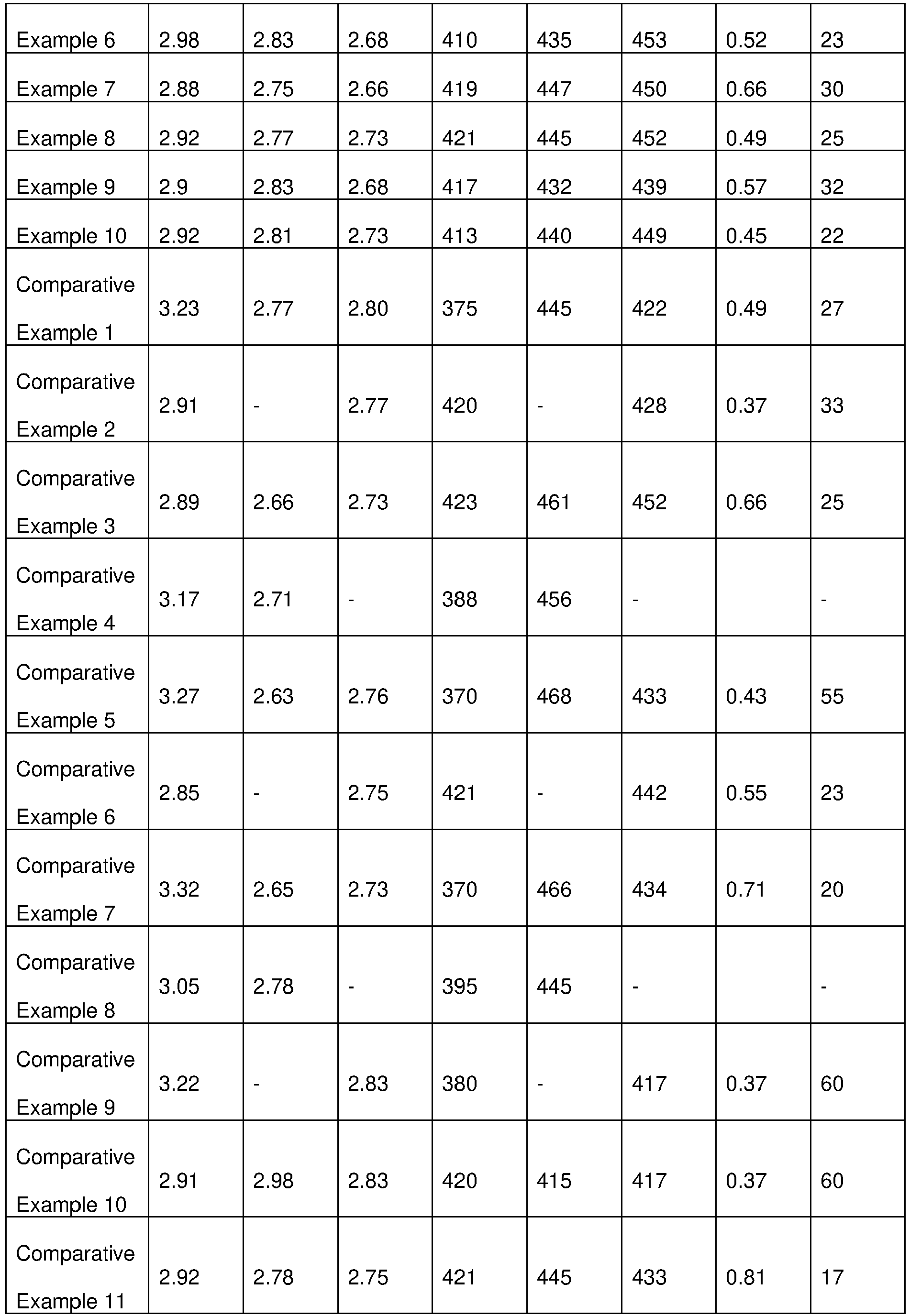

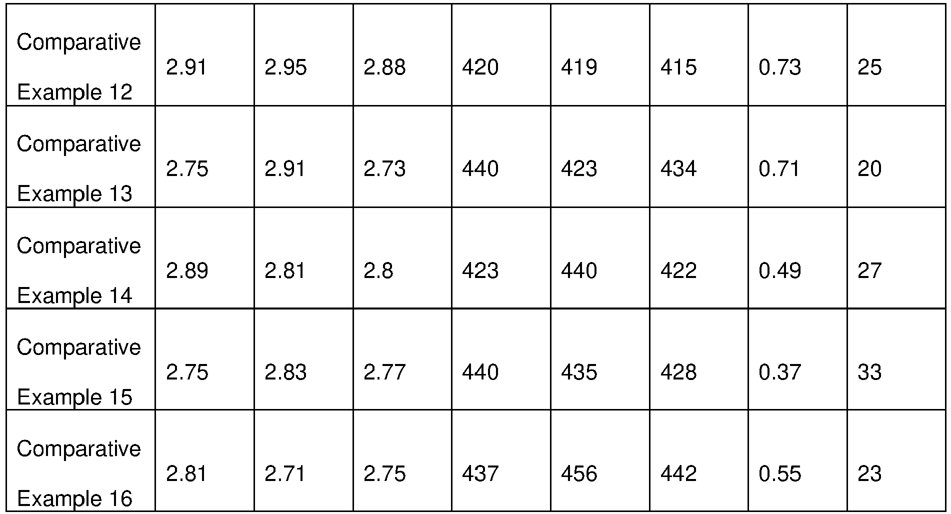

### (Evaluation of properties of organic electroluminescence device)

The evaluation of the properties of the organic electroluminescence devices was conducted using a brightness light distribution characteristics measurement system. In order to evaluate the properties of the organic electroluminescence devices according to the Examples and the Comparative examples, efficiency, and lifespan (T₉₅) were measured. Emission efficiencies (cd/A) for the organic electroluminescence devices thus manufactured were measured at a current density of about 10 mA/cm² and a luminance of about 1,000 cd/m². The device lifespan (T₉₅) is the time period after which the luminance decreases to 95% from a standard (e.g., initial luminance) of about 1,000 cd/m². The device life (T₉₅) was measured by continuously (e.g., substantially continuously) driving at a current density of about 10 mA/cm², and the results are shown in terms of hours.

**[Table 3]**

| Device manufacturing example | Emission efficiency (cd/A) | Device life (T₉₅, h) |
|---|---|---|
| Example 1 | 23.6 | 31.1 |
| Example 2 | 24.2 | 29.5 |
| Example 3 | 24.1 | 38.6 |
| Example 4 | 25.3 | 26.8 |
| Example 5 | 25.1 | 26.1 |
| Example 6 | 21.8 | 33.9 |
| Example 7 | 22.8 | 35.5 |
| Example 8 | 23.5 | 42.0 |
| Example 9 | 24.4 | 37.1 |
| Example 10 | 25.5 | 33.3 |
| Comparative Example 1 | 17.8 | 0.5 |
| Comparative Example 2 | 26.6 | 1.5 |
| Comparative Example 3 | 19.1 | 21.2 |
| Comparative Example 4 | 11.9 | 1.7 |
| Comparative Example 5 | 16.3 | 7.6 |
| Comparative Example 6 | 25.7 | 2.4 |
| Comparative Example 7 | 11.5 | 10.8 |
| Comparative Example 8 | 17.0 | 17.4 |
| Comparative Example 9 | 2.7 | 1.8 |
| Comparative Example 10 | 3.5 | 0.8 |
| Comparative Example 11 | 15.8 | 17.2 |
| Comparative Example 12 | 6.2 | 1.3 |
| Comparative Example 13 | 1.1 | 0.2 |
| Comparative Example 14 | 10.7 | 28.9 |
| Comparative Example 15 | 4.1 | 1.2 |
| Comparative Example 16 | 13.2 | 15.3 |

Referring to the results of Table 3, it could be confirmed that the device emission efficiency and/or device life was improved for each of the Examples when compared with the Comparative Examples, because the emission layer according to an embodiment includes all the first host, the second host, the first dopant and the second dopant, and the luminescent onset wavelength of the second dopant has a greater value than the luminescent onset wavelength of the first dopant.

In Comparative Examples 1, 2, and 4 to 9, one of the first host, the second host, the first dopant and the second dopant was not included, and at least one among efficiency and life was therefore decreased when compared with the devices of the Examples. In addition, it could be confirmed that although Comparative Examples 3 and 10 to 16 each included all of the first host, the second host, the first dopant, and the second dopant, the second dopant had a smaller luminescent onset wavelength value than only one of the first dopant and the host. Therefore Comparative Examples 3 and 10 to 16 showed decreased emission efficiency and device life when compared with the light-emitting devices of the Examples.

In the organic electroluminescence device of an embodiment, the second dopant (which is a light-emitting body) has the greatest luminescent onset wavelength, the first dopant (which performs the function of an assistant dopant) has a smaller luminescent onset wavelength than the second dopant, and the host has the smallest luminescent onset wavelength. Accordingly, energy transfer between the materials in the emission layer may be improved, and high emission efficiency and/or long-lifespan characteristics may be achieved. Further, the organic electroluminescence device of the claimed invention has a normalized light intensity of about 0.5 or more at the wavelength cross point of the normalized light absorption spectrum and normalized light emission spectrum of the second dopant (which is a light-emitting body), and energy transfer from the host and the first dopant to the second dopant may be improved, and high emission efficiency and/or long-lifespan characteristics may be shown.

The organic electroluminescence device according to the claimed invention shows improved device properties of long lifespan and/or high efficiency.

Although the example embodiments of the present disclosure have been described, it is understood that the present disclosure should not be limited to these example embodiments, but various changes and modifications can be made by one ordinary skilled in the art within the scope of the present disclosure as described in the following claims.

## Claims

1. An organic electroluminescence device (10), comprising:
a first electrode (EL1);
a second electrode (EL2) opposite the first electrode (EL1); and
an emission layer (EML) between the first electrode (EL1) and the second electrode (EL2),
wherein the emission layer (EML) comprises:
a host having a first luminescent onset wavelength, wherein the first luminescent onset wavelength is an x-intercept value of a tangent line that is drawn at a position where light intensity is about 0.5 in a normalized light emission spectrum of the host;
a first dopant having a second luminescent onset wavelength, wherein the second luminescent onset wavelength is an x-intercept value of a tangent line that is drawn at a position where light intensity is about 0.5 in a normalized light emission spectrum of the first dopant; and
a second dopant different from the first dopant and having a third luminescent onset wavelength, wherein the third luminescent onset wavelength is an x-intercept value of a tangent line that is drawn at a position where light intensity is about 0.5 in a normalized light emission spectrum of the second dopant, and
the third luminescent onset wavelength is greater than the first luminescent onset wavelength and the second luminescent onset wavelength,
wherein the normalized light emission spectra are obtained by dissolving the host, the first dopant or the second dopant in an organic solvent and dividing it by a maximum value of a first peak after measuring the emission spectrum,
wherein a normalized light intensity at a cross point of a normalized light absorption spectrum and a normalized light emission spectrum of the second dopant is about 0.5 or more, and
a distance between a peak of the normalized light absorption spectrum and a peak of the normalized light emission spectrum of the second dopant is about 50 nm or less,
wherein the host comprises a first host and a second host, the second host being different from the first host, and
wherein the first host is represented by Formula H-1: 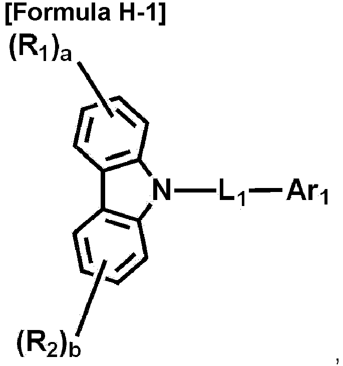
wherein in Formula H-1,
L₁ is a direct linkage, a substituted or unsubstituted arylene group of 6 to 30 carbon atoms to form a ring, or a substituted or unsubstituted heteroarylene group of 2 to 30 carbon atoms to form a ring,
Ar₁ is a substituted or unsubstituted aryl group of 6 to 30 carbon atoms to form a ring, or a substituted or unsubstituted heteroaryl group of 2 to 30 carbon atoms to form a ring,
"a" and "b" are each independently an integer of 0 to 4, and
R₁ and R₂ are each independently a substituted or unsubstituted aryl group of 6 to 30 carbon atoms to form a ring, or a substituted or unsubstituted heteroaryl group of 2 to 30 carbon atoms to form a ring, and
wherein the second host is represented by Formula H-2: 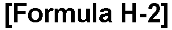 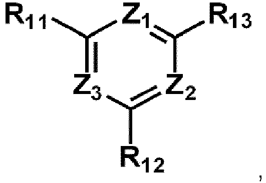
wherein in Formula H-2,
Z₁ to Z₃ are each independently CR_{y} or N, and
R_{y} and R₁₁ to R₁₃ are each independently a hydrogen atom, a deuterium atom, a cyano group, a substituted or unsubstituted silyl group, a substituted or unsubstituted aryl group of 6 to 30 carbon atoms to form a ring, or a substituted or unsubstituted heteroaryl group of 2 to 30 carbon atoms to form a ring.

2. An organic electroluminescence device (10) according to claim 1, wherein the second dopant has a smaller lowest triplet excitation energy level than each of the host and the first dopant.

3. An organic electroluminescence device (10) according to claim 1 or claim 2, wherein the first dopant comprises an organometallic complex comprising Ir, Ru, Rh, Pt, Pd, Cu, or Os as a central metal element, optionally wherein the first dopant is represented by Formula D-1: 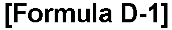 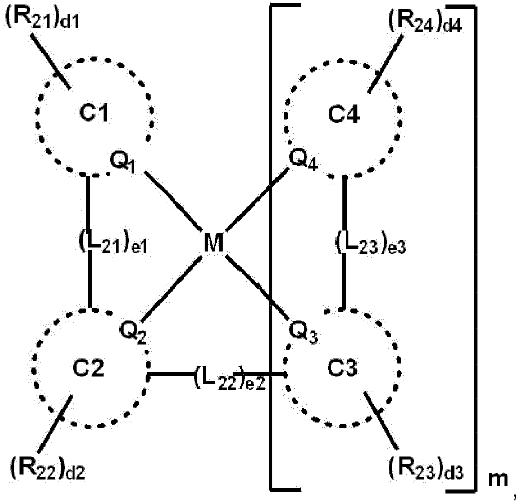 wherein in Formula D-1,
M is Pt, Pd, Cu, Os, Ir, Ru, or Rh,
Q₁ to Q₄ are each independently C or N,
C1 to C4 are each independently a substituted or unsubstituted hydrocarbon ring of 5 to 30 carbon atoms to form a ring, or a substituted or unsubstituted heterocycle of 2 to 30 carbon atoms to form a ring,
L₂₁ to L₂₃ are each independently a direct linkage, *-o-*, *-s-*, 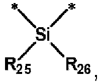 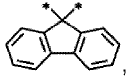 a substituted or unsubstituted divalent alkyl group of 1 to 20 carbon atoms, a substituted or unsubstituted arylene group of 6 to 30 carbon atoms to form a ring, or a substituted or unsubstituted heteroarylene group of 2 to 30 carbon atoms to form a ring,
e1 to e3 are each independently 0 or 1,
R₂₁ to R₂₆ are each independently a hydrogen atom, a deuterium atom, a halogen atom, a cyano group, a substituted or unsubstituted amine group, a substituted or unsubstituted alkyl group of 1 to 20 carbon atoms, a substituted or unsubstituted aryl group of 6 to 30 carbon atoms to form a ring, or a substituted or unsubstituted heteroaryl group of 2 to 30 carbon atoms to form a ring, or are combined with an adjacent group to form a ring,
d1 to d4 are each independently an integer of 0 to 4,
when M is Pt, Pd, Cu, or Os, "m" is 1, and
when M is Ir, Ru, or Rh, "m" is 2, and e2 is 0.

4. An organic electroluminescence device (10) according to any one of claims 1 to 3, wherein the second dopant is represented by Formula D-2a: 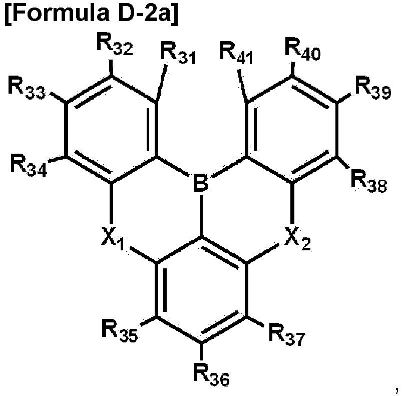 in Formulae D-2a, X₁ and X₂ are each independently NRₘ or O,
Rₘ is a hydrogen atom, a deuterium atom, a substituted or unsubstituted alkyl group of 1 to 20 carbon atoms, a substituted or unsubstituted aryl group of 6 to 30 carbon atoms to form a ring, or a substituted or unsubstituted heteroaryl group of 2 to 30 carbon atoms to form a ring, and
R₃₁ to R₄₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted alkyl group of 1 to 20 carbon atoms, a substituted or unsubstituted aryl group of 6 to 30 carbon atoms to form a ring, or a substituted or unsubstituted heteroaryl group of 2 to 30 carbon atoms to form a ring, or are combined with an adjacent group to form a ring.

5. An organic electroluminescence device (10) according to any one of claims 1 to 4, wherein the second dopant is represented by Formula D-2b:
**[Formula D-2b]** **D₁-L₂-A₁**
wherein in Formula D-2b,
L₂ is a direct linkage, a substituted or unsubstituted arylene group of 6 to 30 carbon atoms to form a ring, or a substituted or unsubstituted heteroarylene group of 2 to 30 carbon atoms to form a ring, and
D₁ is represented by Formula D-2-1 or Formula D-2-2: 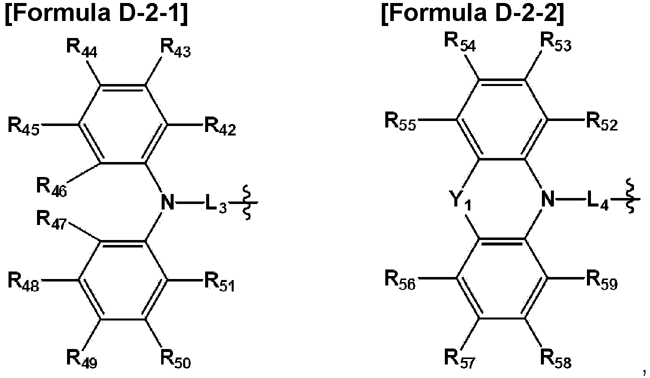
wherein in Formulae D-2-1 and D-2-2,
L₃ and L₄ are each independently a direct linkage, or a substituted or unsubstituted arylene group of 6 to 30 carbon atoms to form a ring,
R₄₂ to R₅₉ are each independently a hydrogen atom, a deuterium atom, a halogen atom, a substituted or unsubstituted amine group, a substituted or unsubstituted silyl group, a substituted or unsubstituted alkyl group of 1 to 15 carbon atoms, a substituted or unsubstituted aryl group of 6 to 30 carbon atoms to form a ring, or a substituted or unsubstituted heteroaryl group of 2 to 30 carbon atoms to form a ring, or are each combined with an adjacent group to form a ring,
Y₁ is a direct linkage, CRₐR_{b}, SiR_{c}R_{d}, GeRₑR_{f}, NR_{g}, O or S,
Rₐ to R_{g} are each independently a substituted or unsubstituted alkyl group of 1 to 15 carbon atoms, a substituted or unsubstituted aryl group of 6 to 30 carbon atoms to form a ring, or a substituted or unsubstituted heteroaryl group of 2 to 30 carbon atoms to form a ring,
Rₐ and R_{b}, R_{c} and R_{d}, and Rₑ and/or Rf are optionally combined with each other to form a ring, and
A₁ is represented by one of Formulae D-2-3 to D-2-10: 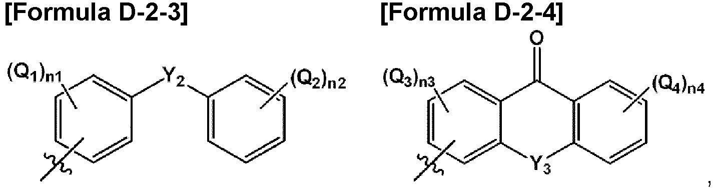 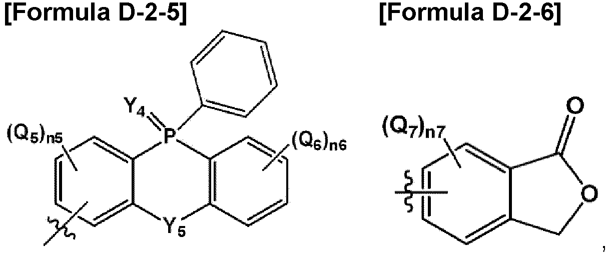 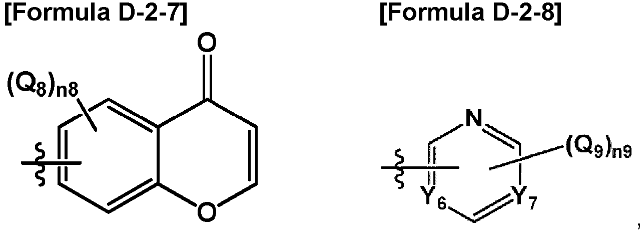 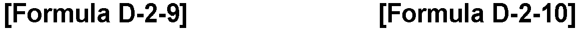 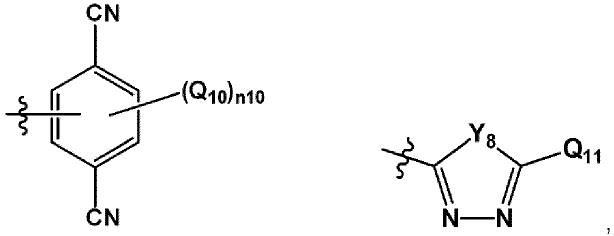
Y₂ is C=O, or S(=O)₂,
Y₃ is C=O, or O,
Y₄ and Y₅ are each independently O, or S,
Y₆ and Y₇ are each independently N, or CQ₁₂,
Y₈ is O or NQ₁₃,
Q₁ to Q₁₃ are each independently a substituted or unsubstituted alkyl group of 1 to 15 carbon atoms, a substituted or unsubstituted aryl group of 6 to 30 carbon atoms to form a ring, or a substituted or unsubstituted heteroaryl group of 2 to 30 carbon atoms to form a ring,
n1, n4, and n6 are each independently 0 to 4,
n3, n5, n7, n8, and n10 are each independently an integer of 0 to 3,
n2 is an integer of 0 to 5, and
n9 is an integer of 0 to 2.

6. An organic electroluminescence device (10) according to any one of claims 1 to 5, wherein:
(i) a weight ratio of the first host and the second host is about 7:3 to about 3:7; and/or
(ii) the first dopant is in an amount of about 10 wt% to about 15 wt%, and
the second dopant is in an amount of about 1 wt% to about 5 wt% based on a total weight of the first host, the second host, the first dopant, and the second dopant.

7. An organic electroluminescence device (10) according to any one of claims 1 to 6, wherein the first host comprises at least one selected from compounds represented in Compound Group 1:

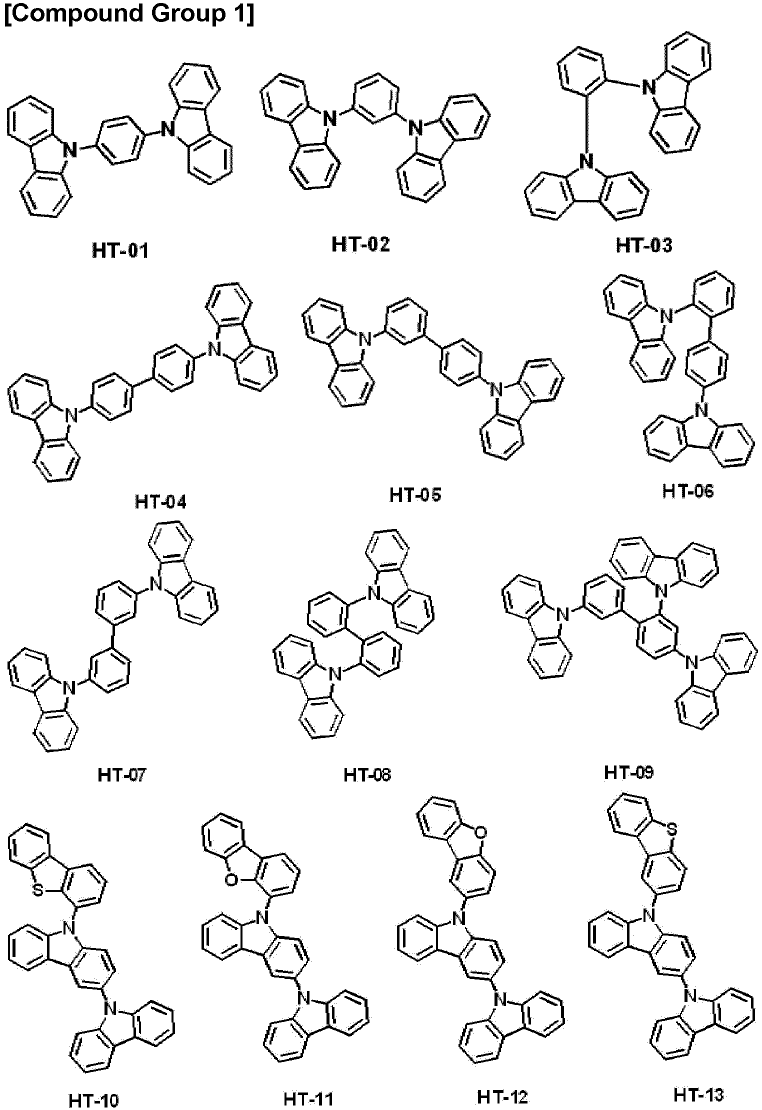

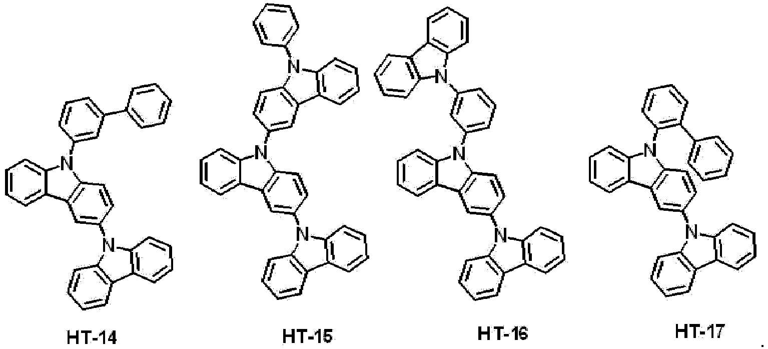

8. An organic electroluminescence device (10) according to any one of claims 1 to 7, wherein the second host comprises at least one selected from compounds represented in Compound Group 2-1 and Compound Group 2-2:

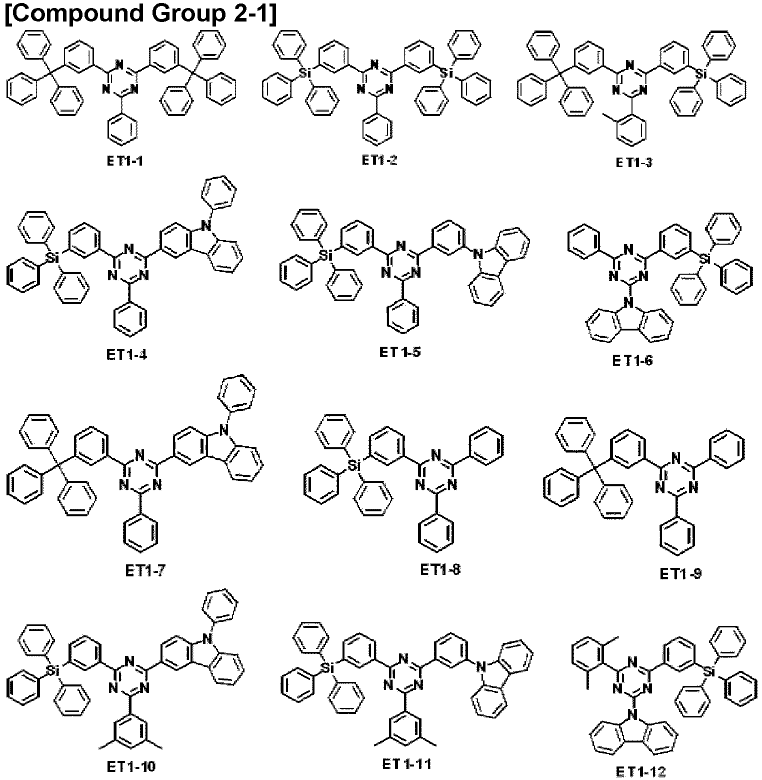

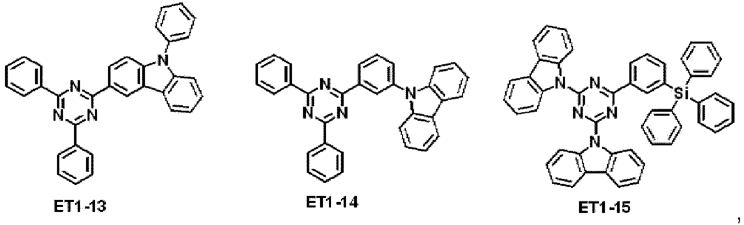

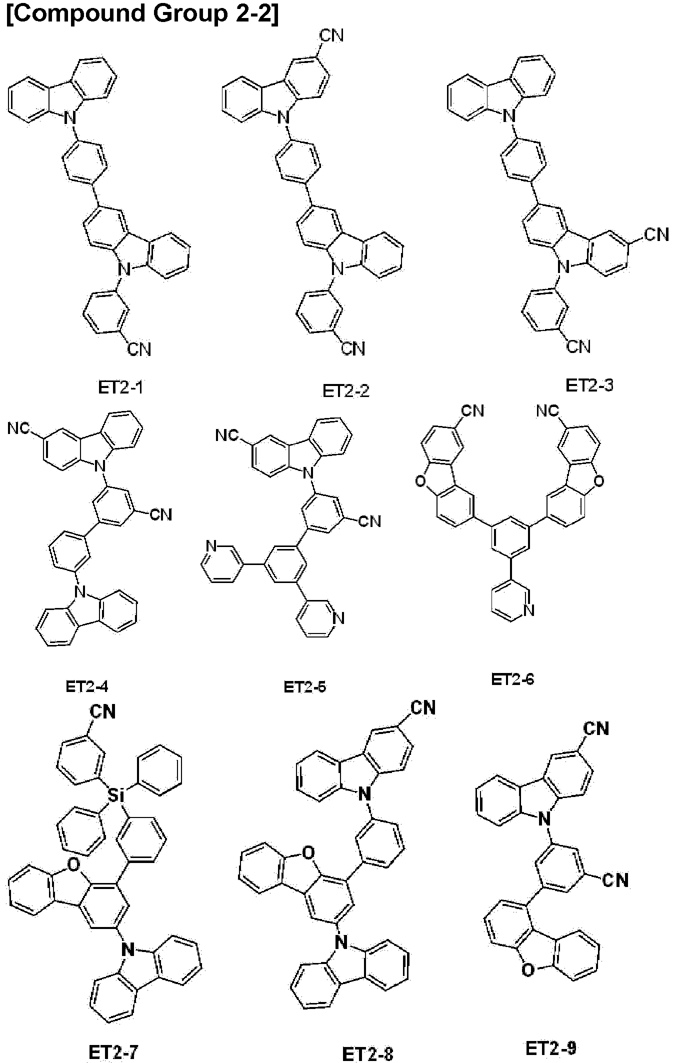

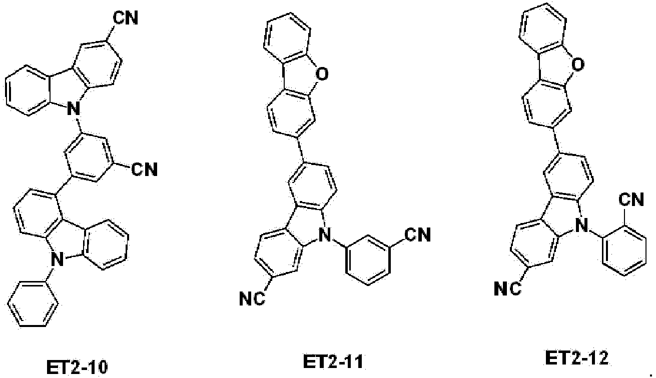

9. An organic electroluminescence device (10) according to any one of claims 1 to 8, wherein the first dopant comprises at least one selected from compounds represented in Compound Group 3-1 and Compound Group 3-2: 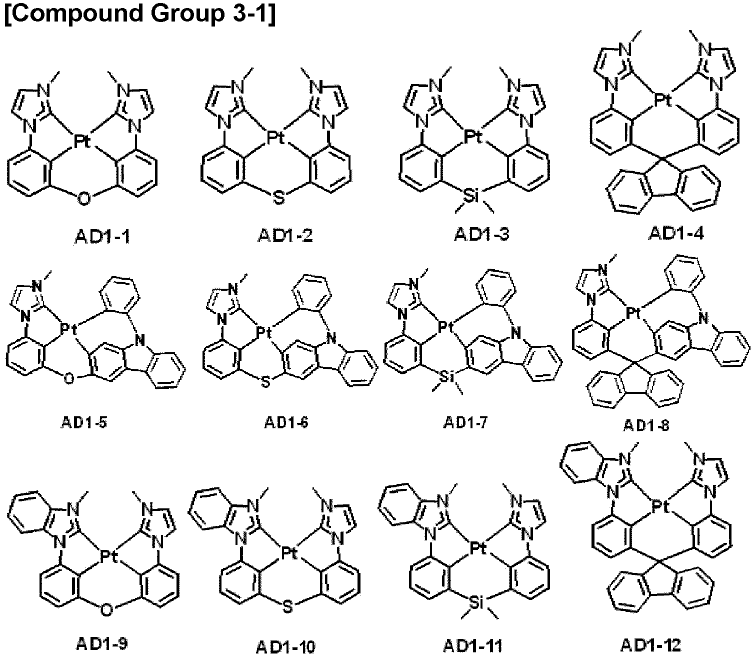 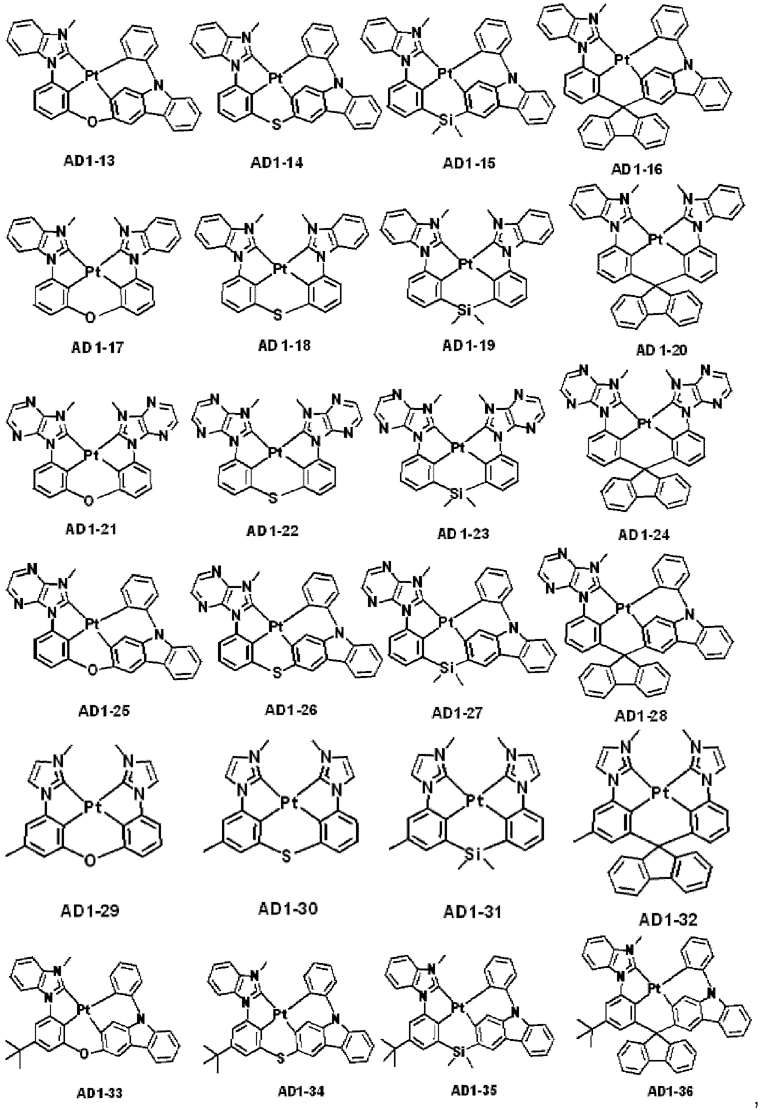 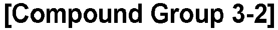 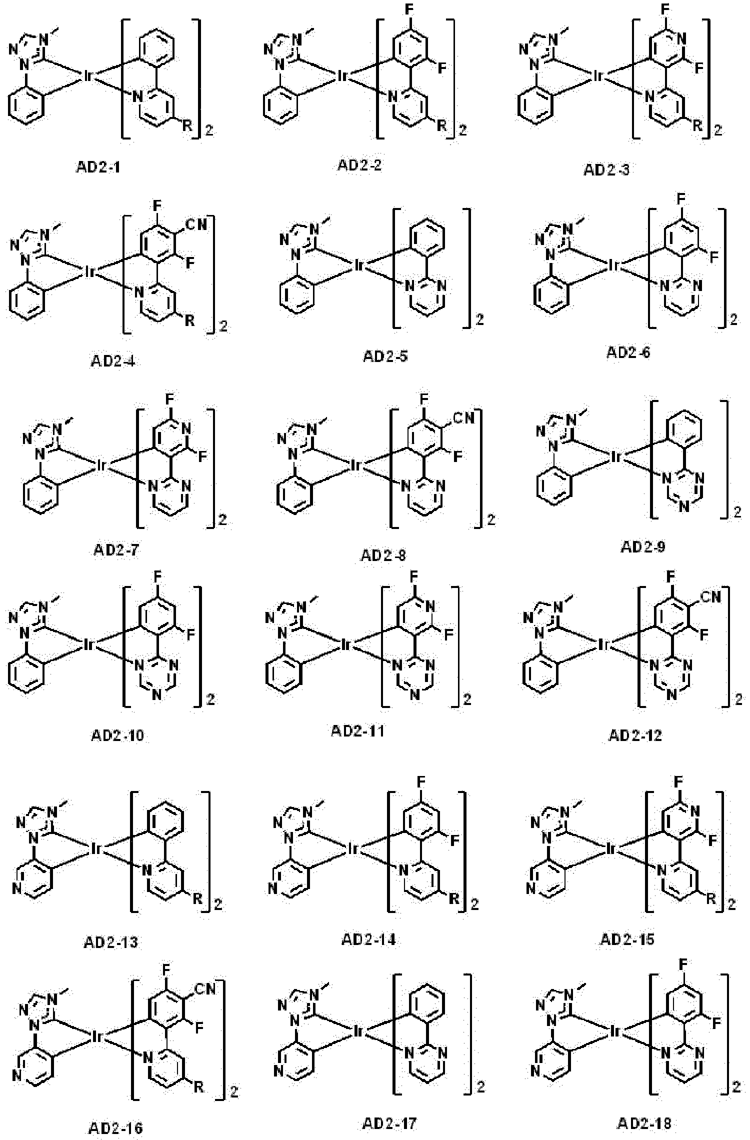 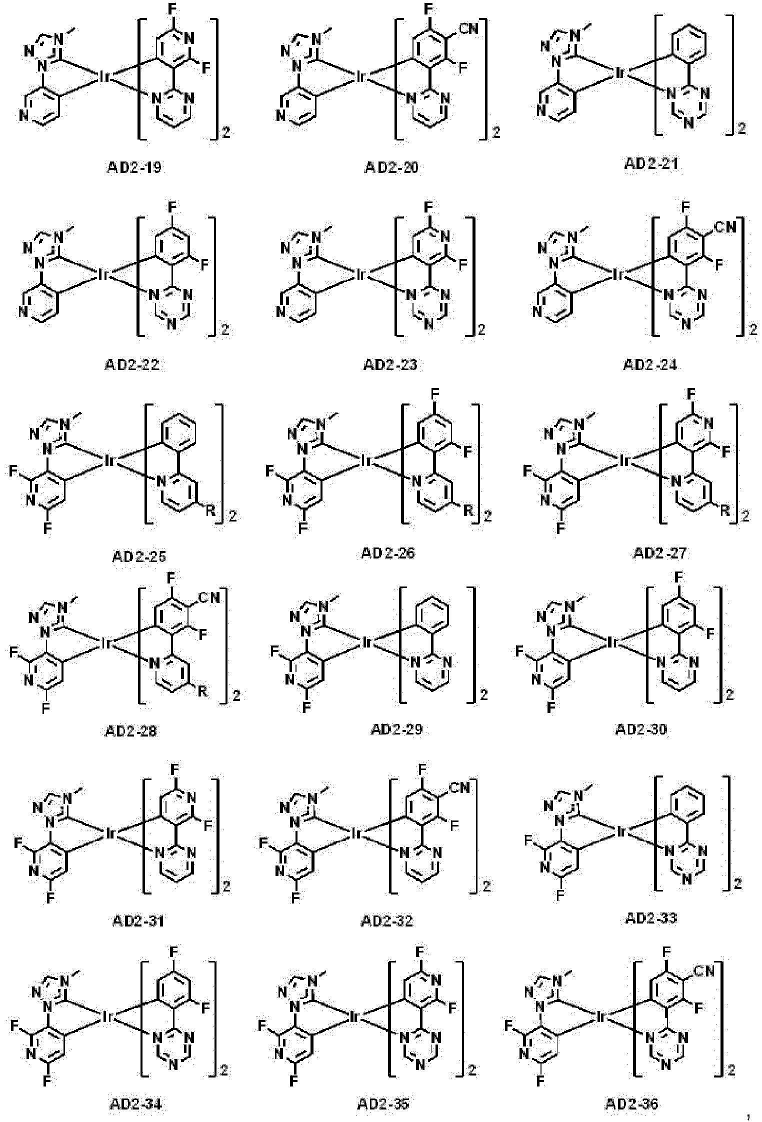 wherein in AD2-1 to AD2-4, AD2-13 to AD2-16, and AD2-25 to AD2-28, each R is independently a hydrogen atom, a methyl group, an isopropyl group, a tert-butyl group, or a dimethyl amine group.

10. An organic electroluminescence device (10) according to any one of claims 1 to 9, wherein the second dopant comprises at least one selected from compounds represented in Compound Group 4-1 and Compound Group 4-2:

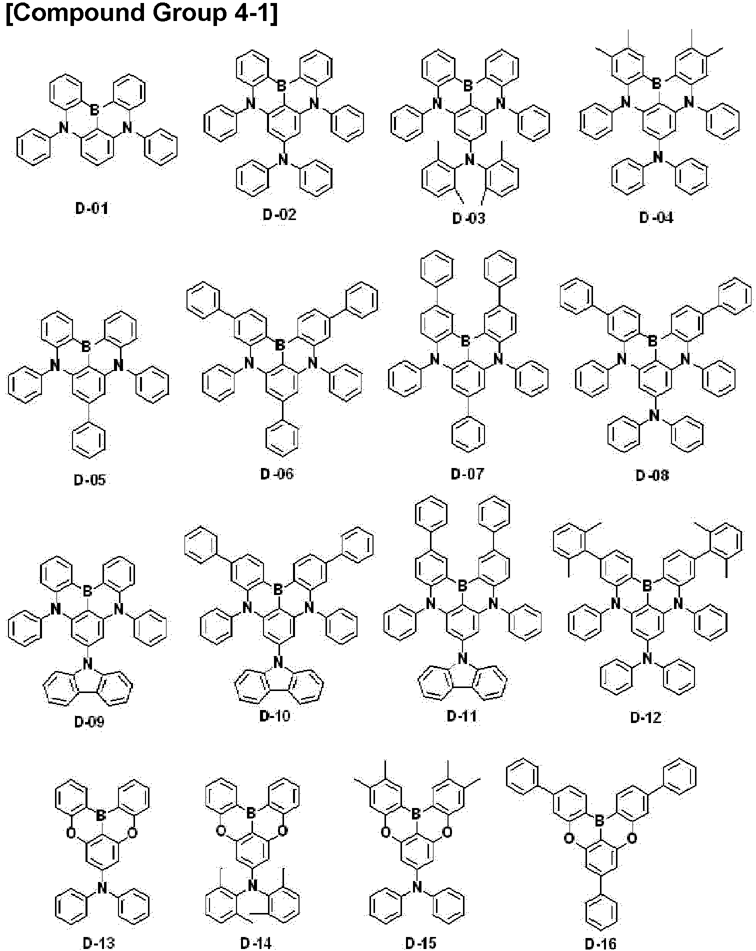

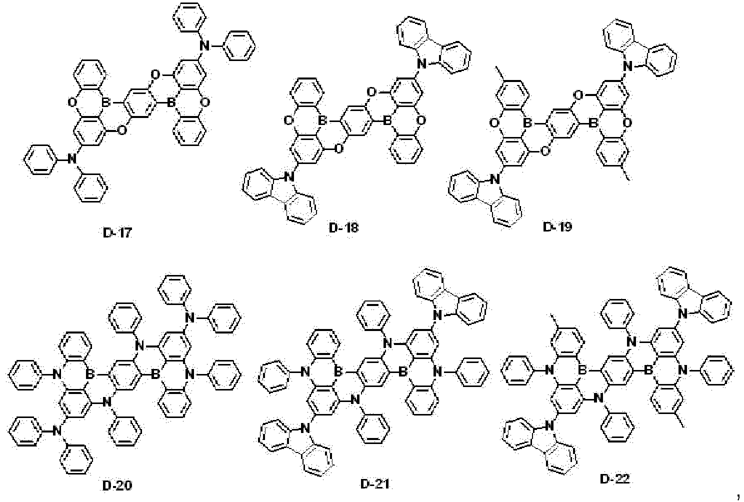

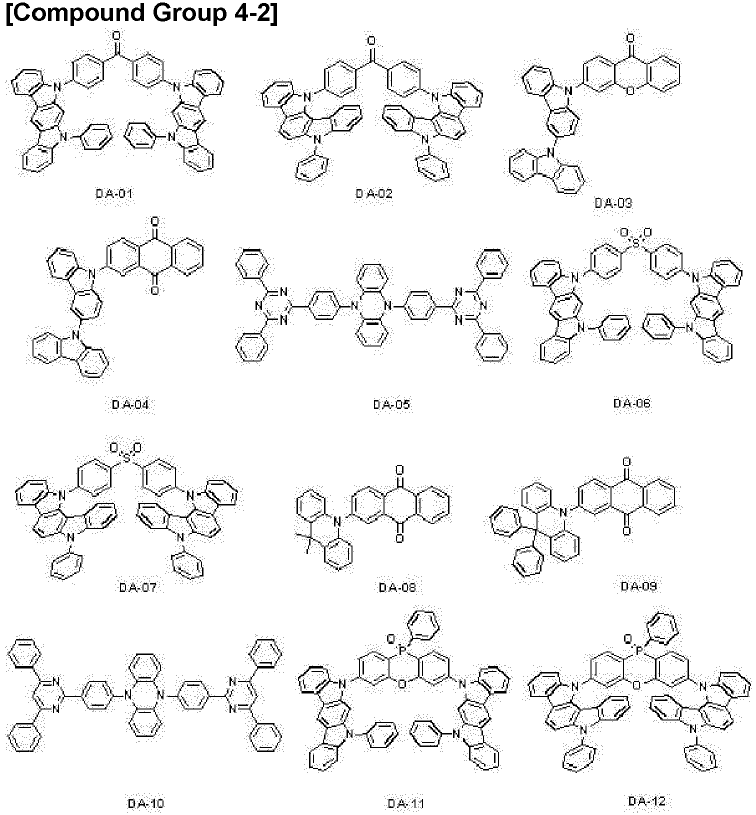

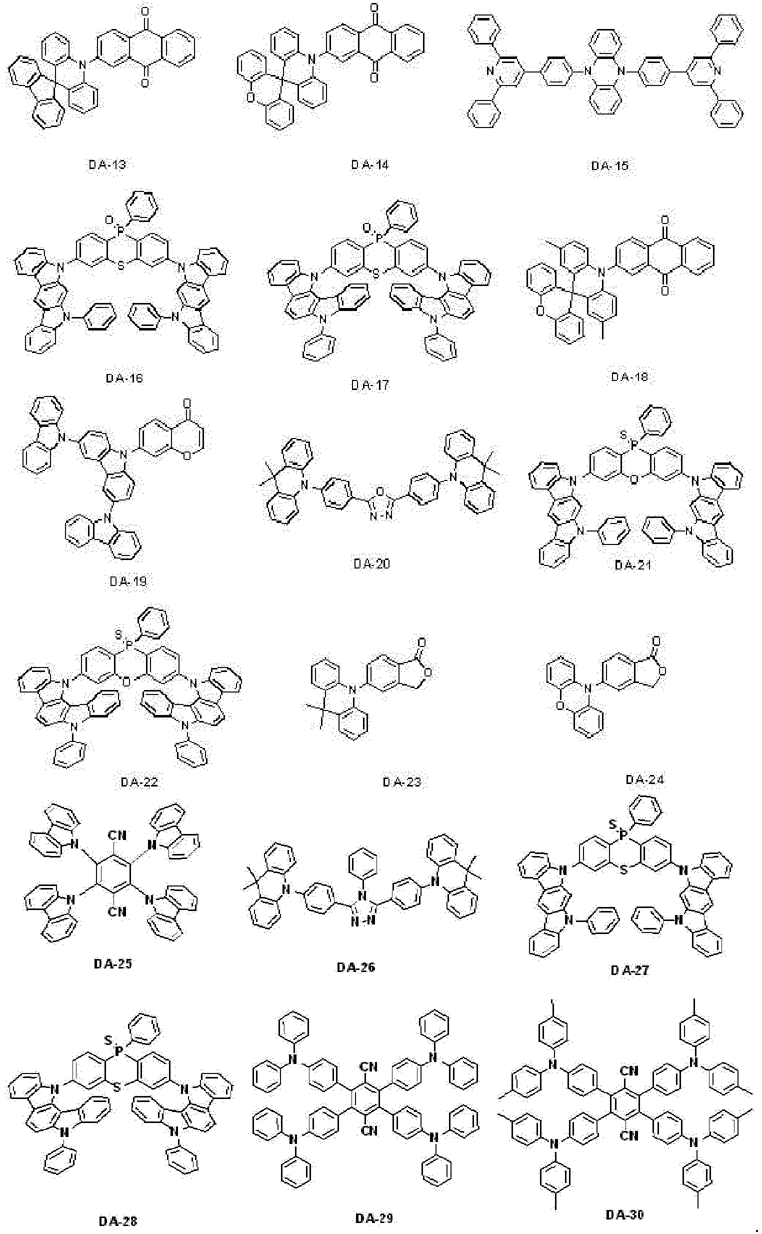

## Patentansprüche

1. Organische Elektrolumineszenzvorrichtung (10), Folgendes umfassend:
eine erste Elektrode (EL1);
eine zweite Elektrode (EL2) gegenüber der ersten Elektrode (EL1); und
eine Emissionsschicht (EML) zwischen der ersten Elektrode (EL1) und der zweiten Elektrode (EL2),
wobei die Emissionsschicht (EML) Folgendes umfasst:
einen Wirt mit einer ersten Lumineszenz-Anfangswellenlänge, wobei die erste Lumineszenz-Anfangswellenlänge ein x-Achsenschnittpunkt einer Tangente ist, die an einer Position gezogen wird, an der eine Lichtintensität in einem normierten Lichtemissionsspektrum des Wirts etwa 0,5 beträgt;
einen ersten Dotierstoff mit einer zweiten Lumineszenz-Anfangswellenlänge, wobei die zweite Lumineszenz-Anfangswellenlänge ein x-Achsenschnittpunkt einer Tangente ist, die an einer Position gezogen wird, an der eine Lichtintensität in einem normierten Lichtemissionsspektrum des ersten Dotierstoffs etwa 0,5 beträgt; und
einen zweiten Dotierstoff, der sich vom ersten Dotierstoff unterscheidet und eine dritte Lumineszenz-Anfangswellenlänge aufweist, wobei die dritte Lumineszenz-Anfangswellenlänge ein x-Achsenschnittpunkt einer Tangente ist, die an einer Position gezogen wird, an der eine Lichtintensität in einem normierten Lichtemissionsspektrum des zweiten Dotierstoffs etwa 0,5 beträgt, und
die dritte Lumineszenz-Anfangswellenlänge größer ist als die erste Lumineszenz-Anfangswellenlänge und die zweite Lumineszenz-Anfangswellenlänge,
wobei die normierten Lichtemissionsspektren durch Auflösen des Wirts, des ersten Dotierstoffs oder des zweiten Dotierstoffs in einem organischen Lösungsmittel und durch Teilen durch einen Maximalwert eines ersten Peaks nach Messung des Emissionsspektrums erlangt werden,
wobei eine normierte Lichtintensität an einem Schnittpunkt eines normierten Lichtabsorptionsspektrums und eines normierten Lichtemissionsspektrums des zweiten Dotierstoffs etwa 0,5 oder mehr beträgt, und
ein Abstand zwischen einem Peak des normierten Lichtabsorptionsspektrums und einem Peak des normierten Lichtemissionsspektrums des zweiten Dotierstoffs etwa 50 nm oder weniger beträgt,
wobei der Wirt einen ersten Wirt und einen zweiten Wirt umfasst, wobei sich der zweite Wirt vom ersten Wirt unterscheidet, und
wobei der erste Wirt durch Formel H-1 dargestellt wird: 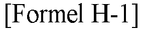 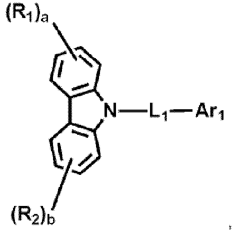
wobei in Formel H-1
L₁ eine direkte Bindung, eine substituierte oder unsubstituierte Arylengruppe mit 6 bis 30 Kohlenstoffatomen, um einen Ring auszubilden, oder eine substituierte oder unsubstituierte Heteroarylengruppe mit 2 bis 30 Kohlenstoffatomen, um einen Ring auszubilden, ist,
Ar₁ eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, ist,
"a" und "b" jeweils unabhängig voneinander eine ganze Zahl von 0 bis 4 sind, und
R₁ und R₂ jeweils unabhängig voneinander eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind, und
wobei der zweite Wirt durch Formel H-2 dargestellt wird: 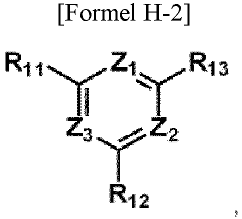
wobei in Formel H-2
Z₁ bis Z₃ jeweils unabhängig voneinander CR_{y} oder N sind, und
R_{y} und R₁₁ bis R₁₃ jeweils unabhängig voneinander ein Wasserstoffatom, ein Deuteriumatom, eine Cyanogruppe, eine substituierte oder unsubstituierte Silylgruppe, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind.

2. Organische Elektrolumineszenzvorrichtung (10) nach Anspruch 1, wobei der zweite Dotierstoff ein geringeres niedrigstes Triplett-Anregungsenergieniveau als jeder von dem Wirt und dem ersten Dotierstoff aufweist.

3. Organische Elektrolumineszenzvorrichtung (10) nach Anspruch 1 oder Anspruch 2, wobei der erste Dotierstoff einen organometallischen Komplex umfasst, der Ir, Ru, Rh, Pt, Pd, Cu oder Os als ein zentrales Metallelement umfasst, wobei der erste Dotierstoff optional durch Formel D-1 dargestellt wird: 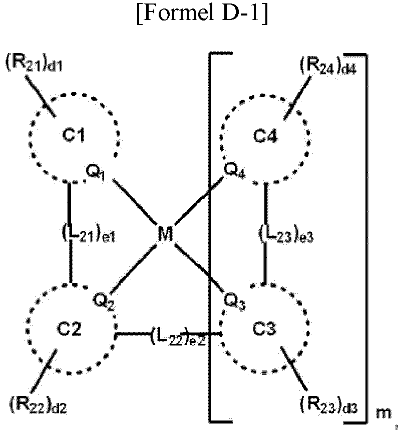 wobei in Formel D-1
M Pt, Pd, Cu, Os, Ir, Ru oder Rh ist,
Q₁ bis Q₄ jeweils unabhängig voneinander C oder N sind,
C1 bis C4 jeweils unabhängig voneinander ein substituierter oder unsubstituierter Kohlenwasserstoffring mit 5 bis 30 Kohlenstoffatomen, um einen Ring auszubilden, oder ein substituierter oder unsubstituierter Heterocyclus mit 2 bis 30 Kohlenstoffatomen, um einen Ring auszubilden, sind,
L₂₁ bis L₂₃ jeweils unabhängig voneinander eine direkte Bindung *-o-*, *-s-*, 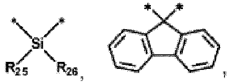 eine substituierte oder unsubstituierte zweiwertige Alkylgruppe mit 1 bis 20 Kohlenstoffatomen, eine substituierte oder unsubstituierte Arylengruppe mit 6 bis 30 Kohlenstoffatomen, um einen Ring auszubilden, oder eine substituierte oder unsubstituierte Heteroarylengruppe mit 2 bis 30 Kohlenstoffatomen, um einen Ring auszubilden, sind,
e1 bis e3 jeweils unabhängig voneinander 0 oder 1 sind,
R₂₁ bis R₂₆ jeweils unabhängig voneinander ein Wasserstoffatom, ein Deuteriumatom, ein Halogenatom, eine Cyanogruppe, eine substituierte oder unsubstituierte Aminogruppe, eine substituierte oder unsubstituierte Alkylgruppe mit 1 bis 20 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind, oder mit einer angrenzenden Gruppe kombiniert sind, um einen Ring auszubilden,
d1 bis d4 jeweils unabhängig voneinander eine ganze Zahl von 0 bis 4 sind,
wenn M Pt, Pd, Cu oder Os ist, "m" 1 ist, und
wenn M Ir, Ru oder Rh ist, "m" 2 ist, und e2 0 ist.

4. Organische Elektrolumineszenzvorrichtung (10) nach einem der Ansprüche 1 bis 3, wobei der zweite Dotierstoff durch Formel D-2a dargestellt wird: 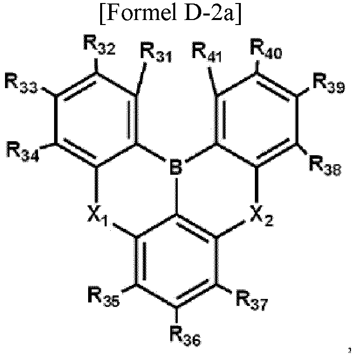 in Formel D-2a sind X₁ und X₂ jeweils unabhängig voneinander NRₘ oder O,
Rₘ ist ein Wasserstoffatom, ein Deuteriumatom, eine substituierte oder unsubstituierte Alkylgruppe mit 1 bis 20 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, und
R₃₁ bis R₄₁ sind jeweils unabhängig voneinander ein Wasserstoffatom, ein Deuteriumatom, ein Halogenatom, eine Cyanogruppe, eine substituierte oder unsubstituierte Aminogruppe, eine substituierte oder unsubstituierte Borylgruppe, eine substituierte oder unsubstituierte Oxygruppe, eine substituierte oder unsubstituierte Alkylgruppe mit 1 bis 20 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, oder sind mit einer angrenzenden Gruppe kombiniert, um einen Ring auszubilden.

5. Organische Elektrolumineszenzvorrichtung (10) nach einem der Ansprüche 1 bis 4, wobei der zweite Dotierstoff durch Formel D-2b dargestellt wird:
[Formel D-2b] **D₁-L₂-A₁,**
wobei in Formel D-2b
L₂ eine direkte Bindung, eine substituierte oder unsubstituierte Arylengruppe mit 6 bis 30 Kohlenstoffatomen, um einen Ring auszubilden, oder eine substituierte oder unsubstituierte Heteroarylengruppe mit 2 bis 30 Kohlenstoffatomen, um einen Ring auszubilden, ist, und
D₁ durch Formel D-2-1 oder Formel D-2-2 dargestellt wird: 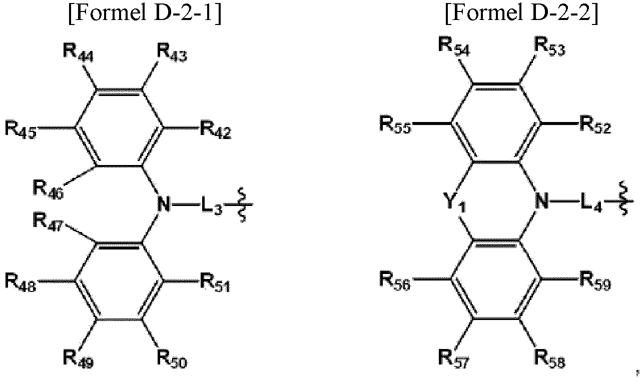
wobei in den Formeln D-2-1 und D-2-2
L₃ und L₄ jeweils unabhängig voneinander eine direkte Bindung oder eine substituierte oder unsubstituierte Arylengruppe mit 6 bis 30 Kohlenstoffatomen, um einen Ring auszubilden, sind,
R₄₂ bis R₅₉ jeweils unabhängig voneinander ein Wasserstoffatom, ein Deuteriumatom, ein Halogenatom, eine substituierte oder unsubstituierte Aminogruppe, eine substituierte oder unsubstituierte Silylgruppe, eine substituierte oder unsubstituierte Alkylgruppe mit 1 bis 15 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind, oder jeweils mit einer angrenzenden Gruppe kombiniert sind, um einen Ring auszubilden,
Y₁ eine direkte Bindung, CRₐR_{b}, SiR_{c}R_{d}, GeRₑR_{f}, NR_{g}, O oder S ist,
Rₐ bis R_{g} jeweils unabhängig voneinander eine substituierte oder unsubstituierte Alkylgruppe mit 1 bis 15 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind,
Rₐ und R_{b}, R_{c} und R_{d} und Rₑ und/oder R_{f} optional miteinander kombiniert sind, um einen Ring auszubilden, und
A₁ durch eine der Formeln D-2-3 bis D-2-10 dargestellt wird: 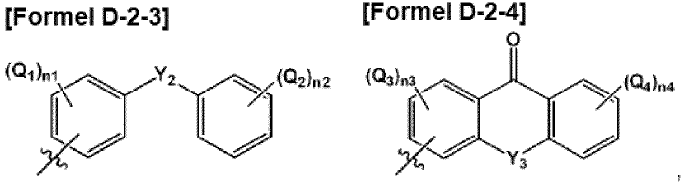 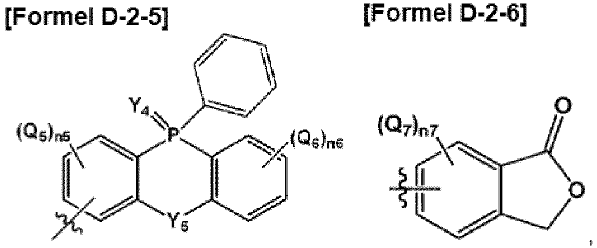 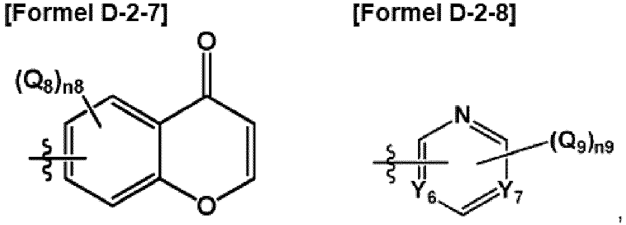 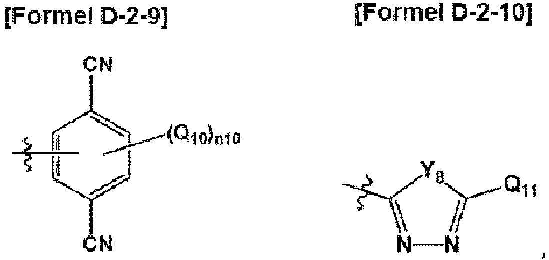
Y₂ C=O oder S(=O)₂ ist,
Y₃ C=O oder O ist,
Y₄ und Y₅ jeweils unabhängig voneinander O oder S sind,
Y₆ und Y₇ jeweils unabhängig voneinander N oder CQ₁₂ sind,
Y₈ O oder NQ₁₃ ist,
Q₁ bis Q₁₃ jeweils unabhängig voneinander eine substituierte oder unsubstituierte Alkylgruppe mit 1 bis 15 Kohlenstoffatomen, eine substituierte oder unsubstituierte Arylgruppe mit 6 bis 30 Kohlenstoffatomen, um einen Ring auszubilden, oder eine substituierte oder unsubstituierte Heteroarylgruppe mit 2 bis 30 Kohlenstoffatomen, um einen Ring auszubilden, sind,
n1, n4 und n6 jeweils unabhängig voneinander 0 bis 4 sind,
n3, n5, n7, n8 und n10 jeweils unabhängig voneinander eine ganze Zahl von 0 bis 3 sind,
n2 eine ganze Zahl von 0 bis 5 ist, und
n9 eine ganze Zahl von 0 bis 2 ist.

6. Organische Elektrolumineszenzvorrichtung (10) nach einem der Ansprüche 1 bis 5, wobei:
(i) ein Gewichtsverhältnis des ersten Wirts und des zweiten Wirts etwa 7:3 bis etwa 3:7 beträgt; und/oder
(ii) der erste Dotierstoff in einer Menge von etwa 10 Gew.-% bis etwa 15 Gew.- % vorliegt, und
der zweite Dotierstoff in einer Menge von etwa 1 Gew.-% bis etwa 5 Gew.-% vorliegt, bezogen auf ein Gesamtgewicht des ersten Wirts, des zweiten Wirts, des ersten Dotierstoffs und des zweiten Dotierstoffs.

7. Organische Elektrolumineszenzvorrichtung (10) nach einem der Ansprüche 1 bis 6, wobei der erste Wirt mindestens eine umfasst, die aus Verbindungen ausgewählt ist, die in Verbindungsgruppe 1 dargestellt sind:

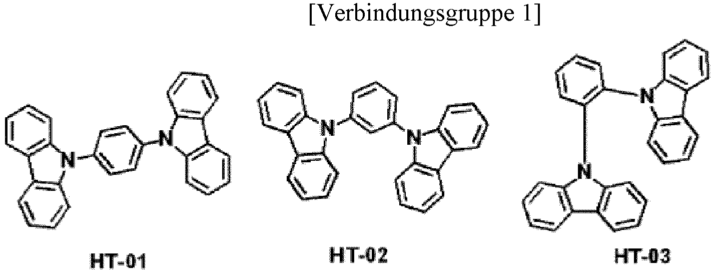

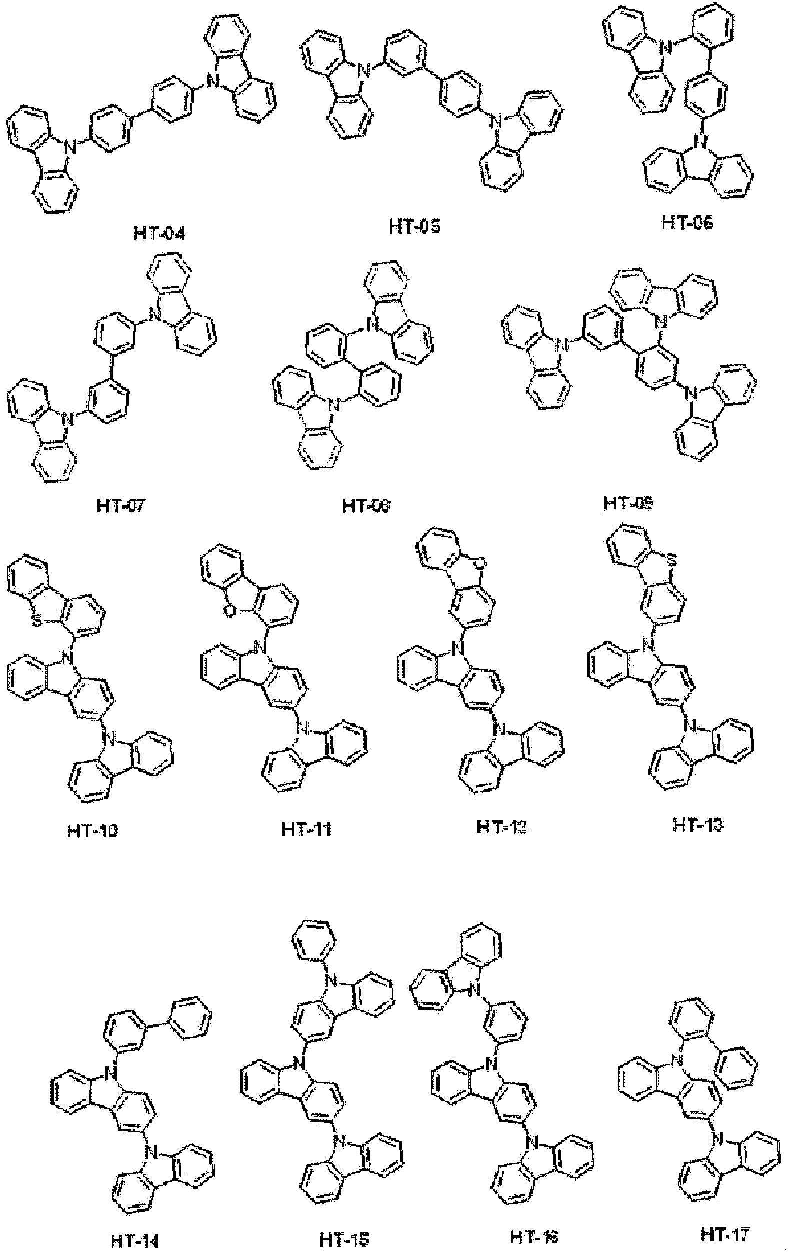

8. Organische Elektrolumineszenzvorrichtung (10) nach einem der Ansprüche 1 bis 7, wobei der zweite Wirt mindestens eine umfasst, die aus Verbindungen ausgewählt ist, die in Verbindungsgruppe 2-1 und Verbindungsgruppe 2-2 dargestellt sind:

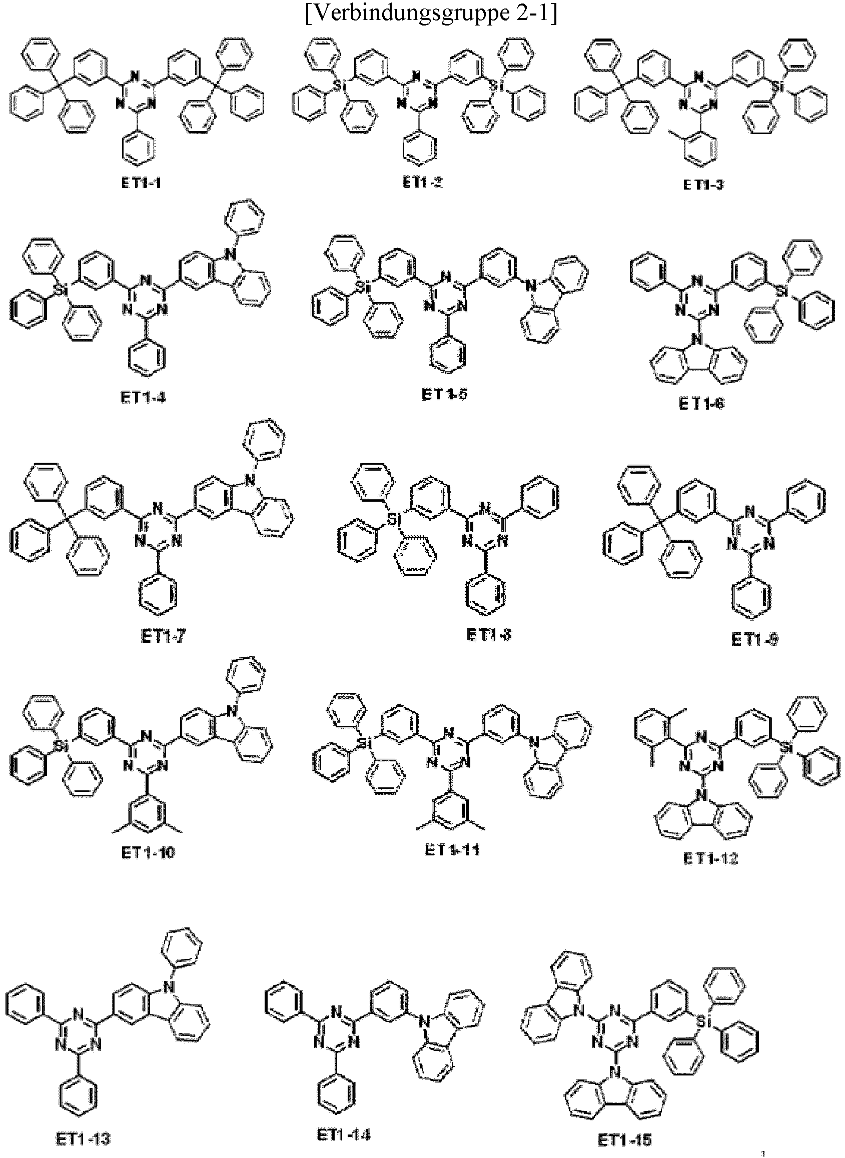

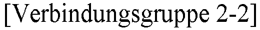

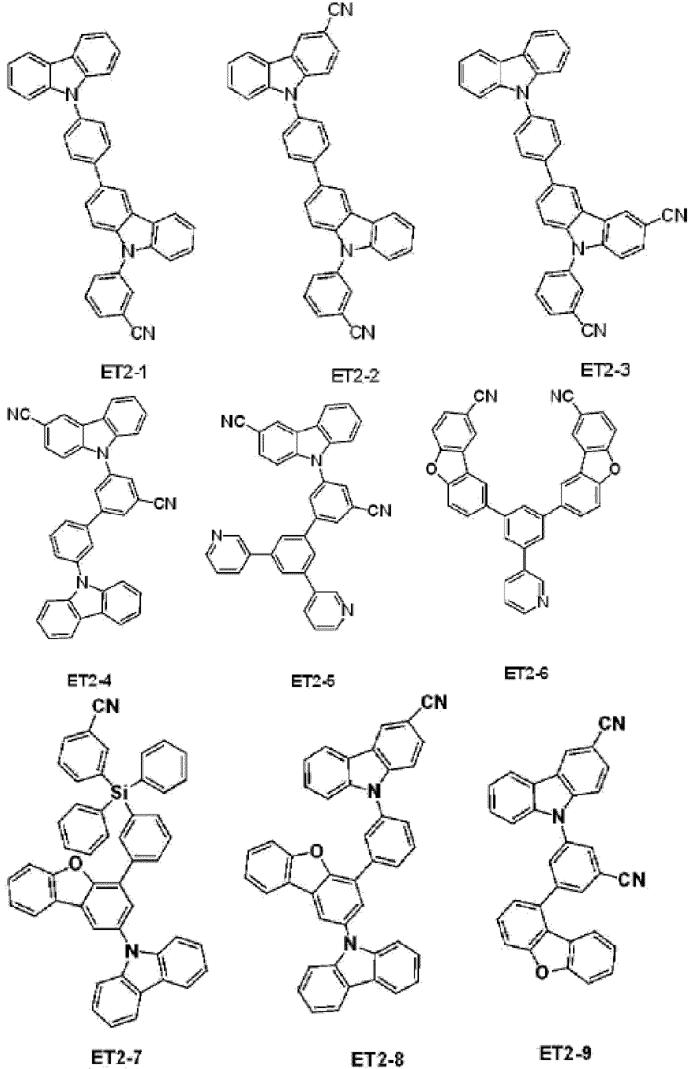

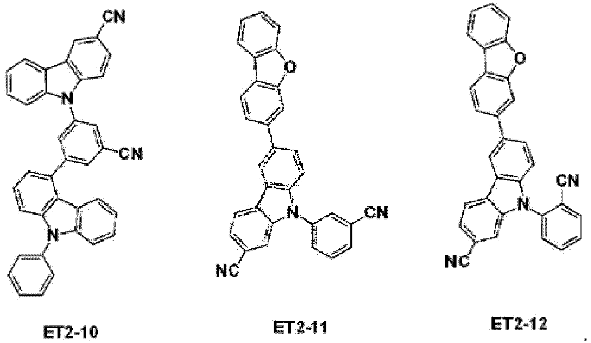

9. Organische Elektrolumineszenzvorrichtung (10) nach einem der Ansprüche 1 bis 8, wobei der erste Dotierstoff mindestens eine umfasst, die aus Verbindungen ausgewählt ist, die in Verbindungsgruppe 3-1 und Verbindungsgruppe 3-2 dargestellt sind: 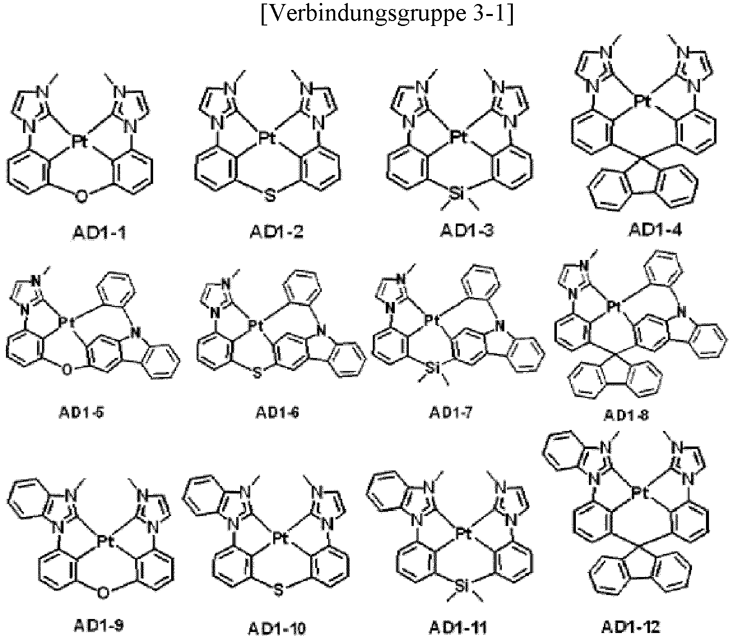 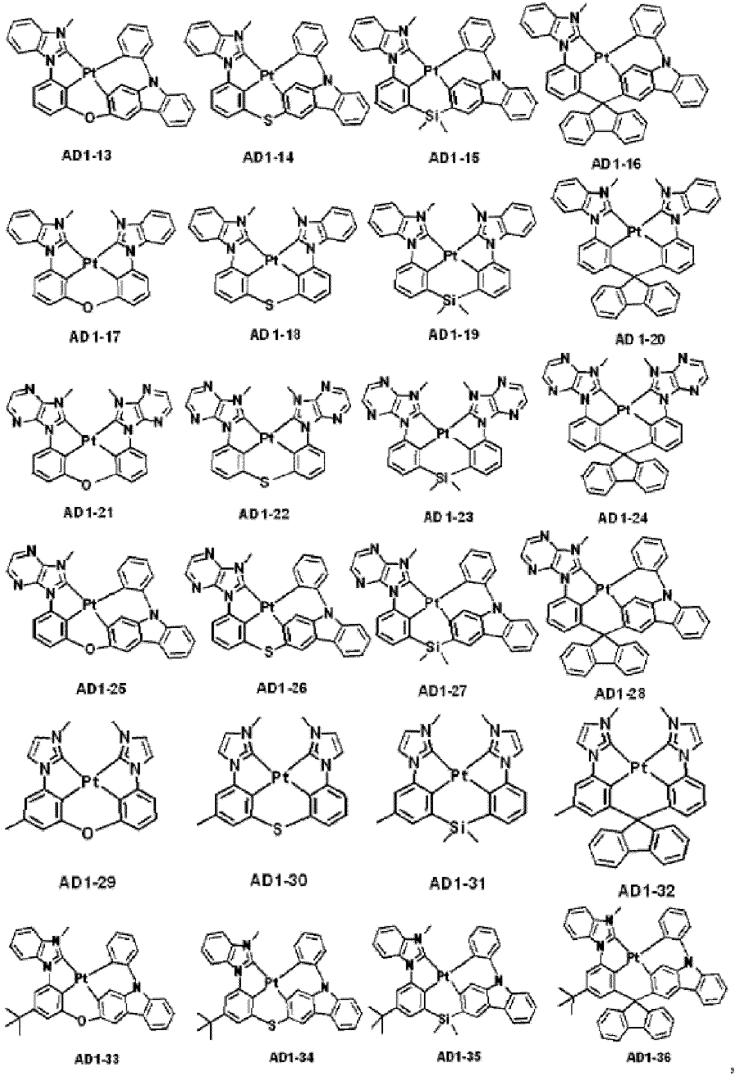 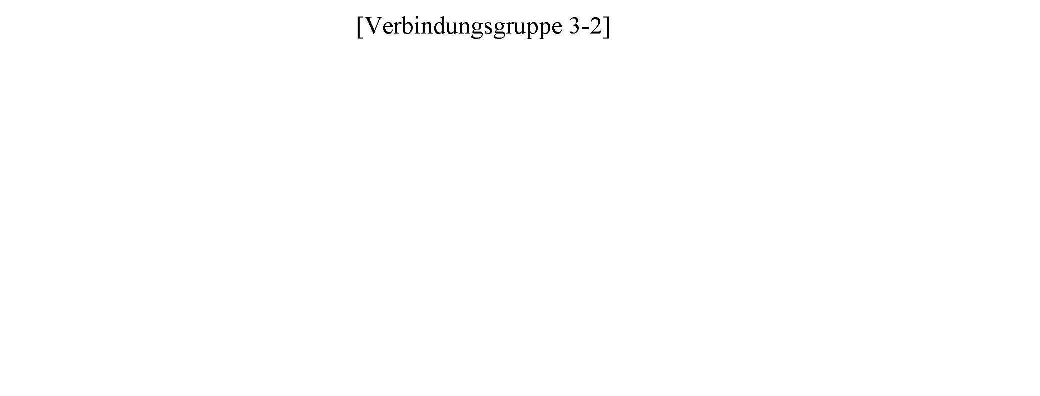 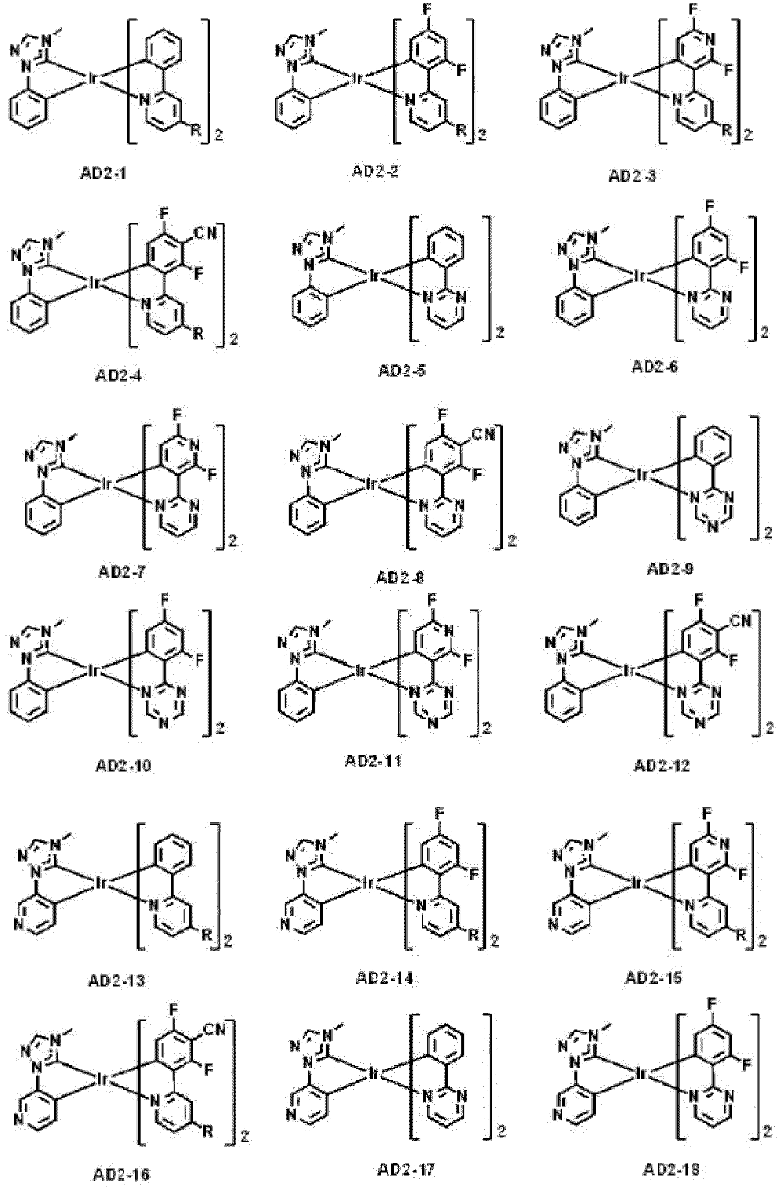 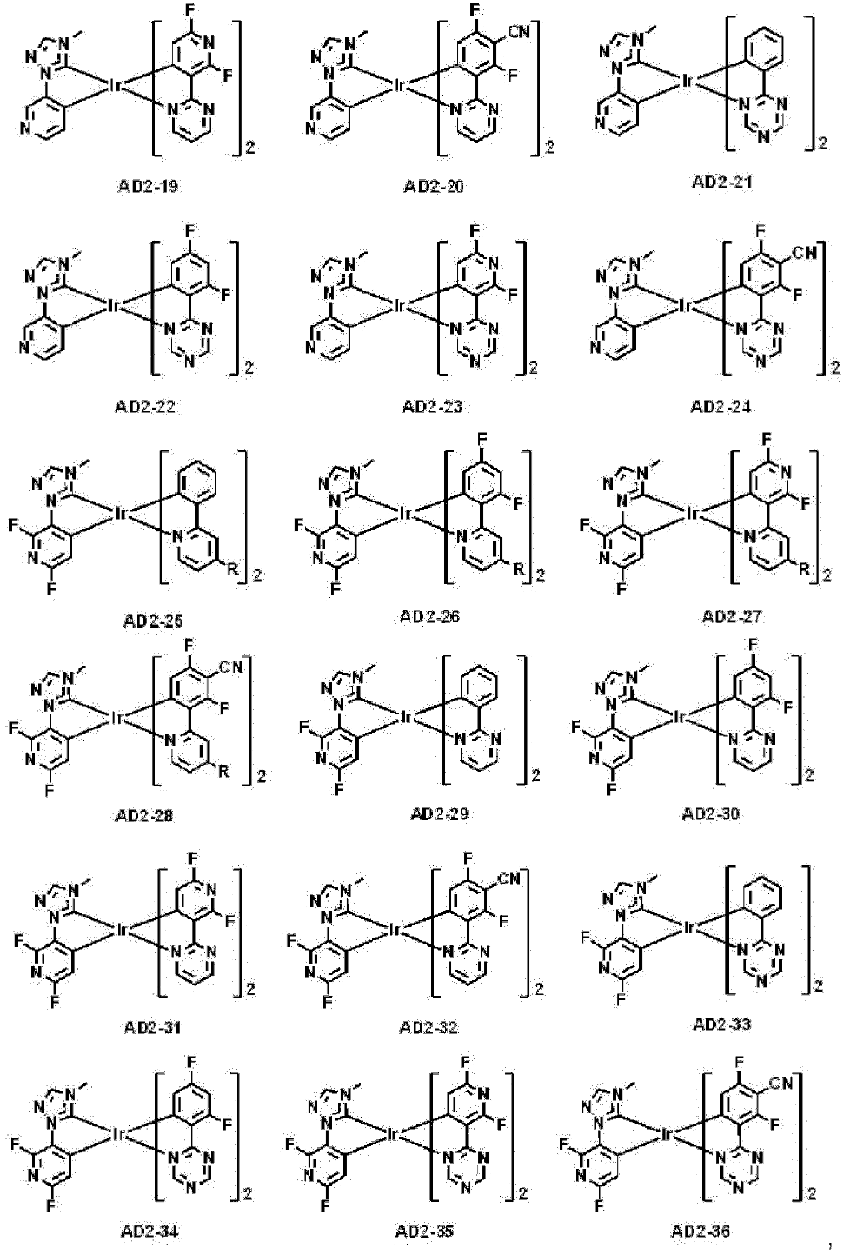 wobei in AD2-1 bis AD2-4, AD2-13 bis AD2-16 und AD2-25 bis AD2-28 jedes R unabhängig voneinander ein Wasserstoffatom, eine Methylgruppe, eine Isopropylgruppe, eine tert-Butylgruppe oder eine Dimethylamingruppe ist.

10. Organische Elektrolumineszenzvorrichtung (10) nach einem der Ansprüche 1 bis 9, wobei der zweite Dotierstoff mindestens eine umfasst, die aus Verbindungen ausgewählt ist, die in Verbindungsgruppe 4-1 und Verbindungsgruppe 4-2 dargestellt sind:

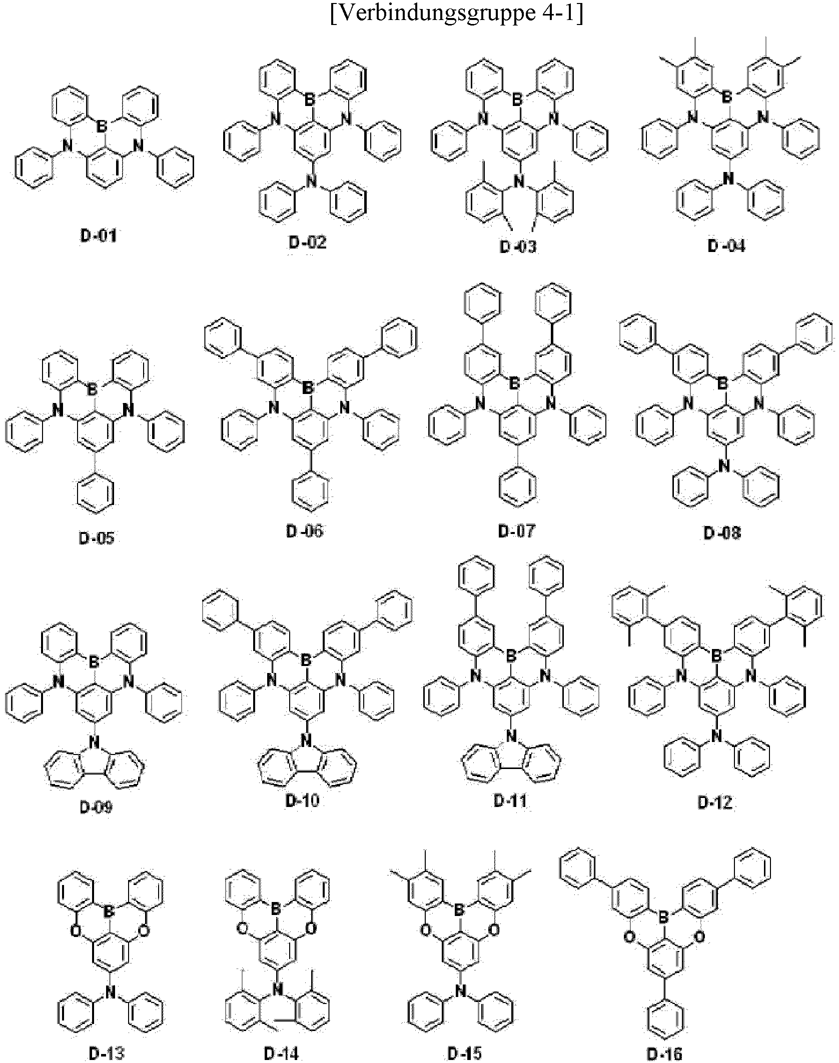

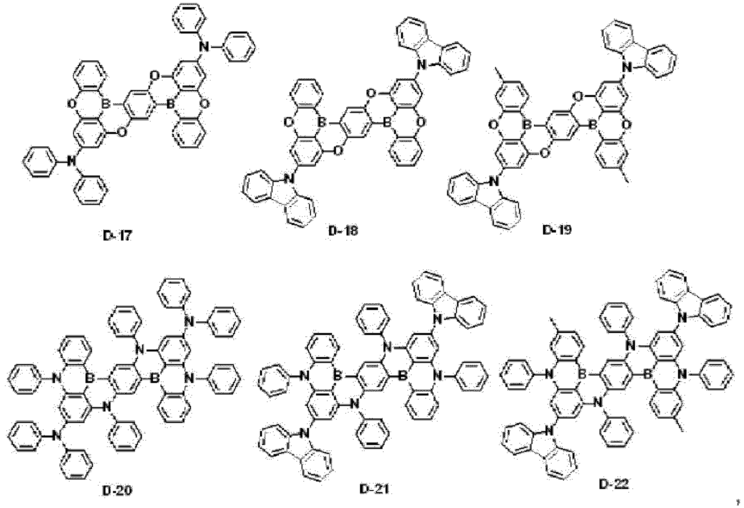

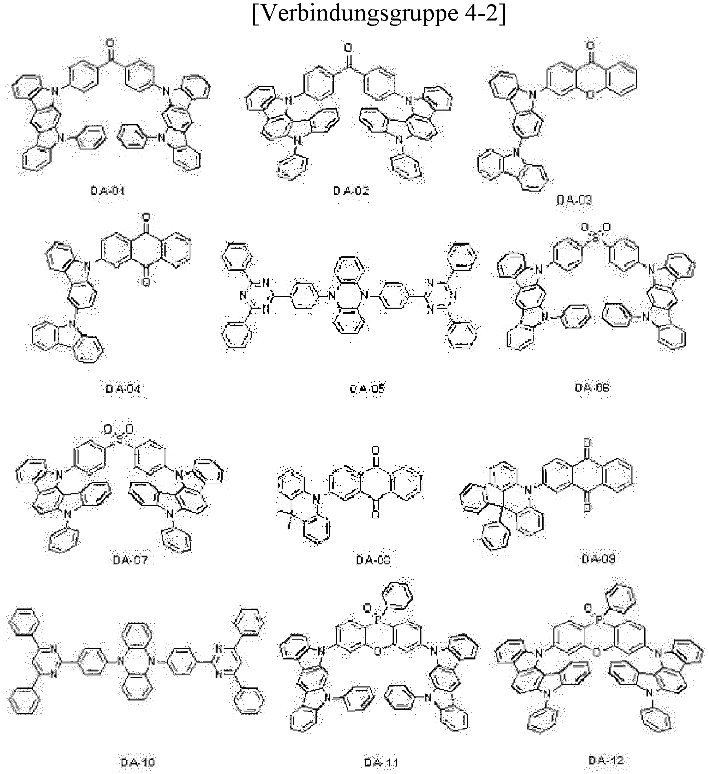

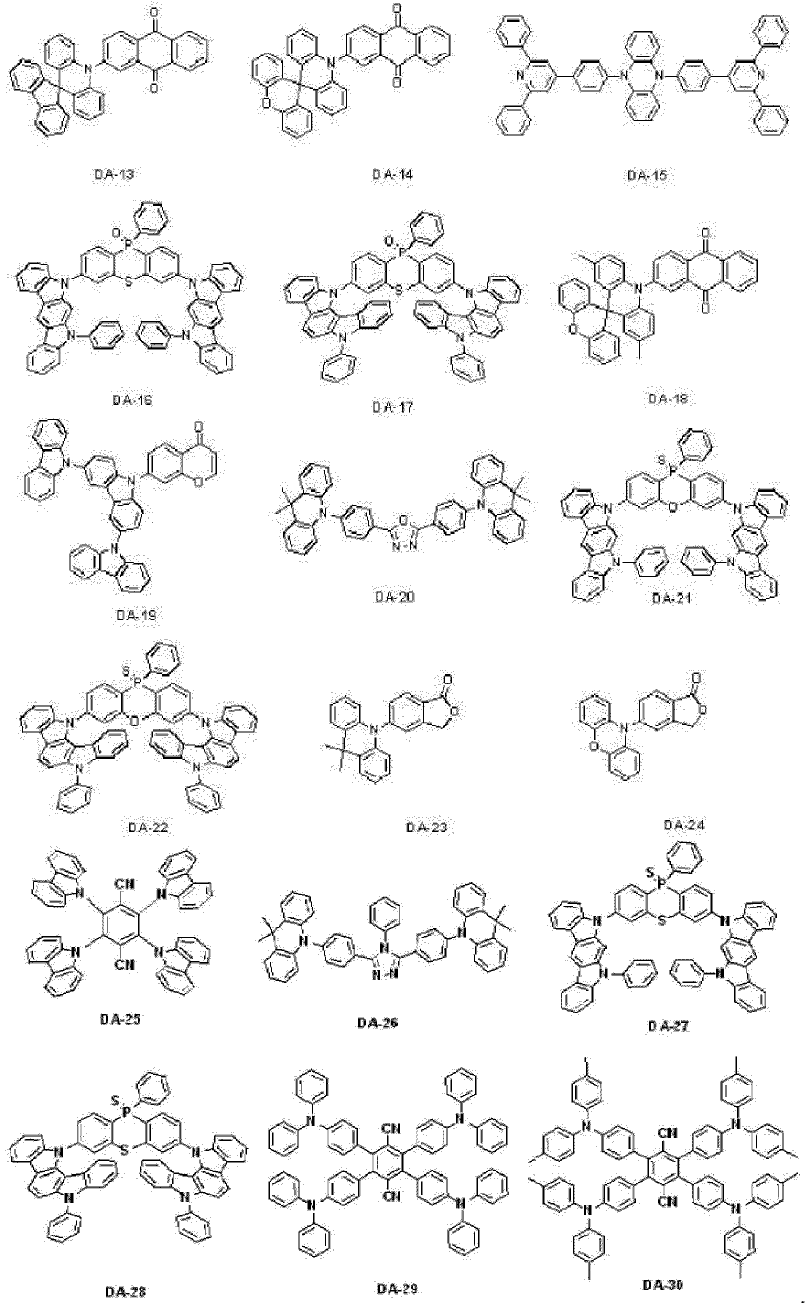

## Revendications

1. Dispositif électroluminescent organique (10), comprenant :
une première électrode (EL1) ;
une seconde électrode (EL2) opposée à la première électrode (EL1) ; et
une couche d'émission (EML) entre la première électrode (EL1) et la seconde électrode (EL2),
dans lequel la couche d'émission (EML) comprend :
un hôte présentant une première longueur d'onde de début luminescente, dans lequel la première longueur d'onde de début luminescente est une valeur d'interception x d'une ligne tangente qui est tirée dans une position où une intensité lumineuse est d'environ 0,5 dans un spectre d'émission de lumière normalisé de l'hôte ;
un premier dopant présentant une deuxième longueur d'onde de début luminescente, dans lequel la deuxième longueur d'onde de début luminescente est une valeur d'interception x d'une ligne tangente qui est tirée dans une position où une intensité lumineuse est d'environ 0,5 dans un spectre d'émission de lumière normalisé du premier dopant ; et
un second dopant différent du premier dopant et présentant une troisième longueur d'onde de début luminescente, dans lequel la troisième longueur d'onde de début luminescente est une valeur d'interception x d'une ligne tangente qui est tirée dans une position où une intensité lumineuse est d'environ 0,5 dans un spectre d'émission de lumière normalisé du second dopant, et
la troisième longueur d'onde de début luminescente est supérieure à la première longueur d'onde de début luminescente et à la deuxième longueur d'onde de début luminescente,
dans lequel les spectres d'émission de lumière normalisés sont obtenus en dissolvent l'hôte, le premier dopant ou le second dopant dans un solvant organique et en le divisant par une valeur maximale d'un premier pic après la mesure du spectre d'émission,
dans lequel une intensité lumineuse normalisée en un point de croisement d'un spectre d'absorption de lumière normalisé et d'un spectre d'émission de lumière normalisé du second dopant est d'environ 0,5 ou plus, et
une distance entre un pic du spectre d'absorption de lumière normalisé et un pic du spectre d'émission de lumière normalisé du second dopant est d'environ 50 nm ou moins,
dans lequel l'hôte comprend un premier hôte et un second hôte, le second hôte étant différent du premier hôte, et
dans lequel le premier hôte est représenté par la Formule H-1 : 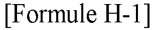 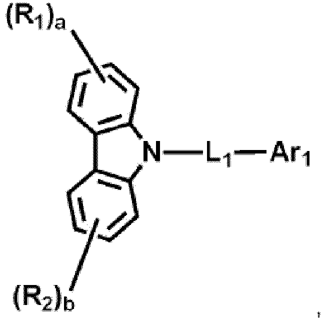
dans lequel, dans la Formule H-1,
L₁ est une liaison directe, un groupe arylène substitué ou non substitué à 6 à 30 atomes de carbone pour former un cycle, ou un groupe hétéroarylène substitué ou non substitué à 2 à 30 atomes de carbone pour former un cycle,
Ar₁ est un groupe aryle substitué ou non substitué à 6 à 30 atomes de carbone pour former un cycle, ou un groupe hétéroaryle substitué ou non substitué à 2 à 30 atomes de carbone pour former un cycle,
« a » et « b » sont chacun indépendamment un nombre entier de 0 à 4, et
R₁ et R₂ sont chacun indépendamment un groupe aryle substitué ou non substitué à 6 à 30 atomes de carbone pour former un cycle, ou un groupe hétéroaryle substitué ou non substitué à 2 à 30 atomes de carbone pour former un cycle, et
dans lequel le second hôte est représenté par la Formule H-2 : 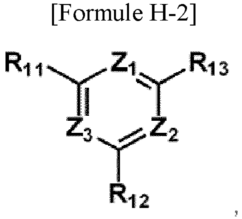
dans lequel dans la Formule H-2,
Z₁ à Z₃ sont chacun indépendamment CR_{y} ou N, et
R_{y} et R₁₁ à R₁₃ sont chacun indépendamment un atome d'hydrogène, un atome de deutérium, un groupe cyano, un groupe silyle substitué ou non substitué, un groupe aryle substitué ou non substitué à 6 à 30 atomes de carbone pour former un cycle, ou un groupe hétéroaryle substitué ou non substitué à 2 à 30 atomes pour former un cycle.

2. Dispositif électroluminescent organique (10) selon la revendication 1, dans lequel le second dopant présente un niveau d'énergie d'excitation de triplet le plus bas inférieur à chacun de l'hôte et du premier dopant.

3. Dispositif électroluminescent organique (10) selon la revendication 1 ou la revendication 2, dans lequel le premier dopant comprend un complexe organométallique comprenant Ir, Ru, Rh, Pt, Pd, Cu, ou Os comme élément métallique central, facultativement dans lequel le premier dopant est représenté par la Formule D-1 : 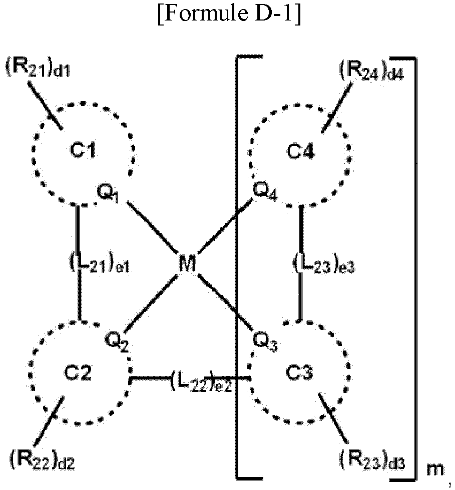 dans lequel dans la Formule D-1,
M est Pt, Pd, Cu, Os, Ir, Ru, ou Rh,
Q₁ à Q₄ sont chacun indépendamment un C ou N,
C1 à C4 sont chacun indépendamment un cycle hydrocarbure substitué ou non substitué à 5 à 30 atomes de carbone pour former un cycle, ou un hétérocycle substitué ou non substitué à 2 à 30 atomes de carbone pour former un cycle,
L₂₁ à L₂₃ sont chacun indépendamment une liaison directe, , *-o-*, *-s-*, 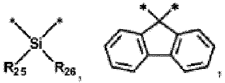 un groupe alkyle divalent substitué ou non substitué à 1 à 20 atomes de carbone, un groupe arylène substitué ou non substitué à 6 à 30 atomes de carbone pour former un cycle, ou un groupe hétéroarylène substitué ou non substitué à 2 à 30 atomes de carbone pour former un cycle,
e1 à e3 sont chacun indépendamment 0 ou 1,
R₂₁ à R₂₆ sont chacun indépendamment un atome d'hydrogène, un atome de deutérium, un atome d'halogène, un groupe cyano, un groupe amine substitué ou non substitué, un groupe alkyle substitué ou non substitué à 1 à 20 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle, ou sont combinés avec un groupe adjacent pour former un cycle,
d1 à d4 sont chacun indépendamment un nombre entier de 0 à 4,
lorsque M est Pt, Pd, Cu, ou Os, « m » est égal à 1, et
lorsque M est Ir, Ru, ou Rh, « m » est égal à 2, et e2 est égal à 0.

4. Dispositif électroluminescent organique (10) selon l'une quelconque des revendications 1 à 3, dans lequel le second dopant est représenté par la Formule D-2a : 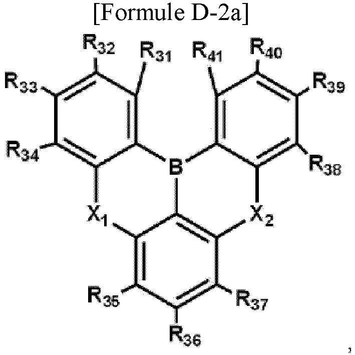 dans la Formule D-2a, X₁ et X₂ sont chacun indépendamment un NRₘ ou O,
Rₘ est un atome d'hydrogène, un atome de deutérium, un groupe alkyle substitué ou non substitué à 1 à 20 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle, et
R₃₁ à R₄₁ sont chacun indépendamment un atome d'hydrogène, un atome de deutérium, un atome d'halogène, un groupe cyano, un groupe amine substitué ou non substitué, un groupe boryle substitué ou non substitué, un groupe oxy substitué ou non substitué, un groupe alkyle substitué ou non substitué à 1 à 20 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle, ou sont combinés avec un groupe adjacent pour former un cycle.

5. Dispositif organique électroluminescent (10) selon l'une quelconque des revendications 1 à 4, dans lequel le second dopant est représenté par la Formule D-2b :
[Formule D-2b] **D₁-L₂-A₁,**
dans lequel, dans la Formule D-2b,
L₂ est une liaison directe, un groupe arylène substitué ou non substitué à 6 à 30 atomes de carbone pour former un cycle, ou un groupe hétéroarylène substitué ou non substitué à 2 à 30 atomes de carbone pour former un cycle, et
D₁ est représenté par la Formule D-2-1 ou la Formule D-2-2 : 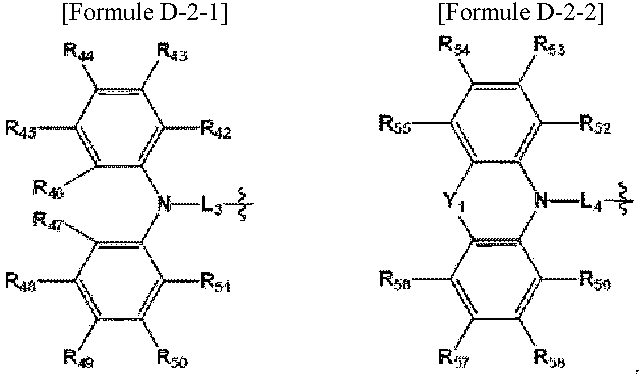
dans lequel dans les Formules D-2-1 et D-2-2,
L₃ et L₄ sont chacun indépendamment une liaison directe, ou un groupe arylène substitué ou non substitué à 6 à 30 atomes de carbone pour former un cycle,
R₄₂ à R₅₉ sont chacun indépendamment un atome d'hydrogène, un atome de deutérium, un atome d'halogène, un groupe amine substitué ou non substitué, un groupe silyle substitué ou non substitué, un groupe alkyle substitué ou non substitué à 1 à 15 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle, ou sont chacun combinés avec un groupe adjacent pour former un cycle,
Y₁ est une liaison directe, CRₐR_{b}, SiR_{c}R_{d}, GeRₑR_{f}, NR_{g}, O ou S,
Rₐ à R_{g} sont chacun indépendamment un groupe alkyle substitué ou non substitué à 1 à 15 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle,
Rₐ et R_{b}, R_{c} et R_{d}, et Rₑ et/ou R_{f} sont facultativement combinés l'un à l'autre pour former un cycle, et
A₁ est représenté par une des Formules D-2-3 à D-2-10 : 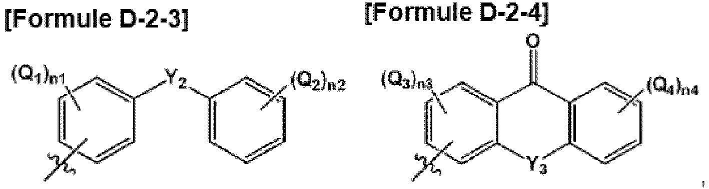 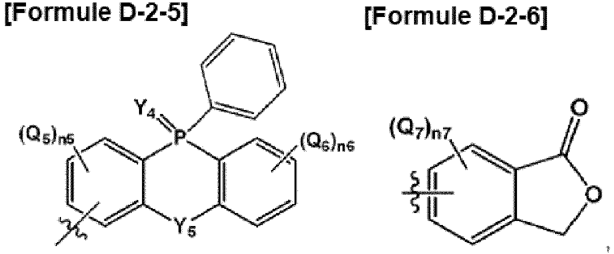 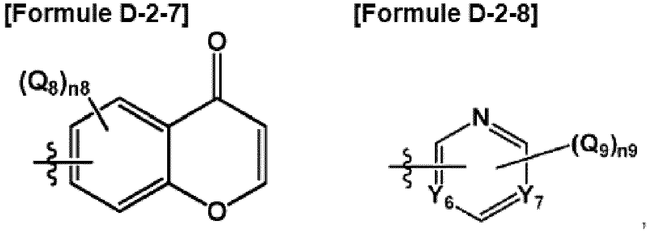 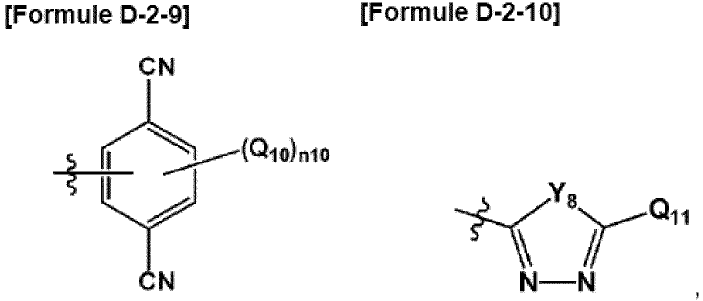
Y₂ est C=O, ou S(=O)₂,
Y₃ est C=O, ou O,
Y₄ et Y₅ sont chacun indépendamment O, ou S,
Y₆ et Y₇ sont chacun indépendamment N, ou CQ₁₂,
Y₈ est O ou NQ₁₃,
Q₁ à Q₁₃ sont chacun indépendamment un groupe alkyle substitué ou non substitué à 1 à 15 atomes de carbone, un groupe aryle substitué ou non substitué à 6 à 30 atomes de carbone pour former un cycle, ou un groupe hétéroaryle substitué ou non substitué à 2 à 30 atomes de carbone pour former un cycle,
n1, n4, et n6 sont chacun indépendamment 0 à 4,
n3, n5, n7, n8, et n10 sont chacun indépendamment un nombre entier de 0 à 3,
n2 est un nombre entier de 0 à 5, et
n9 est un nombre entier de 0 à 2.

6. Dispositif électroluminescent organique (10) selon l'une quelconque des revendications 1 à 5, dans lequel :
(i) un rapport en poids du premier hôte et du second hôte est d'environ 7:3 à environ 3:7 ; et/ou
(ii) le premier dopant est présent en une quantité d'environ 10 % en poids à environ 15 % en poids, et
le second dopant est présent en une quantité d'environ 1 % en poids à environ 5 % en poids sur la base d'un poids total du premier hôte, du second hôte, du premier dopant et du second dopant.

7. Dispositif électroluminescent organique (10) selon l'une quelconque des revendications 1 à 6, dans lequel le premier hôte comprend au moins un composé sélectionné parmi des composés représentés dans le Groupe de Composés 1 :

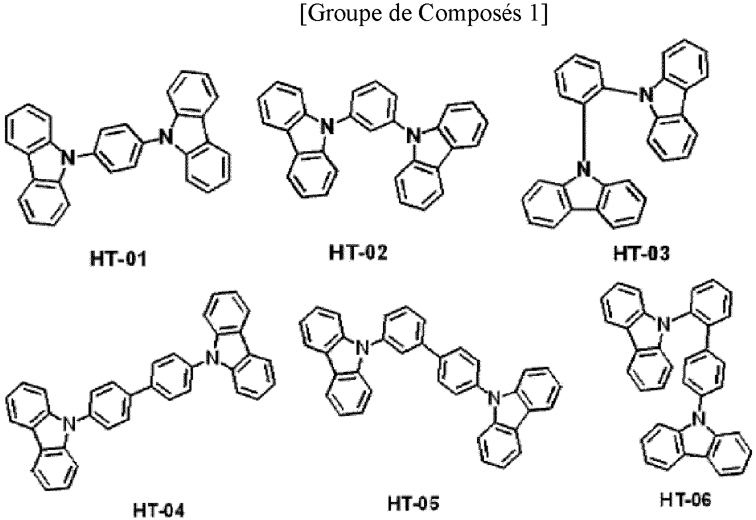

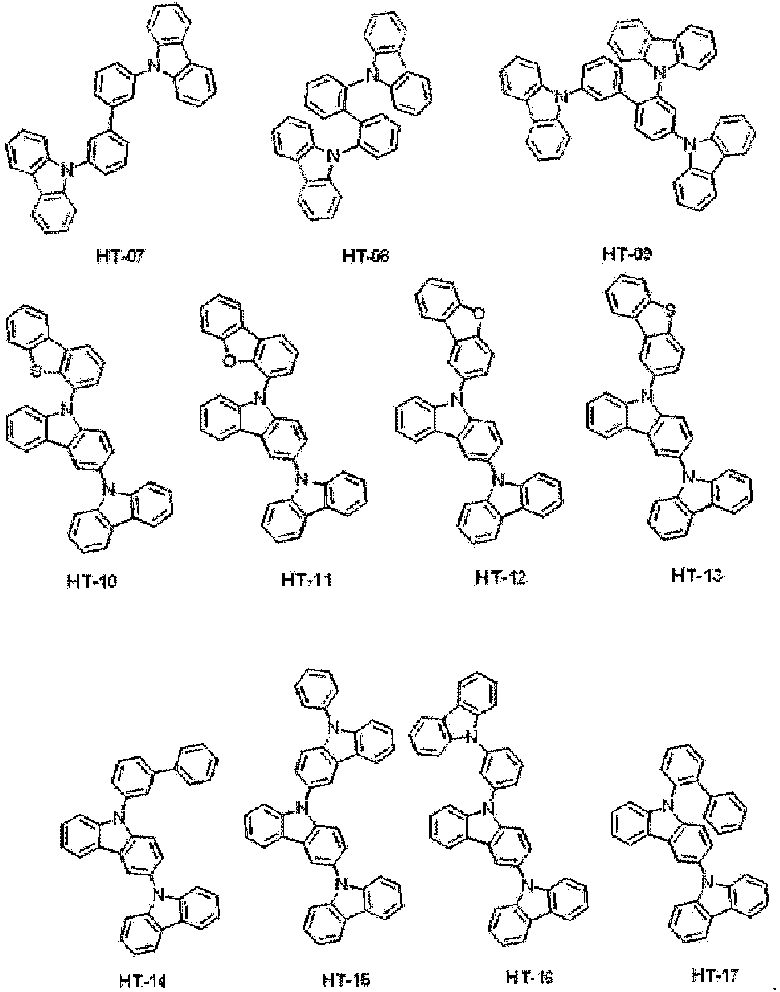

8. Dispositif électroluminescent organique (10) selon l'une quelconque des revendications 1 à 7, dans lequel le second hôte comprend au moins un composé sélectionné parmi des composés représentés dans le Groupe de Composés 2-1 et le Groupe de Composé 2-2 :

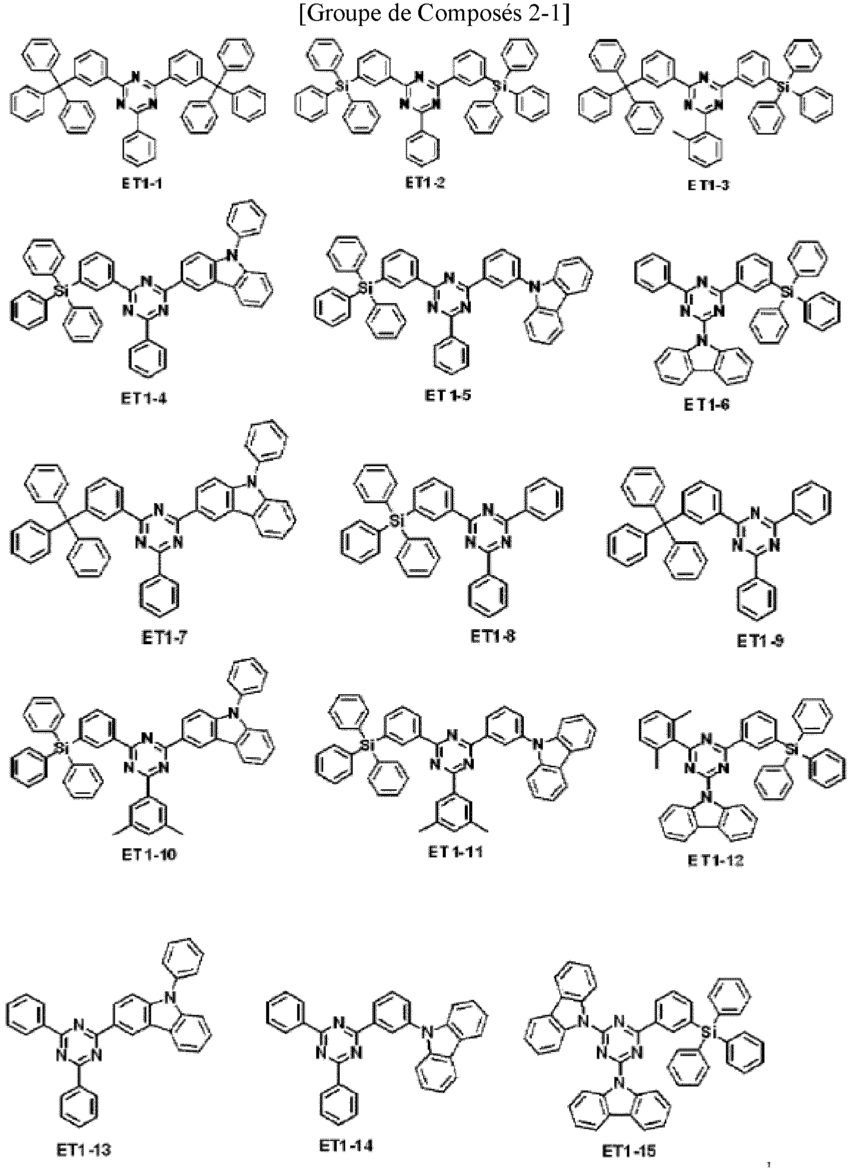

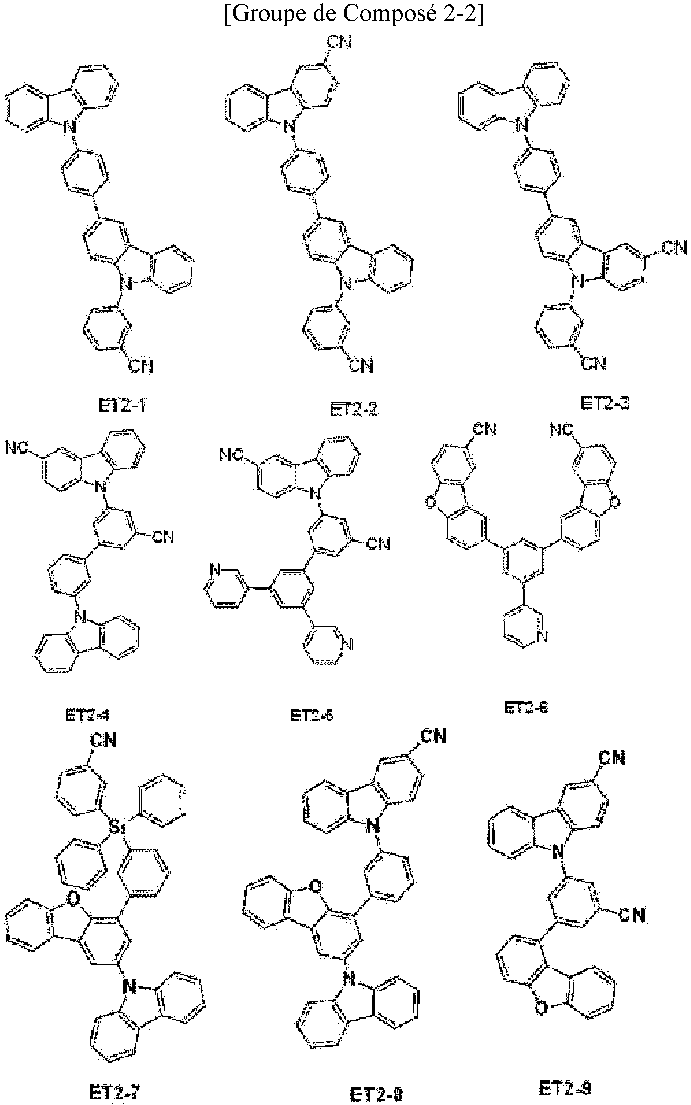

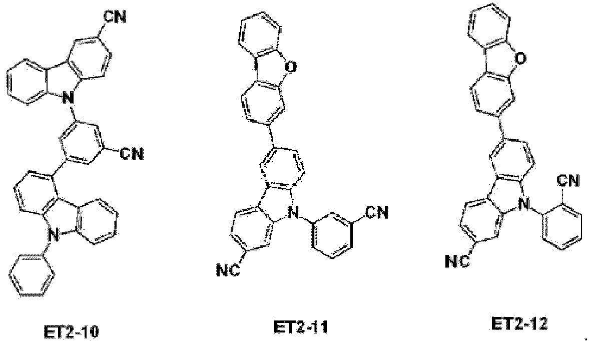

9. Dispositif électroluminescent organique (10) selon l'une quelconque des revendications 1 à 8, dans lequel le premier dopant comprend au moins un composé sélectionné parmi des composés représentés dans le Groupe de Composés 3-1 et le Groupe de Composés 3-2 : 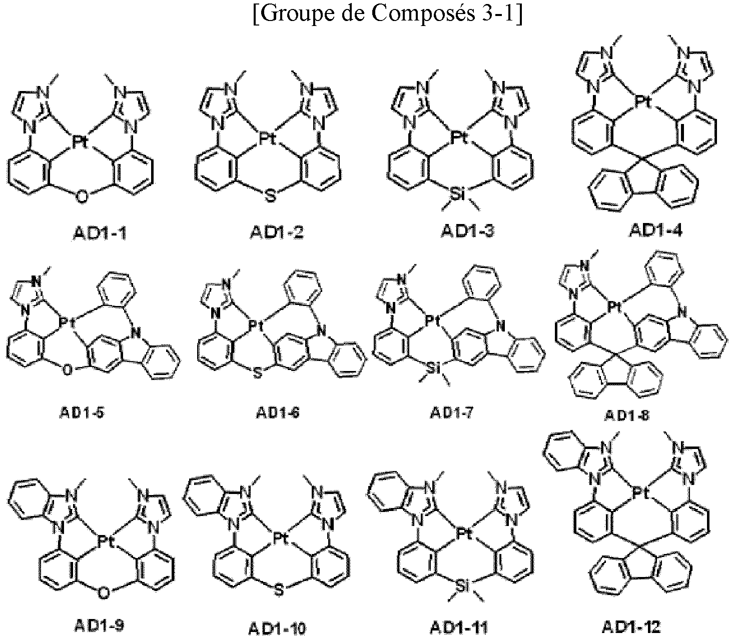 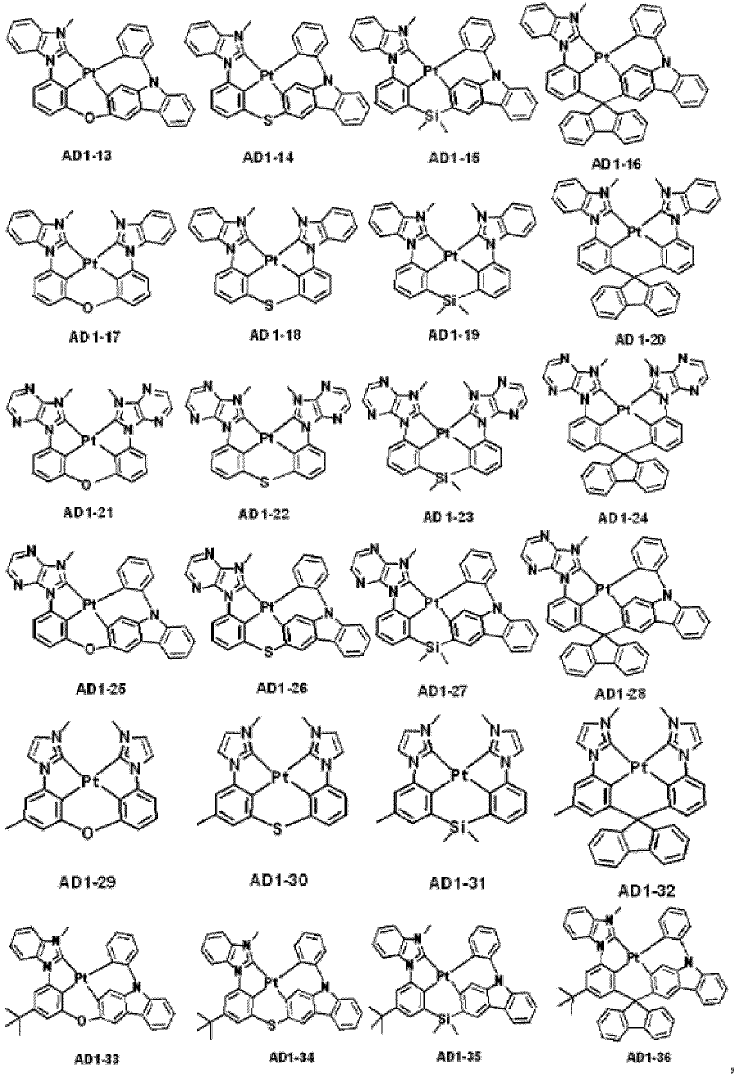 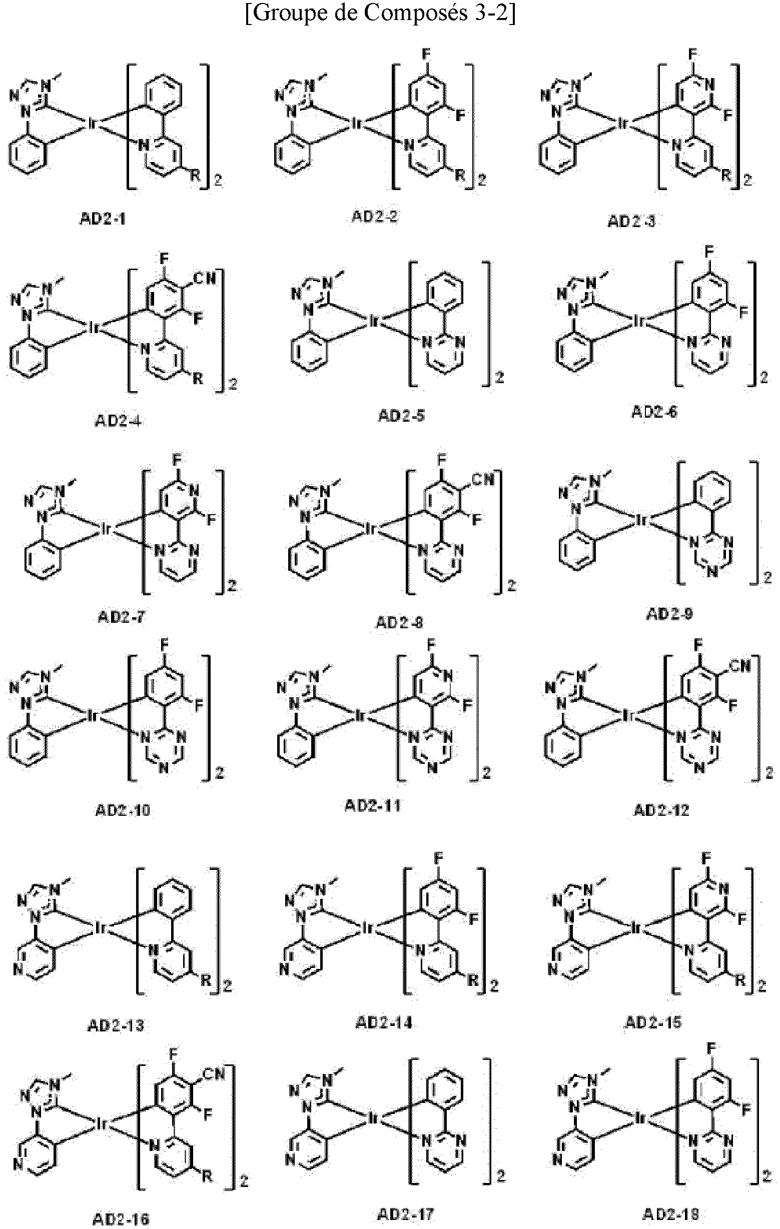 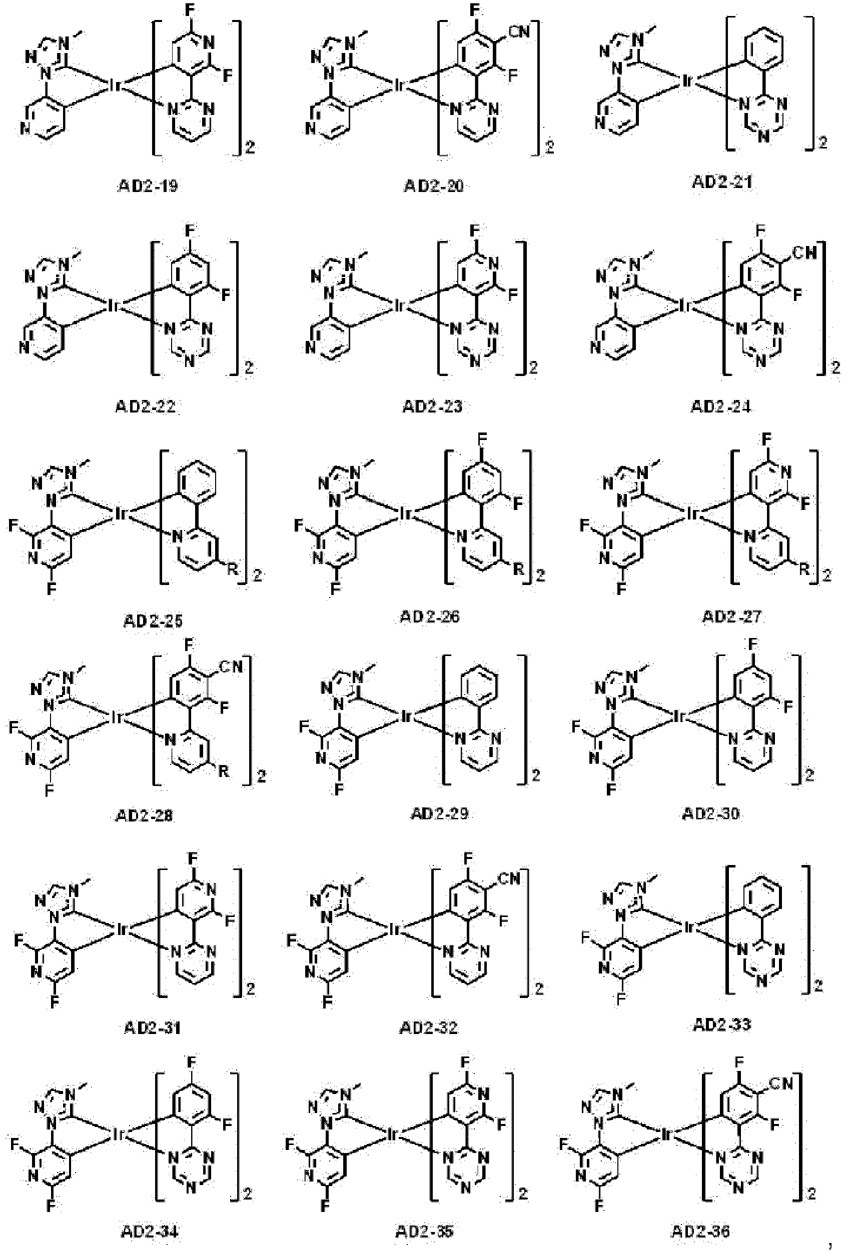 dans lequel dans AD2-1 à AD2-4, AD2-13 à AD2-16, et AD2-25 à AD2-28, chaque R est indépendamment un atome d'hydrogène, un groupe méthyle, un groupe isopropyle, un groupe tert-butyle, ou un groupe diméthylamine.

10. Dispositif électroluminescent organique (10) selon l'une quelconque des revendications 1 à 9, dans lequel le second dopant comprend au moins un composé sélectionné parmi des composés représentés dans le Groupe de Composés 4-1 et le Groupe de Composés 4-2 :
